(19) Europäisches Patentamt
European Patent Office
Office européen des brevets

(11) EP 2 876 671 B1

(12) **EUROPEAN PATENT SPECIFICATION**

(45) Date of publication and mention of the grant of the patent:
**22.11.2017 Bulletin 2017/47**

(21) Application number: **13820690.9**

(22) Date of filing: **19.07.2013**

(51) Int Cl.:
***H01L 31/0216*** *(2014.01)*

(86) International application number:
**PCT/JP2013/069697**

(87) International publication number:
**WO 2014/014107 (23.01.2014 Gazette 2014/04)**

(54) **COMPOSITION FOR FORMING PASSIVATION LAYER, SEMICONDUCTOR SUBSTRATE HAVING PASSIVATION LAYER, METHOD OF PRODUCING SEMICONDUCTOR SUBSTRATE HAVING PASSIVATION LAYER, PHOTOVOLTAIC CELL ELEMENT, AND PHOTOVOLTAIC CELL**

ZUSAMMENSETZUNG ZUM BILDEN EINER PASSIVIERUNGSSCHICHT, HALBLEITERSUBSTRAT MIT EINER PASSIVIERUNGSSCHICHT, VERFAHREN ZUR HERSTELLUNG EINES HALBLEITERSUBSTRATS MIT DIESER PASSIVIERUNGSSCHICHT, ELEMENT MIT PHOTOVOLTAISCHER ZELLE UND PHOTOVOLTAISCHE ZELLE

COMPOSITION PERMETTANT DE FORMER UNE COUCHE DE PASSIVATION, SUBSTRAT SEMI-CONDUCTEUR AVEC COUCHE DE PASSIVATION, PROCÉDÉ DE PRODUCTION D’UN SUBSTRAT SEMI-CONDUCTEUR AYANT UNE COUCHE DE PASSIVATION, ÉLÉMENT DE CELLULE PHOTOVOLTAIQUE ET CELLULE PHOTOVOLTAIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:
**19.07.2012 JP 2012160336**
**28.09.2012 JP 2012218389**
**25.01.2013 JP 2013011934**
**28.02.2013 JP 2013040153**
**28.02.2013 JP 2013038894**

(43) Date of publication of application:
**27.05.2015 Bulletin 2015/22**

(73) Proprietor: **Hitachi Chemical Company, Ltd.**
**Chiyoda-ku**
**Tokyo 100-6606 (JP)**

(72) Inventors:
- **ADACHI, Shuichiro**
  **Tsukuba-shi**
  **Ibaraki 300-4247 (JP)**
- **YOSHIDA, Masato**
  **Tsukuba-shi**
  **Ibaraki 300-4247 (JP)**
- **NOJIRI, Takeshi**
  **Tsukuba-shi**
  **Ibaraki 300-4247 (JP)**
- **KURATA, Yasushi**
  **Tsukuba-shi**
  **Ibaraki 300-4247 (JP)**
- **TANAKA, Tooru**
  **Tsukuba-shi**
  **Ibaraki 300-4247 (JP)**
- **ORITA, Akihiro**
  **Tsukuba-shi**
  **Ibaraki 300-4247 (JP)**
- **HAYASAKA, Tsuyoshi**
  **Tsukuba-shi**
  **Ibaraki 300-4247 (JP)**
- **HATTORI, Takashi**
  **Kokubunji-shi**
  **Tokyo 185-8601 (JP)**
- **MATSUMURA, Mieko**
  **Kokubunji-shi**
  **Tokyo 185-8601 (JP)**
- **WATANABE, Keiji**
  **Kokubunji-shi**
  **Tokyo 185-8601 (JP)**
- **MORISHITA, Masatoshi**
  **Kokubunji-shi**
  **Tokyo 185-8601 (JP)**
- **HAMAMURA, Hirotaka**
  **Kokubunji-shi**
  **Tokyo 185-8601 (JP)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 876 671 B1

(74) Representative: **Hoffmann Eitle**
**Patent- und Rechtsanwälte PartmbB**
**Arabellastraße 30**
**81925 München (DE)**

(56) References cited:

| | |
|---|---|
| **WO-A1-2011/155635** | **WO-A2-2010/111311** |
| **WO-A2-2010/111311** | **JP-A- 2011 216 845** |
| **JP-A- 2011 501 442** | **US-A- 4 496 398** |

- **PEHLIVAN, E. ET AL.: 'Effect of Ti02 mixtures on the optical, structural and electrochromic properties of Nb205 thin films' SOLAR ENERGY MATERIALS AND SOLAR CELLS vol. 87, no. 1-4, May 2005, pages 317 - 322, XP027815146**

## Description

Technical Field

The present invention relates to a composition for forming a passivation layer, a semiconductor substrate having a passivation layer, a method of producing a semiconductor substrate having a passivation layer, a photovoltaic cell element, and a method of producing a photovoltaic cell element.

Background Art

A conventional method of producing a silicon photovoltaic cell element is explained.

First, in order to improve efficiency by promoting an optical confinement effect, a p-type silicon substrate having a textured structure formed on its light receiving surface is prepared. Then, the p-type silicon substrate is subjected to treatment in a mixed gas atmosphere of phosphorus oxychloride ($POCl_3$), nitrogen and oxygen at a temperature of from 800°C to 900°C for several ten minutes, thereby uniformly forming an n-type diffusion layer. In this method, since phosphorus diffusion is performed using a mixed gas, an n-type diffusion layer is formed not only at a light-receiving surface but also at back and side surfaces. Therefore, side etching is performed in order to remove an n-type diffusion layer formed at side surfaces. In addition, an n-type diffusion layer formed at a back surface needs to be converted to a $p^+$-type diffusion layer. Therefore, an aluminum paste including an aluminum powder and a binder is applied to the entire back surface, and this is subjected to thermal treatment (sintering) in order to convert the n-type diffusion layer to a $p^+$-type diffusion layer and to form an aluminum electrode, thereby obtaining an ohmic contact.

An aluminum electrode formed from an aluminum paste has a low electric conductivity. Therefore, an aluminum electrode, which is generally formed on an entire back surface, usually has a thickness of from about 10 μm to 20 μm after the thermal treatment (sintering) in order to reduce the sheet resistance. Furthermore, since there is a great difference between thermal expansion coefficients of silicon and aluminum, a large internal stress is generated in a silicon substrate on which an aluminum electrode is formed during thermal treatment (sintering) and cooling, thereby causing a damage to a crystalline interface, an increase in crystal defect, and warpage.

In order to solve the problems as described above, there is a method of reducing the thickness of the back surface electrode layer by reducing the amount of an aluminum paste to be applied. However, reducing the amount of aluminum to be applied results in insufficient amount of aluminum to diffuse from the surface to the inside of a p-type silicon semiconductor substrate. As a result, a desired BSF (Back Surface Field) effect (effect to enhance collection efficiency of generated carriers by the existence of a $p^+$-type diffusion layer) cannot be achieved and the properties of a photovoltaic cell are deteriorated.

With reference to the above, a point contact method, in which an aluminum paste is applied onto a part of a silicon substrate surface to locally form a $p^+$-type diffusion layer and an aluminum electrode (see, for example, Japanese Patent No. 3107287) is proposed.

In a case of a photovoltaic cell having a point contact structure at a surface opposite to the light-receiving surface (hereinafter, also referred to as a "back surface"), it is necessary to suppress a recombination velocity of minority carriers at a surface other than a region at which the aluminum electrode is formed. As a passivation layer for a back surface used for this purpose, a $SiO_2$ film is suggested (see, for example, Japanese Patent Application Laid-Open (JP-A No. 2004-6565). As a passivation effect achieved by forming an oxide film, there is an effect of reducing the surface level density, which causes recombination, by terminating a dangling bond of a silicon atom in a back surface portion of a silicon substrate.

As another method to inhibit recombination of minority carriers, there is a method of reducing a minority carrier density by means of an electric field that generates a fixed charge in the passivation layer. Such a passivation effect is generally referred to as an electrical field effect, and an aluminum oxide ($Al_2O_3$) layer and the like are suggested as a material having a negative fixed charge (see, for example, Japanese Patent No. 4767110).

Such a passivation layer is generally formed by a method such as an ALD (Atomic Layer Deposition) method, a CVD (Chemical Vapor Deposition) method and the like (see, for example, Journal of Applied Physics, 104 (2008), 113703-1 to 113703-7). As a simple method of forming an aluminum oxide film on a semiconductor substrate, a method employing a sol gel process is suggested (see, for example, Thin Solid Films, 517 (2009), 6327-6330, Chinese Physics Letters, 26 (2009), 088102-1 to 088102-4) and Nippon Seramikkusu Kyokai Gakujitsu Ronbunshi, 97(1989) 369-399.

On the other hand, by forming a film that has a high refractive index and a large passivation effect at the light receiving surface side of a silicon substrate, it becomes possible to achieve an optical confinement effect and to suppress recombination velocity of minority carriers, thereby improving power generation efficiency of a photovoltaic cell. For example, a method of increasing a refractive index of a film by forming an oxide film, in which a composite is formed from a metal such as titanium and aluminum, by a sol gel method is proposed (see, for example, Japanese Journal of Applied Physics, 45(2006), 5897-5901).

WO 2010/111311 A2 relates to dielectric oxide materials prepared by producing a sol from a mixture of a metal oxide precursor, a solvent, and an epoxide, and preparing a metal oxide material from the sol.

WO 2011/155635 A1 (corresponding to US 2013/101867 A1) relates to a metal oxide film which is formed by a method comprising a coating step of forming a coating film on a substrate by using a coating liquid for forming a metal oxide film containing any of various organometallic compounds; a drying step of making the coating film into a dried coating film; and a heating step of forming an inorganic film from the dried coating film under an oxygen-containing atmosphere having a dew-point temperature equal to or lower than -10°C.

US 4 496 398 A relates to a metal organic paste containing a metal alkoxides, a thickening or suspension agent, a solvent for the alkoxides and an effective amount of an anhydride.

## Summary of the Invention

### Problem to be Solved by the Invention

Since a method described in Journal of Applied Physics, 104 (2008), 113703-1 to 113703-7 includes a complicated process such as vapor deposition, it is sometimes difficult to enhance productivity. A composition to be used for a method of forming a passivation layer described in Thin Solid Films, 517 (2009), 6327-6330, Chinese Physics Letters, 26 (2009), 088102-1 to 088102-4 and Nippon Seramikkusu Kyokai Gakujitsu Ronbunshi, 97(1989) 369-399 may cause a trouble such as gelation over time and have an insufficient storage stability.

Further, the passivation layer prepared by a method as described in Journal of Applied Physics, 104 (2008), 113703-1 to 113703-7 has an insufficient refractive index and a photocatalyst effect derived from titanium oxide may occur, thereby causing a damage to a sealing resin of a photovoltaic cell element.

The invention has been made in view of the above-described conventional problems, and aims to provide a composition for forming a passivation layer that exhibits an excellent storage stability and enables formation of a passivation layer that has a sufficiently high refractive index by a simple method. In addition, the invention aims to provide a semiconductor substrate having a passivation layer that is obtained by using the composition for forming a passivation layer and that is provided with a passivation layer having a sufficiently high refractive index; a method of producing the semiconductor substrate having a passivation layer; a photovoltaic cell element; and a method of producing the photovoltaic cell element.

## Description of Embodiments

Specific means for solving the above-mentioned problem are as follows.

<1> A composition for forming a passivation layer, comprising an alkoxide represented by the following Formula (I); a compound represented by the following Formula (II); at least one compound selected from the group consisting of a titanium compound, a zirconium compound and a silicon alkoxide; a solvent; and a resin:

$$M(OR^1)_m \qquad (I)$$

wherein, in Formula (I), M comprises at least one metal element selected from the group consisting of Nb, Ta, V, Y and Hf, each $R^1$ independently represents an alkyl group having from 1 to 8 carbon atoms or an aryl group having from 6 to 14 carbon atoms, and m represents an integer from 1 to 5;

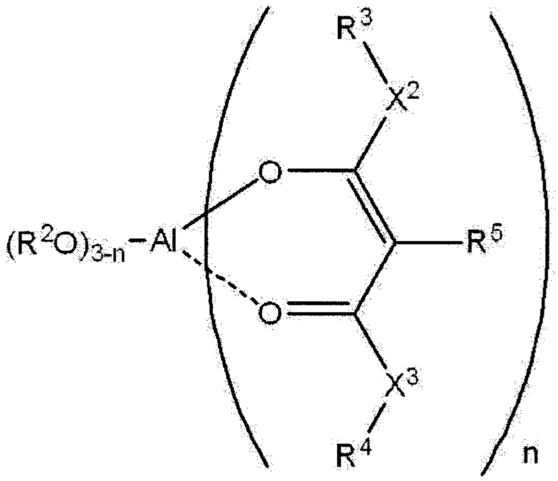

(II)

wherein, in Formula (II), each $R^2$ independently represents an alkyl group having from 1 to 8 carbon atoms, n represents an integer from 0 to 3, each of $X^2$ and $X^3$ independently represents an oxygen atom or a methylene group, and each of $R^3$, $R^4$ and $R^5$ independently represents a hydrogen atom or an alkyl group having from 1 to 8 carbon atoms.

<2> The composition for forming a passivation layer according to < 1>, wherein at least one of the alkoxides represented by Formula (I) is an alkoxide in which M comprises Nb.

<3> The composition for forming a passivation layer according to <1>, wherein at least one of the alkoxides represented by Formula (I) is an alkoxide in which M comprises Ta, V, Y or Hf.

<4> The composition for forming a passivation layer according to any one of <1> to <3>, wherein the at least one compound selected from the group consisting of a titanium compound, a zirconium compound and a silicon alkoxide comprises at least the titanium compound, and the titanium compound is at least one selected from the group consisting of titanium methoxide, titanium ethoxide, titanium isopropoxide, titanium n-propoxide, titanium n-butoxide, titanium t-butoxide, titanium isobutoxide, titanium (diisopropoxide) bis(acetylacetonate) and titanium (tetrakis(2-ethyl-1-hexanolate)).

<5> The composition for forming a passivation layer according to any one of <1> to <4>, wherein the at least one compound selected from the group consisting of a titanium compound, a zirconium compound and a silicon alkoxide comprises at least the zirconium compound, and the zirconium compound is at least one selected from the group consisting of zirconium ethoxide, zirconium isopropoxide, zirconium n-propoxide, zirconium n-butoxide, zirconium t-butoxide, zirconium acetylacetone, zirconium trifluoroacetylacetonate and zirconium hexafluoroacetylacetonate.

<6> The composition for forming a passivation layer according to any one of <1> to <5>, wherein the at least one compound selected from the group consisting of a titanium compound, a zirconium compound and a silicon alkoxide comprises at least the silicon alkoxide, and the silicon alkoxide is a silicon alkoxide represented by the following Formula (III):

$$(R^6O)_{(4-m)}SiR^7_m \qquad (III)$$

[wherein, in Formula (III), each of $R^6$ and $R^7$ independently represents an alkyl group having from 1 to 8 carbon atoms, and m represents an integer from 0 to 3.]

<7> The composition for forming a passivation layer according to any one of <1> to <6>, wherein a content of the compound represented by Formula (I), the at least one compound selected from the group consisting of a titanium compound, a zirconium compound and a silicon alkoxide and the compound represented by Formula (II) is from 0.1% by mass to 80% by mass of a total mass of the composition for forming a passivation layer.

<8> The composition for forming a passivation layer according to any one of <1> to <7>, wherein a total content of the solvent and the resin is from 5% by mass to 98% by mass of a total mass of the composition for forming a passivation layer.

<9> Use of the composition according to any one of <1> to <8> for forming a passivation layer on an entire or partial surface of a semiconductor substrate.

<10> A semiconductor substrate having a passivation layer, comprising:

a semiconductor substrate; and

a passivation layer that is a thermally-treated product of the composition for forming a passivation layer according to any one of <1> to <8> and that is provided at an entire or partial surface of the semiconductor substrate.

<11> A method of producing a semiconductor substrate having a passivation layer, the method comprising:

a process of forming a composition layer by applying the composition for forming a passivation layer according to any one of <1> to <8> onto an entire or partial surface of a semiconductor substrate; and
a process of forming a passivation layer by subjecting the composition layer to a thermal treatment.

<12> A photovoltaic cell element, comprising:

a semiconductor substrate having a pn junction of a p-type layer and an n-type layer;
a passivation layer that is a thermally-treated product of the composition for forming a passivation layer according to any one of <1> to <8> and that is provided at an entire or partial surface of the semiconductor substrate; and
an electrode provided at at least one of the p-type layer or the n-type layer.

<13> A method of producing a photovoltaic cell element, the method comprising:

a process of forming a composition layer by applying the composition for forming a passivation layer according to any one of <1> to <8> onto an entire or partial surface of a semiconductor substrate having a pn junction of a p-type layer and an n-type layer;
a process of forming a passivation layer by subjecting the composition layer to a thermal treatment; and
a process of forming an electrode at at least one of the p-type layer or the n-type layer.

Effect of the Invention

According to the invention, it is possible to provide a composition for forming a passivation layer that exhibits an excellent storage stability and enables formation of a passivation layer having a sufficiently high refractive index by a simple method. In addition, it is possible to provide a semiconductor substrate having a passivation layer that is obtained by using the composition for forming a passivation layer and that is provided with a passivation layer having a sufficiently high refractive index; a method of producing the semiconductor substrate having a passivation layer; a photovoltaic cell element that exhibits an excellent conversion efficiency; a method of producing the photovoltaic cell element; and a photovoltaic cell.

Brief Description of the Drawings

Figure 1 is a cross sectional view that schematically shows an example of a method of producing a photovoltaic cell element having a passivation layer according to the embodiment.
Figure 2 is a cross sectional view that schematically shows another example of a method of producing a photovoltaic cell element having a passivation layer according to the embodiment.
Figure 3 is a cross sectional view that schematically shows an example of a backside electrode-type photovoltaic cell element having a passivation layer according to the embodiment.
Figure 4 is a plan view that schematically shown an example of a screen mask for forming an electrode according to the embodiment.
Figure 5 is a cross sectional view showing a structure of a double-sided electrode type photovoltaic cell element.
Figure 6 is a cross sectional view of a first constitutional example of a photovoltaic cell element according to a reference embodiment.
Figure 7 is a cross sectional view of a second constitutional example of a photovoltaic cell element according to a reference embodiment.
Figure 8 is a cross sectional view of a third constitutional example of a photovoltaic cell element according to a reference embodiment.
Figure 9 is a cross sectional view of a fourth constitutional example of a photovoltaic cell element according to a reference embodiment.
Figure 10 is a cross sectional view of another constitutional example of a photovoltaic cell element according to a reference embodiment.

Embodiments for Implementing the Invention

In the present specification, the term "process" as used herein includes not only an independent process but also a process that is not clearly distinguishable from one another, so long as it can attain its object. The numerical value range expressed as "A to B" indicates a range that includes A as a maximum value and B as a minimum value, respectively. Furthermore, unless otherwise indicated, when there are plural kinds of substances that correspond to a component, the content of the component refers to the total contents of the substances. The term "layer" includes a construction having a shape formed on a part of a region, in addition to a construction having a shape formed on an entire region.

<Composition for forming passivation layer>

The composition for forming a passivation layer includes an alkoxide represented by the following Formula (I) (hereinafter, also referred to as a specific metal alkoxide compound); at least one compound selected from the group consisting of a titanium compound, a zirconium compound and a silicon alkoxide; a solvent; and a resin. The composition for forming a passivation layer may include other components, if necessary. Since the composition includes these components, it is possible to form a passivation layer having a sufficiently high refractive index by a simple method. In addition, the composition for forming a passivation layer has an excellent storage stability.

$$M(OR^1)_m \qquad (I)$$

In Formula (I), M includes at least one metal element selected from the group consisting of Nb, Ta, V, Y and Hf. $R^1$ represents an alkyl group having from 1 to 8 carbon atoms or an aryl group having from 6 to 14 carbon atoms. m represents an integer from 1 to 5.

By forming a composition layer having a desired shape by applying a composition for forming a passivation layer, including at least one kind of specific metal alkoxide compound and at least one kind of compound selected from the group of a titanium compound, a zirconium compound and a silicon alkoxide, onto a semiconductor substrate and subjecting the same to a thermal treatment (sintering), a passivation layer of a desired shape that has an excellent passivation effect and a sufficiently high refractive index can be formed. The process of the invention is simple without the need of using an evaporator or the like, and is high in productivity. In addition, a passivation layer can be formed into a desired shape without a complicated process such as masking. In addition, the composition for forming a passivation layer has an excellent stability with suppressed occurrence of problems over time such as gelation or the like, by including at least one kind of specific metal alkoxide compound and at least one kind of compound selected from the group of a titanium compound, a zirconium compound and a silicon alkoxide.

In the present specification, a passivation effect of a semiconductor substrate can be evaluated by measuring the effective lifetime of minority carriers in a semiconductor substrate on which a passivation layer is formed, by a microwave reflection photoconductivity decay method with a device such as WT-2000PVN manufactured by Semilab Japan K.K.

Effective lifetime $\tau$ is represented by the following Formula (A) in which $\tau_b$ represents a bulk lifetime inside a semiconductor substrate and $\tau_S$ represents a surface lifetime at a surface of a semiconductor substrate. The smaller the surface level density at a surface of the semiconductor substrate is, the longer the $\tau_S$ is, which results in longer effective lifetime $\tau$. Alternatively, as the defects such as dangling bonds inside the semiconductor substrate decrease, bulk lifetime $\tau_b$ becomes longer, which results in longer effective lifetime $\tau$. That is, measurement of effective lifetime $\tau$ enables evaluation of interfacial properties between the passivation layer and the semiconductor substrate, as well as internal properties of the semiconductor substrate such as dangling bonds.

$$1/\tau = 1/\tau_b + 1/\tau_S \qquad (A)$$

The longer the effective lifetime $\tau$ is, the slower the recombination velocity of the minority carriers is. By using a semiconductor substrate having a longer effective lifetime for a photovoltaic cell element, the conversion efficiency thereof is improved.

(Alkoxide represented by Formula (I))

The composition for forming a passivation layer includes at least one compound represented by Formula (I) (hereinafter, also referred to as a specific metal alkoxide compound). The specific metal alkoxide compound is an alkoxide of Nb, Ta, V or Hf (alkoxide compound). By including at least one kind of these alkoxide compounds in the composition

for forming a passivation layer, a passivation layer having an excellent passivation effect can be formed. The possible reason for this is as follows.

In a metal oxide, which is formed by performing thermal treatment (sintering) of a composition for forming a passivation layer that includes at least one kind of specific metal alkoxide compound, it is considered that a large fixed charge is readily generated due to defects of metal atoms or oxygen atoms. Further, it is considered that the fixed charge generates a charge near an interface of a semiconductor substrate, thereby reducing the concentration of minority carriers. As a result, it is considered that the recombination velocity of the carriers at the interface is suppressed, and a passivation layer that exhibits an excellent passivation effect can be formed. In addition, it is considered that a refractive index of the passivation layer is increased by including at least one kind of compound selected from the group consisting of a titanium compound, a zirconium compound and a silicon alkoxide.

As for the state of a passivation layer that generates a fixed charge on a semiconductor substrate, its binding mode can be analyzed from a cross section of the semiconductor substrate by electron energy loss spectroscopy (EELS) with a scanning transmission electron microscope (STEM). In addition, a crystalline phase near an interface of a passivation layer can be determined by measuring an X-ray diffraction spectrum (XRD). Also, a fixed charge of a passivation layer can be evaluated by capacitance voltage measurement (CV).

In Formula (I), M includes at least one metal element selected from the group consisting of Nb, Ta, V, Y and Hf. In view of a passivation effect, M is preferably at least one metal element selected from the group consisting of Nb, Ta and Y, more preferably Nb. In view of obtaining a negative fixed charge density of a passivation layer, M preferably includes at least one metal element selected from the group consisting of Nb, Ta, V and Hf, more preferably at least one selected form the group consisting of Nb, Ta, VO and Hf.

In Formula (I), each $R^1$ independently represents an alkyl group having from 1 to 8 carbon atoms or an aryl group having from 6 to 14 carbon atoms, preferably an alkyl group having from 1 to 4 carbon atoms. An alkyl group represented by $R^1$ may be straight or branched. Examples of an alkyl group represented by $R^1$ include a methyl group, an ethyl group, a propyl group, an isopropyl group, a butyl group, an isobutyl group, a sec-butyl group, a t-butyl group, a hexyl group, an octyl group, a 2-ethylhexyl group and a 3-ethylhexyl group. Examples of an aryl group represented by $R^1$ include a phenyl group. An alkyl group and an aryl group represented by $R^1$ may have a substituent, and examples of a substituent of an alkyl group include a halogen element, an amino group, a hydroxyl group, a carboxyl group, a sulfonic group and a nitro group. Examples of a substituent of an aryl group include a methyl group, an ethyl group, an isopropyl group, an amino group, a hydroxyl group, a carboxyl group, a sulfonic group and a nitro group.

From the viewpoint of storage stability and a passivation effect, $R^1$ is preferably an unsubstituted alkyl group having from 1 to 8 carbon atoms, more preferably an unsubstituted alkyl group having from 1 to 4 carbon atoms.

In Formula (I), m represents an integer from 1 to 5. From the viewpoint of storage stability, m is preferably 5 when M is Nb, m is preferably 5 when M is Ta, m is preferably 3 when M is VO, m is preferably 3when M is Y, and m is preferably 4 when M is Hf.

From the viewpoint of a passivation effect, M in the compound represented by Formula (I) is preferably Nb, Ta or Y. From the viewpoint of storage stability and a passivation effect, $R^1$ is more preferably an unsubstituted alkyl group having from 1 to 4 carbon atoms. From the viewpoint of storage stability, m is preferably an integer from 1 to 5.

Specifically, the specific metal alkoxide compound is preferably niobium methoxide, niobium ethoxide, niobium isopropoxide, niobium n-propoxide, niobium n-butoxide, niobium t-butoxide, niobium isobutoxide, tantalum methoxide, tantalum ethoxide, tantalum isopropoxide, tantalum n-propoxide, tantalum n-butoxide, tantalum t-butoxide, tantalum isobutoxide, yttrium methoxide, yttrium ethoxide, yttrium isopropoxide, yttrium n-propoxide, yttrium n-butoxide, yttrium t-butoxide, yttrium isobutoxide, vanadium methoxide oxide, vanadium ethoxide oxide, vanadium isopropoxide oxide, vanadium n-propoxide oxide, vanadium n-butoxide oxide, vanadium t-butoxide oxide, vanadium isobutoxide oxide, hafnium methoxide, hafnium ethoxide, hafnium isopropoxide, hafnium n-propoxide, hafnium n-butoxide, hafnium t-butoxide and hafnium isobutoxide. Among them, niobium ethoxide, niobium n-propoxide, niobium n-butoxide, tantalum ethoxide, tantalum n-propoxide, tantalum n-butoxide, yttrium isopropoxide and yttrium n-butoxide are preferred. From the viewpoint of obtaining a negative fixed charge density, niobium ethoxide, niobium n-propoxide, niobium n-butoxide, tantalum ethoxide, tantalum n-propoxide, tantalum n-butoxide, vanadium ethoxide oxide, vanadium n-propoxide oxide, vanadium n-butoxide oxide, hafnium ethoxide, hafnium n-propoxide and hafnium n-butoxide are preferred.

(Other compounds)

The composition for forming a passivation layer of the invention includes at least one kind of a compound selected from the group consisting of a titanium compound, a zirconium compound and a silicon alkoxide, in addition to a specific metal alkoxide compound. By including at least one kind of a compound selected from the group consisting of a titanium compound, a zirconium compound and a silicon alkoxide, it becomes possible to generate a composite oxide having a high refractive index together with a specific metal alkoxide compound, and to further improve a passivation effect.

By subjecting the composition for forming a passivation layer of the invention, the passivation layer to be formed has a greater refractive index as compared to a passivation layer formed from a specific metal alkoxide compound alone. For example, a photovoltaic cell element having a passivation layer on its light receiving surface, which has a high refractive index, exhibits an improved light use efficiency, and power generation efficiency is also improved. The refractive index of a passivation layer formed from the composition for forming a passivation layer is preferably 1.4 or more, more preferably 1.5 or more, further preferably from 1.5 to 2.5.

The titanium compound is not particularly limited, and may be selected from titanium compounds that are commonly used. In view of a property not to decompose a resin or the like that is in contact with the passivation layer, the titanium compound is preferably a compound that generates a denser composite oxide upon reaction with a specific metal alkoxide compound represented by Formula (I). Specific examples of the titanium compound include titanium methoxide, titanium ethoxide, titanium isopropoxide, titanium n-propoxide, titanium t-butoxide, titanium isobutoxide, titanium (diisopropoxide) bis(acetylacetonate) and titanium tetrakis (2-ethyl-1-hexanolate). The titanium compound used in the invention is particularly preferably a titanium alkoxide. Generally, it is known that titanium oxide obtained by subjecting a titanium compound to thermal treatment (sintering) has a high refractive index. However, if a titanium oxide as is is added to the composition for forming a passivation layer, there is fear that a resin or the like that is in contact with the passivation layer may decompose upon exposure to sunlight or the like, due to a photocatalyst effect of the titanium oxide. On the other hand, in a case in which a titanium compound is used in combination in the composition for forming a passivation layer, the titanium compound forms a composite oxide together with an organic aluminum compound. As a result, a photocatalyst effect is suppressed and a passivation layer having a high refractive index can be formed.

The zirconium compound is not particularly limited so long as it can generate a composite oxide upon reaction with a specific metal alkoxide compound represented by Formula (I). Specific examples of the zirconium compound include zirconium ethoxide, zirconium isopropoxide, zirconium n-propoxide, zirconium n-butoxide, zirconium t-butoxide, zirconium acetylacetone, zirconium trifluoroacetylacetonate and zirconium hexafluoroacetylacetonate. The zirconium compound used in the invention is particularly preferably a zirconium alkoxide. Generally, it is known that zirconium oxide obtained by subjecting a zirconium compound to thermal treatment (sintering) has a high refractive index. However, if zirconium oxide as is is added to the composition for forming a passivation layer, there is fear that a resin or the like that is in contact with the passivation layer may decompose upon exposure to sunlight or the like, due to a photocatalyst effect of the zirconium oxide. On the other hand, in a case in which a zirconium compound is used in combination in the composition for forming a passivation layer, the zirconium compound forms a composite oxide together with an organic aluminum compound. As a result, a photocatalyst effect is suppressed and a passivation layer having a high refractive index can be formed.

The silicon alkoxide is not particularly limited so long as it can generate a composite oxide upon reaction with a specific metal alkoxide compound represented by Formula (I) and a titanium compound or a zirconium compound that is added as necessary. In particular, the silicon alkoxide is preferably a compound represented by the following Formula (III).

$$(R^6O)_{(4-m)}SiR^7_m \qquad \text{(III)}$$

wherein, in Formula (III), each of $R^6$ and $R^7$ independently represents an alkyl group having from 1 to 8 carbon atoms. m represents an integer from 0 to 3.

Specific examples of the silicon alkoxide include silicon methoxide, silicon ethoxide and silicon tetrapropoxide.

From the viewpoint of reactivity with a specific metal alkoxide compound, a refractive index of a composite oxide to be generated and a passivation effect, the compound selected from the group consisting of a titanium compound, a zirconium compound and a silicon alkoxide is preferably at least one selected from the group consisting of a titanium compound and a zirconium compound, more preferably at least one selected from the group consisting of titanium isopropoxide, zirconium ethoxide and zirconium isopropoxide, further preferably at least one selected from the group consisting of titanium isopropoxide and zirconium ethoxide.

The total content of the at least one compound selected from the group consisting of a titanium compound, a zirconium compound and a silicon alkoxide may be from 0.1% by mass to 80% by mass, preferably from 0.5% by mass to 65% by mass, more preferably from 1% by mass to 65% by mass, further preferably from 2% by mass to 60% by mass, in the total mass of the composition for forming a passivation film.

From the viewpoint of a refractive index of a composite oxide to be generated and a passivation effect, the ratio of the content of the at least one compound selected from the group consisting of a titanium compound, a zirconium compound and a silicon alkoxide to the content of the specific metal alkoxide compound (specific metal alkoxide compound / compound selected from the group consisting of titanium compound, zirconium compound and silicon alkoxide) is preferably from 0.01 to 1000, more preferably from 0.05 to 500, further preferably from 0.1 to 100.

(Aluminum compound represented by Formula (II))

The composition for forming a passivation layer of the invention includes at least one of a compound represented by the following Formula (II) (hereinafter, also referred to as an "organic aluminum compound").

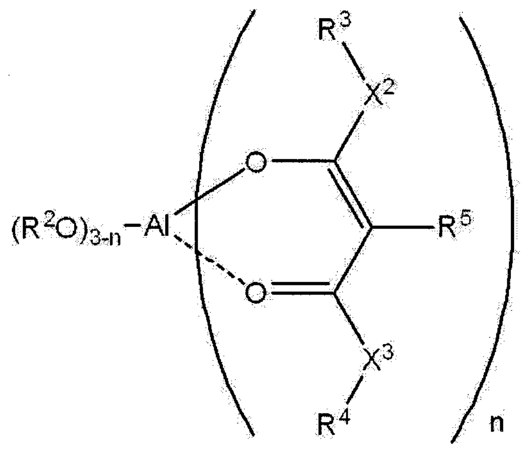

(II)

In Formula (II), each $R^2$ independently represents an alkyl group having from 1 to 8 carbon atoms. n represents an integer from 0 to 3. Each of $X^2$ and $X^3$ independently represents an oxygen atom or a methylene group. Each of $R^3$, $R^4$ and $R^5$ independently represents a hydrogen atom or an alkyl group having from 1 to 8 carbon atoms.

By including the organic aluminum compound as described above in the composition for forming a passivation layer, a passivation effect can be further improved. A possible reason for this is as follows.

The organic aluminum compound includes a compound that is referred to as aluminum alkoxide, aluminum chelate, or the like, and preferably includes an aluminum chelate structure in addition to an aluminum alkoxide structure. As described in Nippon Seramikkusu Kyokai Gakujitsu Ronbunshi, 97 (1989), 369 - 399, an organic aluminum compound is converted to an aluminum oxide ($Al_2O_3$) by thermal treatment (sintering). In that case, it is considered that the formed aluminum oxide tends to become amorphous, and a 4-fold coordinated aluminum oxide layer tends to be formed near the interface with a semiconductor substrate, and a large negative fixed charge attributed to a 4-fold coordinated aluminum oxide tends to be obtained. In that case, it is considered that complexation with an oxide derived from the specific metal alkoxide compound having a fixed charge is achieved, and a passivation layer having an excellent passivation effect is formed.

In Formula (II), each $R^2$ independently represents an alkyl group having from 1 to 8 carbon atoms, preferably an alkyl group having from 1 to 4 carbon atoms. An alkyl group represented by $R^2$ may be straight or branched. Examples of an alkyl group represented by $R^2$ include a methyl group, an ethyl group, a propyl group, an isopropyl group, a butyl group, an isobutyl group, a sec-butyl group, a t-butyl group, a hexyl group, an octyl group, and an ethylhexyl group. From the viewpoint of storage stability and a passivation effect, an alkyl group represented by $R^2$ is preferably an unsubstituted alkyl group having from 1 to 8 carbon atoms, more preferably an unsubstituted alkyl group having from 1 to 4 carbon atoms.

In Formula (II), n represents an integer from 0 to 3. From the viewpoint of storage stability, n is preferably an integer from 1 to 3, more preferably 1 or 3. Each of $X^2$ and $X^3$ independently represents an oxygen atom or a methylene group. From the viewpoint of storage stability, at least one of $X^2$ and $X^3$ is preferably an oxygen atom.

Each of $R^3$, $R^4$ and $R^5$ in Formula (II) independently represents a hydrogen atom or an alkyl group having from 1 to 8 carbon atoms. An alkyl group represented by $R^3$, $R^4$ and $R^5$ may be straight or branched. An alkyl group represented by $R^3$, $R^4$ and $R^5$ may have a substituent, or may be unsubstituted, and is preferably unsubstituted. Examples of an alkyl group represented by $R^3$, $R^4$ and $R^5$ include an alkyl group having from 1 to 8 carbon atoms, preferably an alkyl group having from 1 to 4 carbon atoms. Examples of an alkyl group represented by $R^3$, $R^4$ and $R^5$ include a methyl group, an ethyl group, a propyl group, an isopropyl group, a butyl group, an isobutyl group, a sec-butyl group, a t-butyl group, a hexyl group, an octyl group and a 2-ethylhexyl group.

From the viewpoint of storage stability and a passivation effect, it is preferred that each of $R^3$ and $R^4$ in Formula (II) independently represents a hydrogen atom or an unsubstituted alkyl group having from 1 to 8 carbon atoms, more preferably a hydrogen atom or an unsubstituted alkyl group having from 1 to 4 carbon atoms.

From the viewpoint of storage stability and a passivation effect, $R^5$ in Formula (II) is preferably a hydrogen atom or an unsubstituted alkyl group having from 1 to 8 carbon atoms, more preferably a hydrogen atom or an unsubstituted alkyl group having from 1 to 4 carbon atoms.

From the viewpoint of storage stability, the compound represented by Formula (II) is preferably a compound in which n is from 1 to 3, and each $R^5$ independently represents a hydrogen atom or an alkyl group having from 1 to 4 carbon atoms.

From the viewpoint of storage stability and a passivation effect, the compound represented by Formula (II) is preferably at least one selected from the group consisting of: a compound in which n is 0 and each $R^2$ independently represents an alkyl group having from 1 to 4 carbon atoms; and a compound in which n is from 1 to 3, each $R^2$ independently represents an alkyl group having from 1 to 4 carbon atoms, at least one of $X^2$ and $X^3$ is an oxygen atom, each of $R^3$ and $R^4$ independently represents a hydrogen atom or an alkyl group having from 1 to 4 carbon atoms, and each $R^5$ is independently a hydrogen atom or an alkyl group having from 1 to 4 carbon atoms.

More preferably, the compound represented by Formula (II) is at least one selected from the group consisting of: a compound in which n is 0 and each $R^2$ is independently an unsubstituted alkyl group having from 1 to 4 carbon atoms; and a compound in which n is from 1 to 3, each $R^2$ independently represents an unsubstituted alkyl group having from 1 to 4 carbon atoms, at least one of $X^2$ and $X^3$ is an oxygen atom, $R^3$ or $R^4$ that is bonded to this oxygen atom is an alkyl group having from 1 to 4 carbon atoms, wherein when $X^2$ or $X^3$ is a methylene group, $R^3$ or $R^4$ that is bonded to the methylene group is a hydrogen atom, and $R^5$ is a hydrogen atom.

Examples of an aluminum trialkoxide, which is an organic aluminum compound represented by Formula (II) in which n is 0, include aluminum trimethoxide, aluminum triethoxide, aluminum triisopropoxide, aluminum tri-sec-butoxide, aluminum mono-sec-butoxy-diisopropoxide, aluminum tri-t-butoxide and aluminum tri-n-butoxide.

Examples of an organic aluminum compound represented by Formula (II) in which n is from 1 to 3 include aluminum ethyl acetoacetate diisopropylate and tris(ethyl acetoacetate)aluminum.

The organic aluminum compound represented by Formula (II) in which n is from 1 to 3 may be a prepared product or a commercially available product. Examples of the commercially available product include ALCH, ALCH-50F, ALCH-75, ALCH-TR and ALCH-TR-20 (all trade names) manufactured by Kawaken Fine Chemicals Co., Ltd.

An organic aluminum compound represented by Formula (II) in which n is from 1 to 3 can be prepared by mixing an aluminum trialkoxide with a compound of a specific structure having two carbonyl groups. Alternatively, a commercially available aluminum chelate compound may be used.

When an aluminum trialkoxide is mixed with a compound of a specific structure having two carbonyl groups, at least some of alkoxide groups in the aluminum trialkoxide is substituted with the compound of a specific structure to form an aluminum chelate structure. If necessary, a solvent may exist, and thermal treatment, addition of a catalyst, or the like may be performed. When at least a part of the aluminum alkoxide structure is substituted with an aluminum chelate structure, stability of the organic aluminum compound against hydrolysis and polymerization reaction is improved, and storage stability of the composition for forming a passivation layer is further improved.

From the viewpoint of reactivity and storage stability, the compound of a specific structure having two carbonyl groups is preferably at least one selected from the group consisting of a β-diketone compound, a β-keto ester compound and a malonic diester.

Examples of a β-diketone compound include acetylacetone, 3-methyl-2,4-pentanedione, 2,3-pentanedione, 3-ethyl-2,4-pentanedione, 3-butyl-2,4-pentanedione, 2,2,6,6-tetramethyl -3,5-heptanedione, 2,6-dimethyl -3,5-heptanedione and 6-methyl-2,4-heptanedione.

Examples of a β-keto ester compound include methyl acetoacetate, ethyl acetoacetate. propyl acetoacetate, isobutyl acetoacetate, butyl acetoacetate, t-butyl acetoacetate, pentyl acetoacetate, isopentyl acetoacetate, hexyl acetoacetate, n-octyl acetoacetate, heptyl acetoacetate, 3-pentyl acetoacetate, ethyl 2-acetylheptanoate, ethyl 2-butylacetoacetate, ethyl 4,4-dimethyl-3-oxovarelate, ethyl 4-methyl-3-oxovarelate, ethyl 2-ethylacetoacetate, ethyl hexylacetoacetate, methyl 4-methyl-3-oxovarelate, isopropyl acetoacetate, ethyl 3-oxohexanoate, ethyl 3-oxovarelate, methyl 3-oxovarelate, methyl 3-oxohexanoate, ethyl 2-methylacetoacetate, ethyl 3-oxoheptanoate, methyl 3-oxoheptanoate and methyl 4,4-dimethyl-3-oxovarelate.

Examples of a malonic diester typically include dimethyl malonate, diethyl malonate, dipropyl malonate, diisopropyl malonate, dibutyl malonate, di-t-butyl malonate, dihexyl malonate, t-butylethyl malonate, diethyl methylmalonate, diethyl ethylmalonate, diethyl isopropylmalonate, diethyl butylmalonate, diethyl sec-butylmalonate, diethyl isobutylmalonate and diethyl 1-methylbutylmalonate.

When the organic aluminum compound has an aluminum chelate structure, the number of the aluminum chelate structure is not particularly limited so long as it falls within the range of from 1 to 3. In particular, from the viewpoint of storage stability, it is preferably 1 or 3, and from the viewpoint of solubility, it is more preferably 1. The number of an aluminum chelate structure can be controlled by appropriately adjusting the mixing ratio of an aluminum trialkoxide and a compound that can form a chelate with aluminum. Alternatively, a compound having a desired structure may be selected from the commercially available aluminum chelate compounds.

From the viewpoint of a passivation effect and compatibility with a solvent that may be optionally included in the composition, the compound represented by Formula (II) is specifically preferably at least one selected from the group consisting of aluminum ethylacetoacetate diisopropylate and aluminum triisopropoxide, more preferably aluminum ethylacetoacetate diisopropylate.

The presence of an aluminum chelate structure in an organic aluminum compound can be confirmed by the conventionally used analysis method. For example, it can be confirmed by analyzing infrared spectroscopy spectra, nuclear magnetic resonance spectra, a melting point, or the like.

The content of the organic aluminum compound included in the composition for forming a passivation layer may be selected as necessary. From the viewpoint of storage stability and a passivation effect, the content of the organic aluminum compound may be from 0.5% by mass to 65% by mass, preferably from 1 % by mass to 65% by mass, more preferably from 2% by mass to 60% by mass, further preferably from 3% by mass to 60% by mass.

The organic aluminum compound may be liquid or solid, and is not particularly limited. From the viewpoint of a passivation effect and storage stability, an organic aluminum compound that exhibits favorable stability at an ambient temperature and favorable solubility or dispersibility in a solvent may be used to further improve homogeneity of the formed passivation layer, thereby stably providing a desired passivation effect.

(Resin)

The composition for forming a passivation layer includes a resin. By including a resin, morphological stability of a composition layer that is formed by applying the composition for forming a passivation layer on a semiconductor substrate is further improved, and a passivation layer can be selectively formed in a desired shape at a region at which the composition layer has been formed.

The type of the resin is not particularly limited. A preferred resin is easy to adjust its viscosity to a range in which a favorable pattern can be formed upon application of the composition for forming a passivation layer on a semiconductor substrate. Examples of the resin include polyvinyl alcohol; polyacrylamide; polyvinyl amide; polyvinyl pyrrolidone; polyethylene oxide; polysulfonic acid; polyacrylamide alkylsulfonic acid; cellulose and a cellulose derivative such as cellulose ether such as carboxymethyl cellulose, hydroxyethyl cellulose and ethyl cellulose; gelatin and a gelatin derivative; starch and a starch derivative; sodium alginate and a sodium alginate derivative; xanthan and a xanthan derivative; guar gum and a guar gum derivative; scleroglucan and a scleroglucan derivative; tragacanth and a tragacanth derivative; dextrin and a dextrin derivative; (meth)acrylic acid resin; (meth)acrylate resin such as alkyl(meth)acrylate resin and dimethylaminoethyl (meth)acrylate resin; butadiene resin; styrene resin; siloxane resin; and a copolymer of these resins. These resins may be used singly or as a combination of two or more kinds.

Among these resins, it is preferred to use a neutral resin that does not have either an acidic functional group or a basic functional group, from the viewpoint of storage stability and pattern formability. It is more preferred to use a cellulose derivative, because a cellulose derivative is easy to adjust its viscosity and thixotropic property even with a small amount.

The molecular weight of the resin is not particularly limited, and is appropriately adjusted in view of a desired viscosity for the composition for forming a passivation layer. The weight average molecular weight of the resin is preferably from 1,000 to 10,000,000, more preferably from 1,000 to 5,000,000, from the viewpoint of storage stability and pattern formability. The weight average molecular weight of a resin can be calculated from a calibration curve of a standard polystyrene, from a molecular weight distribution measured by GPC (gel permeation chromatography). The calibration curve is approximated by third degree equation using five sets of standard polystyrene samples (PStQuick MP-H, PStQuick B [TOSOH CORPORATION, trade name]). The measurement conditions of GPC are shown below.

Apparatus:

(Pump: Model L-2130 [Hitachi High-Technologies Corporation])
(Detector: Model L-2490 RI [Hitachi High-Technologies Corporation])
(Column oven: L-2350 [Hitachi High-Technologies Corporation])

Column:

Gelpack GL-R440 + Gelpack GL-R450 + Gelpack GL-R400M (3 columns in total)
(Hitachi Chemical Company, Ltd., trade name)
Column size: 10.7 mm (inner diameter) x 300 mm
Eluent: tetrahydrofuran
Sample Concentration: 10 mg/2 mL

Injected Amount: 200 μL
Flow Rate: 2.05 mL/min.
Measurement Temperature: 25°C

When the composition for forming a passivation layer includes a resin, the content of the resin in the composition for forming a passivation layer may be appropriately selected, if necessary. For example, the content of the resin is preferably from 0.1% by mass to 50% by mass in the total mass of the composition for forming a passivation layer. In order to develop the thixotropic property so that pattern formation is readily performed, the content of the resin is more preferably from 0.2% by mass to 25% by mass, still more preferably from 0.5% by mass to 20% by mass, particularly preferably from 0.5% by mass to 15% by mass.

(Solvent)

The composition for forming a passivation layer may include a solvent. By including a solvent in the composition for forming a passivation layer, adjustment of the viscosity becomes easier and applicability improves, thereby enabling formation of a more uniform passivation layer. The liquid medium is not particularly limited, and appropriately selected. In particular, the solvent is preferably a liquid medium that can dissolve a specific metal alkoxide compound represented by Formula (I), at least one compound selected from the group consisting of a titanium compound, a zirconium compound and a silicon alkoxide, and a compound represented by Formula (II) that is optionally added, more preferably includes at least one kind of organic solvent.

Examples of a solvent typically include a ketone solvent such as acetone, methyl ethyl ketone, methyl-n-propyl ketone, methyl isopropyl ketone, methyl-n-butyl ketone, methyl isobutyl ketone, methyl-n-pentyl ketone, methyl-n-hexyl ketone, diethyl ketone, dipropyl ketone, diisobutyl ketone, trimethyl nonanone, cyclohexanone, cyclopentanone, methyl cyclohexanone, 2,4-pentanedione and acetonitrile acetone; an ether solvent such as diethyl ether, methyl ethyl ether, methyl-n-propyl ether, diisopropyl ether, tetrahydrofuran, methyl tetrahydrofuran, dioxane, dimethyl dioxane, ethyleneglycol dimethyl ether, ethyleneglycol diethyl ether, ethyleneglycol di-n-propyl ether, ethyleneglycol dibutyl ether, diethyleneglycol dimethyl ether, diethyleneglycol diethyl ether, diethyleneglycol methyl ethyl ether, diethyleneglycol methyl-n-propyl ether, diethyleneglycol methyl-n-butyl ether, diethyleneglycol di-n-propyl ether, diethyleneglycol di-n-butyl ether, diethyleneglycol methyl-n-hexyl ether, triethyleneglycol dimethyl ether, triethyleneglycol diethyl ether, triethyleneglycol methyl ethyl ether, triethyleneglycol methyl-n-butyl ether, triethyleneglycol di-n-butyl ether, triethyleneglycol methyl-n-hexyl ether, tetraethyleneglycol dimethyl ether, tetraethyleneglycol diethyl ether, tetraethyleneglycol methyl ethyl ether, tetraethyleneglycol methyl-n-butyl ether, tetraethyleneglycol di-n-butyl ether, tetraethyleneglycol methyl-n-hexyl ether, tetraethyleneglycol di-n-butyl ether, propyleneglycol dimethyl ether, propyleneglycol diethyl ether, propyleneglycol di-n-propyl ether, propyleneglycol dibutyl ether, dipropyleneglycol dimethyl ether, dipropyleneglycol diethyl ether, dipropyleneglycol methyl ethyl ether, dipropyleneglycol methyl-n-butyl ether, dipropyleneglycol di-n-propyl ether, dipropyleneglycol di-n-butyl ether, dipropyleneglycol methyl-n-hexyl ether, tripropyleneglycol dimethyl ether, tripropyleneglycol diethyl ether, tripropyleneglycol methyl ethyl ether, tripropyleneglycol methyl-n-butyl ether, tripropyleneglycol di-n-butyl ether, tripropyleneglycol methyl-n-hexyl ether, tetrapropyleneglycol dimethyl ether, tetrapropyleneglycol diethyl ether, tetrapropyleneglycol methyl ethyl ether, tetrapropyleneglycol methyl-n-butyl ether, tetrapropyleneglycol di-n-butyl ether, tetrapropyleneglycol methyl-n-hexyl ether and tetrapropyleneglycol di-n-butyl ether; an ester solvent such as methyl acetate, ethyl acetate, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, 2-(2-butoxyethoxy)ethyl acetate, benzyl acetate, cyclohexyl acetate, methylcyclohexyl acetate, nonyl acetate, methyl acetoacetate, ethyl acetoacetate, diethyleneglycol methyl ether acetate, diethyleneglycol monoethyl ether acetate, dipropyleneglycol methyl ether acetate, dipropyleneglycol ethyl ether acetate, glycol diacetate, methoxytriethyleneglycol acetate, isoamyl acetate, ethyl propionate, n-butyl propionate, isoamyl propionate, diethyl oxalate, di-n-butyl oxalate, methyl lactate, ethyl lactate, n-butyl lactate, n-amyl lactate, ethyleneglycol methyl ether propionate, ethyleneglycol ethyl ether propionate, ethyleneglycol methyl ether acetate, ethyleneglycol ethyl ether acetate, propyleneglycol methyl ether acetate, propyleneglycol ethyl ether acetate, propyleneglycol propyl ether acetate, γ-butyrolactone and γ-valerolactone; an aprotic polar solvent such as acetonitrile, N-methyl pyrrolidinone, N-ethyl pyrrolidinone, N-propyl pyrrolidinone, N-butyl pyrrolidinone, N-hexyl pyrrolidinone, N-cyclohexyl pyrrolidinone, N,N-dimethyl formamide, N,N-dimethyl acetoamide and dimethyl sulfoxide; a hydrophobic organic solvent such as methylene chloride, chloroform, dichloroethane, benzene, toluene, xylene, hexane, octane, ethylbenzene, 2-ethylhexanoic acid, methyl isobutyl ketone and methyl ethyl ketone; an alcoholic solvent such as methanol, ethanol, n-propanol, isopropanol, n-butanol, isobutanol, sec-butanol, t-butanol, n-pentanol, isopentanol, 2-methyl butanol, sec-pentanol, t-pentanol, 3-methoxybutanol, n-hexanol, 2-methylpentanol, sec-hexanol, 2-ethylbutanol, sec-heptanol, n-octanol, 2-ethylhexanol, sec-octanol, n-nonylalcohol, n-decanol, sec-undecylalcohol, trimethylnonylalcohol, sec-tetradecylalcohol, sec-heptadecylalcohol, cyclohexanol, methylcyclohexanol, benzylalcohol, ethyleneglycol, 1,2-propyleneglycol, 1,3-butyleneglycol, diethyleneglycol, dipropyleneglycol, triethyleneglycol and tripropyleneglycol; a glycol monoether solvent such as ethyleneglycol monomethyl ether, ethyleneglycol monoethyl ether, ethyleneglycol monophenylether, diethyleneglycol monomethyl ether, diethyleneglycol monoethyl ether, diethyleneglycol mono-n-butyl ether, diethyleneglycol mono-n-hexyl ether, ethoxytriglycol, tetraethyleneglycol mono-n-butyl ether, propyleneglycol monomethyl ether, dipropyleneglycol monomethyl ether, dipropyleneglycol monoethyl ether and tripropyleneglycol monomethyl ether; a terpene solvent such as $\alpha$-terpinene, $\alpha$-terpineol, myrcene, alloocimene, limonene, dipentene, $\alpha$-pinene, $\beta$-pinene, terpineol, carvone, ocimene and phellandrene; and water. These liquid media may be used singly or in a combination of two or more kinds.

In particular, from the viewpoint of applicability with respect to a semiconductor substrate and pattern formability, the solvent is preferably at least one selected from the group consisting of a terpene solvent, an ester solvent and an alcohol solvent, more preferably at least one selected from the group consisting of a terpene solvent.

When the composition for forming a passivation layer includes a solvent, the content of the solvent is determined in view of applicability, pattern formability and storage stability. For example, from the viewpoint of applicability and pattern formability, the content of the solvent in the composition for forming a passivation layer is preferably from 5% by mass to 98% by mass, more preferably from 10% by mass to 95% by mass.

The composition for forming a passivation layer may include an acidic compound or a basic compound. When the composition for forming a passivation layer includes an acidic compound or a basic compound, from the viewpoint of storage stability, the content of the acidic compound or the basic compound is preferably 1% by mass or less, more preferably 0.1% by mass or less, respectively, in the composition for forming a passivation layer.

Examples of an acidic compound include a Bronsted acid and a Lewis acid. Specific examples include an inorganic acid such as hydrochloric acid and nitric acid, and an organic acid such as acetic acid. Examples of the basic compound include a Bronsted base and a Lewis base. Specific examples include an inorganic base such as an alkali metal hydroxide and an alkaline earth metal hydroxide, and an organic base such as trialkylamine and pyridine.

The viscosity of the composition for forming a passivation layer is not particularly limited, and can be appropriately selected depending on the application method onto a semiconductor substrate, and the like. For example, the viscosity of the composition for forming a passivation layer can be from 0.01 Pa·s to 10,000 Pa·s. From the viewpoint of pattern formability, the viscosity of the composition for forming a passivation layer is preferably from 0.1 Pa·s to 1,000 Pa·s. The viscosity is measured at 25°C at a shear rate of 1.0 $s^{-1}$, with a rotational shear viscometer.

The composition for forming a passivation layer preferably has a thixotropic property. In particular, when the composition for forming a passivation layer includes a resin, from the viewpoint of pattern formability, a thixotropic ratio ($\eta_1/\eta_2$), which is obtained by dividing shear viscosity $\eta_1$ at a shear rate of 1.0 $s^{-1}$ by shear viscosity $\eta_2$ at a shear rate of 10 $s^{-1}$, is preferably from 1.05 to 100, more preferably from 1.1 to 50. The shear viscosity is measured at a temperature of 25°C with a rotational shear viscometer equipped with a cone plate (diameter: 50 mm, cone angle: 1 °).

On the other hand, when the composition for forming a passivation layer includes a high-boiling point material instead of a resin, a thixotropic ratio ($\eta_1/\eta_3$), which is calculated by dividing a shear viscosity $\eta_1$ at a shear rate of 1.0 $s^{-1}$ by shear viscosity $\eta_3$ at a shear rate of 1,000 $s^{-1}$, is preferably from 1.05 to 100, more preferably from 1.1 to 50, from the viewpoint of pattern formability.

The method of producing the composition for forming a passivation layer is not particularly limited. For example, the composition can be produced by mixing a specific compound represented by Formula (I), at least one compound selected from the group consisting of a titanium compound, a zirconium compound and a silicon alkoxide, a solvent, a resin and a compound represented by Formula (II), according to a conventional method.

Identification of the component in the composition for forming a passivation layer and determination of the content of the component can be performed by thermal analysis such as differential thermal - thermogravimetric simultaneous measurement (TG/DTA), spectral analysis such as nuclear magnetic resonance (NMR), infrared spectroscopy (IR), chromatographic analysis such as high-speed liquid chromatography (HPLC), gel permeation chromatography (GPC) or the like.

<Semiconductor substrate having passivation layer>

A semiconductor substrate having a passivation layer according to the invention includes a semiconductor substrate and a passivation layer that is a thermally-treated (sintered) product of the composition for forming a passivation layer and is provided on an entire or partial surface of the semiconductor substrate. By having a passivation layer that is a thermally-treated (sintered) product of the composition for forming a passivation layer, the semiconductor substrate having a passivation layer exhibits an excellent passivation effect.

The semiconductor substrate may be either a p-type semiconductor substrate or an n-type semiconductor substrate. In particular, from the viewpoint of a passivation effect, a semiconductor substrate having a p-type layer at a side at which a passivation layer is formed is preferred. The p-type layer on a semiconductor substrate may be a p-type layer derived from a p-type semiconductor substrate, or a p-type layer that is formed on an n-type semiconductor substrate or a p-type semiconductor substrate as a p-type diffusion layer or a $p^+$-type diffusion layer.

The thickness of the semiconductor substrate is not particularly limited, and may be appropriately selected depending on the purpose. For example, the thickness of the semiconductor substrate may be from 50 μm to 1,000 μm, preferably from 75 μm to 750 μm.
The thickness of the passivation layer formed on a semiconductor substrate is not particularly limited, and appropriately selected depending on the purpose. For example, the thickness of the passivation layer is preferably from 5 nm to 50 μm, more preferably from 10 nm to 30 μm, further preferably from 15 nm to 20 μm.
The semiconductor substrate having a passivation layer can be applied to a photovoltaic cell element, a light-emitting diode element, or the like. For example, a photovoltaic cell element in which the semiconductor substrate having a passivation layer is used exhibits an excellent conversion efficiency. In a case in which the semiconductor substrate is applied to a photovoltaic cell element, the passivation layer is preferably provided at the light receiving surface side of the photovoltaic cell element.

<Method of producing semiconductor substrate having passivation layer>

The method of producing a semiconductor substrate having a passivation layer according to the invention includes: a process of applying the composition for forming a passivation layer onto an entire or partial surface of a semiconductor substrate to form a composition layer; and a process of forming a passivation layer by subjecting the composition layer to a thermal treatment (sintering). The method may include other processes, if necessary.
By using the composition for forming a passivation layer, a passivation layer having an excellent passivation effect can be formed by a simple method.
The semiconductor substrate is not particularly limited, and appropriately selected from those conventionally used depending on the purpose. Examples of the semiconductor substrate include a substrate of silicon, germanium or the like to which a p-type impurity or an n-type impurity is doped (diffused). Among them, a silicon substrate is preferred. The semiconductor substrate may be either a p-type semiconductor substrate or an n-type semiconductor substrate. In particular, from the viewpoint of a passivation effect, a semiconductor substrate having a p-type layer at a side at which a passivation layer is formed is preferred. The p-type layer on a semiconductor substrate may be a p-type layer derived from a p-type semiconductor substrate, or a p-type layer that is formed on an n-type semiconductor substrate or a p-type semiconductor substrate as a p-type diffusion layer or a $p^+$-type diffusion layer.
The thickness of the semiconductor substrate is not particularly limited, and appropriately selected depending on the purpose. For example, the thickness of the semiconductor substrate may be from 50 μm to 1,000 μm, preferably from 75 μm to 750 μm.
The method of producing a semiconductor substrate having a passivation layer preferably further includes a process of applying an aqueous alkaline solution onto the semiconductor substrate before a process of forming a composition layer. In other words, a surface of a semiconductor substrate is preferably washed with an aqueous alkaline solution before the application of a composition for forming a passivation layer on a semiconductor substrate. Washing with an aqueous alkaline solution can remove organic substances, particles or the like that exist on a surface of a semiconductor substrate, thereby further enhancing the passivation effect. An example of the method of washing with an alkaline aqueous solution is RCA washing that is commonly known in the art. For example, a semiconductor substrate is immersed in a mixture of ammonium water and hydrogen peroxide water, treated at a temperature of from 60°C to 80°C to remove organic substances and particles, and washed. The washing time is preferably from 10 seconds to 10 minutes, more preferably from 30 seconds to 5 minutes.
The method of applying a composition for forming a passivation layer on a semiconductor substrate to form a composition layer is not particularly limited. For example, a method of applying a composition for forming a passivation layer on a semiconductor substrate by a known application method may be employed. Examples of the method include immersion, printing, spin coating, brushing, spraying, doctor blading, roll coating and ink jetting. Among them, printing of various types and ink jetting are preferred from the viewpoint of pattern formability.
The amount of the composition for forming a passivation layer to be applied may be appropriately selected depending on the purpose. For example, it is appropriately adjusted so that the passivation layer to be formed has a desired thickness.
The composition layer formed with a composition for forming a passivation layer is subjected to thermal treatment (sintering) to form a thermally-treated product layer (sintered product layer) derived from the composition layer, thereby forming a passivation layer on a semiconductor substrate.
The conditions for the thermal treatment (sintering) of the composition layer are not particularly limited, so long as an alkoxide represented by Formula (I), at least one compound selected from the group consisting of a titanium compound, a zirconium compound and a silicon alkoxide, and an organic aluminum compound represented by Formula (II) that is optionally included are converted to a metal oxide or a complex oxide as a thermally-treated (sintered) product. In order to effectively impart a fixed charge to a passivation layer and to provide a more excellent passivation effect, the thermal treatment (sintering) is preferably performed at a temperature of from 300°C to 900°C, more preferably from

450°C to 800°C. The time for the thermal treatment (sintering) may be 0.1 hours to 10 hours, for example, preferably from 0.2 hours to 5 hours.

The thickness of a passivation layer that is produced by a method of producing a semiconductor substrate having a passivation layer is not particularly limited, and appropriately selected depending on the purpose. For example, an average thickness of a passivation layer is preferably from 5 nm to 50 $\mu$m, preferably from 10 nm to 30 $\mu$m, further preferably from 15 nm to 20 $\mu$m.

The average thickness of the formed passivation layer is determined by measuring a thickness at three points with a stylus profilometer for measuring step height and surface roughness (Ambios Technology Inc., for example) by a routine method, and calculating an arithmetic average of the measured values.

The method of producing a semiconductor substrate having a passivation layer may further include a process of performing drying treatment of a composition layer formed from the composition for forming a passivation layer, between the process of applying a composition for forming a passivation layer onto a semiconductor substrate and the process of forming a passivation layer by performing thermal treatment (sintering). By including a process of performing drying treatment of the composition layer, a passivation layer having a more uniform thickness can be formed.

The process of performing drying treatment of a composition layer is not particularly limited, so long as at least a part of a solvent included in the composition for forming a passivation layer can be removed. The drying treatment is, for example, a thermal treatment performed at a temperature of from 30°C to 250°C for one minute to 60 minutes, preferably a thermal treatment performed at a temperature of from 40°C to 220°C for 3 minutes to 40 minutes. The drying treatment may be performed at an ambient pressure or under reduced pressure.

When the composition for forming a passivation layer includes a resin, the method of producing a semiconductor substrate having a passivation layer may include a process of defatting a composition layer formed from the composition for forming a passivation layer between the process of applying a composition for forming a passivation layer and the process of forming a passivation layer by performing thermal treatment (sintering). By performing defatting of the composition layer, a passivation layer having a more uniform passivation effect can be formed.

The process of performing defatting of a composition layer is not particularly limited, so long as at least a part of a resin that may be optionally included in the composition for forming a passivation layer can be removed. The defatting process can be, for example, a thermal treatment performed at a temperature of from 250°C to 450°C for 10 minutes to 120 minutes, preferably a thermal treatment performed at a temperature of from 300°C to 400°C for 3 minutes to 60 minutes. The defatting process is preferably performed in the presence of oxygen, more preferably in an air atmosphere.

<Photovoltaic cell element>

A photovoltaic cell element of the invention includes a semiconductor substrate having a pn junction of a p-type layer and an n-type layer, a passivation layer that is a thermally-treated (sintered) product of the composition for forming a passivation layer and is provided on an entire or partial surface of the semiconductor substrate, and an electrode provided on at least one of the p-type layer and the n-type layer of the semiconductor substrate. The photovoltaic cell element may further include other constituents, if necessary.

By having a passivation layer formed from the composition for forming a passivation layer of the invention, the photovoltaic cell element exhibits an excellent conversion efficiency.

The surface of the semiconductor substrate at which the passivation layer is to be formed may be either a p-type layer or an n-type layer. In particular, from the viewpoint of conversion efficiency, the surface at which the passivation layer is to be formed is preferably a p-type layer. The p-type layer on the semiconductor substrate may be a p-type layer derived from a p-type semiconductor substrate, or a p-type layer that is formed on an n-type semiconductor substrate or a p-type semiconductor substrate as a p-type diffusion layer or a $p^+$-type diffusion layer.

The thickness of the semiconductor substrate is not particularly limited, and may be appropriately selected depending on the purpose. For example, the thickness of the semiconductor substrate may be from 50 $\mu$m to 1,000 $\mu$m, preferably from 75 $\mu$m to 750 $\mu$m.

The thickness of the passivation layer formed on the semiconductor substrate is not particularly limited, and appropriately selected depending on the purpose. For example, an average thickness of the passivation layer is preferably from 5 nm to 50 $\mu$m, more preferably from 10 nm to 30 $\mu$m, still more preferably from 15 nm to 20 $\mu$m.

The shape and the size of the photovoltaic cell element may not be limited. For example, the photovoltaic cell element preferably has a square shape of from 125 mm to 156 mm for each side.

<Method of producing photovoltaic cell element>

The method of producing a photovoltaic cell element according to the invention includes a process of forming a composition layer by applying the composition for forming a passivation layer onto an entire or partial surface of a semiconductor substrate that has a pn junction of a p-type layer and an n-type layer and an electrode formed at at least

one of the p-type layer or the n-type layer; a process of forming a passivation layer by subjecting the composition layer to a thermal treatment (sintering). The method of producing a photovoltaic cell element may further include other processes, if necessary.

By using the composition for forming a passivation layer of the invention, a photovoltaic cell element that exhibits an excellent passivation effect, a passivation layer having a high refractive index, and an excellent conversion efficiency can be produced by a simple method. Further, since a passivation layer can be formed in a desired shape on a semiconductor substrate having an electrode formed thereon, productivity of the photovoltaic cell element is excellent.

A semiconductor having a pn junction and an electrode provided on at least one of a p-type layer or an n-type layer can be produced by an ordinary method. For example, an electrode can be formed by applying a paste for forming an electrode such as a silver paste, an aluminum paste or the like onto a desired region of a semiconductor substrate, and subjecting the same to thermal treatment (sintering), if necessary.

The surface of a semiconductor substrate on which a passivation layer is to be provided may be either a p-type layer or an n-type layer. In particular, a p-type layer is preferred from the viewpoint of conversion efficiency.

Details and preferred embodiments of the method of forming a passivation layer with the composition for forming a passivation layer are similar to those as described above in connection with the method of producing a semiconductor substrate having a passivation layer.

The thickness of a passivation layer to be formed on a semiconductor substrate is not particularly limited, and may be appropriately selected depending on the purpose. For example, an average thickness of a passivation layer is preferably from 5 nm to 50 $\mu$m, more preferably from 10 nm to 30 $\mu$m, further preferably from 15 nm to 20 $\mu$m.

As shown in Figure 1 (a), p-type semiconductor substrate 1 has $n^+$-type diffusion layer 2 that is formed in the vicinity of the surface and anti-reflection film 3 that is formed at the top surface. Examples of anti-reflection film 3 include a silicon nitride film and a titanium oxide film. A surface protection film of silicon oxide or the like (not shown) may exist between anti-reflection film 3 and p-type semiconductor substrate 1. Since the passivation layer of the invention has a high refractive index, a surface protection film is preferably formed between anti-reflection film 3 and p-type semiconductor substrate 1 (not shown). Although it is not shown in Figure 1, a method of producing a photovoltaic cell element having a passivation layer at the light receiving surface side is described later by referring to Figure 3.

Subsequently, as shown in Figure 1 (b), back surface electrode 5 is formed at a portion of the back surface by applying a material for forming back surface electrode 5 such as an aluminum electrode paste and performing thermal treatment. Also, $p^+$-type diffusion layer 4 is formed by allowing aluminum atoms to diffuse in p-type semiconductor substrate 1.

Further, as shown in Figure 1 (c), surface electrode 7 is formed by applying a paste for forming an electrode at the light receiving surface side and performing thermal treatment. By using a paste including a glass powder having a fire through property, an ohmic contact can be achieved as seen in Figure 1 (c) in which surface electrode 7 penetrates anti-reflection film 3 and is positioned on $n^+$-type diffusion layer 2.

In figure 1, although processes (b) and (c) are described as different processes, the processes (b) and (c) may be combined into one process. Specifically, it is possible to apply a paste for forming an electrode onto the light receiving surface side between the process of applying a material for forming back surface electrode 5 such as an aluminum electrode onto a portion of the back surface and the process of performing thermal treatment. In that case, an electrode at the back surface and an electrode at the light receiving surface can be formed at one thermal treatment, thereby simplifying the method.

Finally, as shown in Figure 1 (d), a composition layer is formed by applying the composition for forming a passivation layer onto the p-type layer at the back surface, except a region at which back surface electrode 5 is formed. The application may be performed by a method such as screen printing. By subjecting the composition layer formed on the p-type layer to thermal treatment (sintering), passivation layer 6 is formed. By forming passivation layer 6 from the composition for forming a passivation layer, a photovoltaic cell element that exhibits excellent conversion efficiency can be produced.

The photovoltaic cell element produced by a method including the processes as shown in Figure 1 may have a back surface electrode having a point contact structure that is formed from aluminum or the like. In that case, warpage or the like of a substrate can be reduced. Further, by using the composition for forming a passivation layer, a passivation layer can be formed at a region on the p-type layer except a region on which an electrode is formed, with excellent productivity.

In Figure 1 (d), a passivation layer is formed only at the back surface portion. However, a passivation layer may be formed at the edges of p-type semiconductor substrate 1 (not shown), in addition to the back surface side thereof, by applying the composition for forming a passivation layer onto the edges and performing thermal treatment (sintering). In this way, a photovoltaic cell element that exhibits a more excellent conversion efficiency can be produced.

Further, a passivation layer may be formed only at the edges, without forming a passivation layer at the back surface, by applying the composition for forming a passivation layer onto the edges and drying the same. The effect of the composition for forming a passivation layer is especially great when it is used at a portion that is rich in crystal defects

such as edges.

In Figure 1, a passivation layer is formed after the formation of an electrode. However, an electrode may be formed after the formation of a passivation layer by vapor evaporation or the like of aluminum or the like at a desired region.

Figure 2 is a cross sectional view that schematically illustrates the processes of a method of producing a photovoltaic cell element having a passivation layer according to the embodiment. Specifically, the method shown in Figure 2 includes a process of forming a $p^+$-type diffusion layer from an aluminum electrode paste or a composition for forming a p-type diffusion layer that can form a $p^+$-type diffusion layer by thermal treatment, and a process of removing a thermally-treated product of the aluminum electrode paste or a thermally-treated product of the composition for forming a $p^+$-type diffusion layer. Examples of the composition for forming a p-type diffusion layer include a composition that includes an acceptor element-containing substance and a glass component.

As shown in Figure 2 (a), p-type semiconductor substrate 1 has $n^+$-type diffusion layer 2 that is formed in the vicinity of the surface and anti-reflection layer 3 that is formed at the surface. Examples of anti-reflection layer 3 include a silicon nitride film and a titanium oxide film.

Subsequently, as shown in Figure 2 (b), $p^+$-type diffusion layer 4 is formed by applying a composition for forming a p-type diffusion layer at a portion of the back surface and performing thermal treatment. On $p^+$-type diffusion layer 4, thermally-treated product 8 of the composition for forming a $p^+$-type diffusion layer is formed.

It is possible to use an aluminum electrode paste instead of a composition for forming a p-type diffusion layer. When an aluminum electrode paste is used, aluminum electrode 8 is formed on $p^+$-type diffusion layer 4.

Subsequently, as shown in Figure 2 (c), thermally-treated product 8 of the composition for forming a p-type diffusion layer or aluminum electrode 8 formed on $p^+$-diffusion layer 4 is removed by a process such as etching.

Subsequently, as shown in Figure 2 (d), surface electrode 7 and back surface electrode 5 are formed at the light receiving surface (front surface) and the back surface, respectively, by applying a paste for forming an electrode at a portion of the light receiving surface (front surface) and the back surface in a selective manner, and performing thermal treatment. By using a composition including a glass powder having a fire through property as the paste for forming an electrode to be applied onto the light receiving surface side, an ohmic contact can be achieved by forming surface electrode 7 that penetrates anti-reflection film 3 and is positioned on $n^+$-type diffusion layer 2.

Further, since $p^+$-type diffusion layer 4 is already formed at a region at which a back surface electrode is to be formed, the paste for forming back surface electrode 5 is not limited to an aluminum electrode paste, and a paste that can form an electrode having a lower resistance, such as a silver electrode paste, can be used. By using a paste like this, it is possible to achieve a further improvement in conversion efficiency.

Finally, as shown in Figure 2 (e), a composition layer is formed by applying a composition for forming a passivation layer onto the p-type layer at the back surface other than a region at which back side electrode 5 is formed. The application can be performed by, for example, a method such as screen printing. By subjecting the composition layer formed on the p-type layer to thermal treatment (sintering), passivation layer 6 is formed. By forming passivation layer 6 from the composition for forming a passivation layer on the p-type layer at the back surface, a photovoltaic cell element having an excellent conversion efficiency can be produced.

In Figure 2 (e), a passivation layer is formed only at the back surface portion. However, a passivation layer may be formed at the edges of p-type semiconductor substrate 1 (not shown), in addition to the back surface side thereof, by applying the composition for forming a passivation layer onto the edges and drying the same. In this way, a photovoltaic cell element that exhibits a more excellent conversion efficiency can be produced.

Further, a passivation layer may be formed only at the edges, without forming a passivation layer at the back surface, by applying the composition for forming a passivation layer onto the edges and performing thermal treatment. The effect of the composition for forming a passivation layer is especially great when it is used at a portion that is rich in crystal defects such as the edges.

In Figure 2, a passivation layer is formed after the formation of an electrode. However, an electrode may be formed after the formation of a passivation layer by vapor evaporation or the like of aluminum or the like at a desired region.

In the embodiment as described above, a p-type semiconductor substrate having an $n^+$-type diffusion layer formed at the light receiving surface. However, a photovoltaic cell element can be produced also by using an n-type semiconductor substrate having a $p^+$-type diffusion layer at the light receiving surface. In that case, an $n^+$-type diffusion layer is formed at the back surface side.

Further, the composition for forming a passivation layer can be used for forming passivation layer 6 at the light receiving surface side or at the back surface side of a back surface electrode-type photovoltaic cell element, as shown in Figure 3, in which an electrode is positioned only at the back surface side.

As shown in Figure 3, $n^+$-type diffusion layer 2 is formed in the vicinity of the surface of the light receiving surface side of p-type semiconductor substrate 1, and passivation layer 6 and anti-reflection layer 3 are formed on the surface thereof. As anti-reflection film 3, a silicon nitride film, a titanium oxide film or the like is known. Passivation layer 6 is formed by applying the composition for forming a passivation layer of the invention, and subjecting the same to thermal treatment (sintering). Since the passivation layer according to the invention has a favorable refractive index,

conversion efficiency of a photovoltaic cell can be improved by providing the passivation film at the light receiving surface side.

At the back surface side of p-type semiconductor substrate 1, back side electrode 5 is provided on $p^+$-type diffusion layer 4 and $n^+$-type diffusion layer 2, and passivation layer 6 is provided at a region at which the back side electrodes are not formed.

$p^+$-type diffusion layer 4 can be formed by applying the composition for forming a p-type diffusion layer or an aluminum electrode paste onto a desired region and performing thermal treatment, as mentioned above. $n^+$-type diffusion layer 2 can be formed by, for example, applying a composition for forming an n-type diffusion layer that can form an $n^+$-type diffusion layer by performing thermal diffusion treatment.

Examples of the composition for forming an n-type diffusion layer include a composition that includes a donor element-containing substance and a glass component.

Back surface electrode 5 that is provided on $p^+$-type diffusion layer 4 and $n^+$-type diffusion layer 2, respectively, can be formed by using a paste for forming an electrode that is commonly used, such as a silver electrode paste.

Back surface electrode 5 formed on $p^+$-type diffusion layer 4 may be an aluminum electrode formed from an aluminum electrode paste that is formed together with $p^+$-type diffusion layer 4 in one process.

Passivation layer 6 may be formed not only at the back surface of p-type semiconductor substrate 1, but also at the edges thereof (not shown).

In the back side electrode-type photovoltaic cell element as shown in Figure 3, since an electrode is not formed at the light receiving surface, an excellent power generation efficiency can be achieved. Further, since a passivation layer is formed at a region at which a back side electrode is formed, conversion efficiency is further improved.

The above description is based on an example in which a p-type semiconductor substrate is used as a semiconductor substrate, but it is also possible to produce a photovoltaic cell element that exhibits an excellent conversion efficiency even in a case in which an n-type semiconductor substrate is used.

<Photovoltaic cell >

The photovoltaic cell of the invention includes the photovoltaic cell element as described above and a wiring material provided on an electrode of the photovoltaic cell element. In a preferred embodiment, the photovoltaic cell includes at least one photovoltaic cell element, and a wiring material is provided on an electrode of the photovoltaic cell element. As necessary, the photovoltaic cell may include plural photovoltaic cell elements that are connected via a wiring material, and sealed with a sealing material.

The wiring material and the sealing material are not particularly limited, and may be appropriately selected from those conventionally used in the art.

Examples

The invention is hereinafter specifically explained with reference to the examples, but the invention is not limited thereto. Unless otherwise specified, the percentage is based on mass.

<Example 1> (Reference example, not in accordance with invention)

(Preparation of composition for forming passivation layer 1)

An ethyl cellulose solution was prepared by mixing 5.0 g of ethyl cellulose (Nissin Kasei Co., Ltd., ETHOCEL 200 cps) and 95.0 g of terpineol as a solvent (Nippon Terpene Chemicals, Inc.) and stirring the mixture at 150°C for 1 hour.

Subsequently, composition for forming a passivation layer 1 was prepared by mixing 9.8 g of niobium ethoxide (Wako Pure Chemical Industries, Ltd., the same applies hereinafter) as an alkoxide compound represented by Formula (I), 6.7 g of titanium tetraisopropoxide (Wako Pure Chemical Industries, Ltd., the same applies hereinafter) as a titanium compound, 45.5 g of the ethyl cellulose solution and 38.0 g of terpineol (Nippon Terpene Chemicals, Inc., the same applies hereinafter). The composition of composition for forming a passivation layer 1 is shown in Table 1.

(Formation of passivation layer)

A monocrystalline p-type silicon substrate having a mirror surface (50 mm square, thickness: 625 μm, SUMCO Corporation) was used as a semiconductor substrate. The silicon substrate was subjected to pretreatment by dipping in an RCA washing solution (Kanto Chemical Co., Inc., Frontier Cleaner-A01) at 70°C for 5 minutes.

Thereafter, composition for forming a passivation layer 1 obtained above was applied onto an entire surface of the silicon substrate after the pretreatment, by screen printing such that the average thickness after drying is 5 μm,

and drying treatment was performed at 150°C for 5 minutes. Subsequently, thermal treatment (sintering) was performed at 700°C for 10 minutes, and cooled at room temperature (25°C), thereby preparing a substrate for evaluation.

<Evaluation>

Evaluation as described below was performed for the composition for forming a passivation layer obtained above and the substrate for evaluation obtained by using the same. The results are shown in Table 2.

(Evaluation of thixotropy)

Immediately after the preparation (within 12 hours) of composition for forming a passivation layer 1, the shear viscosity of the composition was measured at a temperature of 25°C at a shear rate of 1.0 $s^{-1}$ and 10 $s^{-1}$, respectively, with a rotational viscometer (Anton Paar GmbH, MCR301) with a cone plate (diameter: 50 mm, cone angle: 1 °).

The shear viscosity ($\eta_1$) at a shear rate of 1.0 $s^{-1}$ was 45.2 Pa·s, and the shear viscosity ($\eta_2$) at a shear rate of 10 $s^{-1}$ was 36.7 Pa·s. The thixotropic ratio ($\eta_1/\eta_2$) at a shear rate of 1.0 $s^{-1}$ and at a shear rate of 10 $s^{-1}$ was 1.2.

(Evaluation of storage stability)

The shear viscosity of composition for forming a passivation layer 1 as prepared above was measured immediately after the preparation (within 12 hours) and after being stored at 25°C for 30 days, respectively. The shear viscosity was measured with a rotational viscometer (Anton Paar GmbH, MCR301) equipped with a cone plate (diameter: 50 mm, cone angle: 1 °) at a temperature of 25°C at a shear rate of 10 $s^{-1}$.

The shear viscosity immediately after the preparation at 25°C ($\eta_0$) was 36.7 Pa·s, and the shear viscosity after being stored at 25°C for 30 days ($\eta_{30}$) was 38.2 Pa·s.

The change rate in shear viscosity after storage at 25°C for 30 days was calculated by the following formula (B), and storage stability was evaluated in accordance with the following criteria.

$$\text{Change rate in shear viscosity (\%)} = (\eta_{30} - \eta_0) / (\eta_0) \times 100 \quad \text{(B)}$$

[Evaluation criteria]

A: Change rate in shear viscosity is less than 10%.
B: Change rate in shear viscosity is from 10% to less than 30%.
C: Change rate in shear viscosity is 30% or more.

When the evaluation is A or B, the composition is favorable as a composition for forming a passivation layer.

(Print Blur)

In order to evaluate print blur, composition for forming a passivation layer 1 was applied onto an entire surface of a silicon substrate excluding the openings in the form of a dotted pattern as shown in Figure 4, by screen printing. The dotted pattern of the openings used in the evaluation has a dot diameter ($L_a$) of 368 μm and an interval ($L_b$) of 0.5 mm.

Subsequently, the silicon substrate onto which composition for forming a passivation layer 1 was applied was subjected to thermal treatment (sintering) at a temperature of 700°C for 10 minutes, and was allowed to cool at room temperature.

For the evaluation of print blur, a dot diameter ($L_a$) of the dotted openings 9 in the passivation layer formed on the substrate after the thermal treatment (sintering) was measured. The dot diameter ($L_a$) was measured at ten points, and an average thereof was calculated. The dot diameter ($L_a$) was 344 μm.

The result in which a decrease ratio of the dot diameter ($L_a$) after the thermal treatment (sintering) with respect to the dot diameter ($L_a$) immediately after printing (368 μm) is less than 10% is scored as A, the result in which the decrease ratio is from 10% to less than 30% is scored as B, and the result in which the decrease ratio is 30% or more is scored as C. When the evaluation is A or B, the composition is favorable as a composition for forming a passivation layer.

In the present specification, print blur refers to a phenomenon in which a composition layer that is formed from the composition for forming a passivation layer spreads in a plane direction on the semiconductor substrate.

(Measurement of effective lifetime)

The effective lifetime (μs) of the substrate for evaluation obtained above was measured with a lifetime measurement device (Semilab Japan K.K., WT-2000PVN) at room temperature by a microwave reflection photoconductivity decay method. The effective lifetime of a region of the obtained substrate for evaluation, at which the composition for forming a passivation layer was applied, was 450 μs.

(Measurement of thickness and refractive index of passivation layer)

The thickness (average thickness) and the refractive index of the passivation layer on the substrate for evaluation obtained above were measured with an interference-type film thickness meter (Filmetrics Corporation, F20 Thin Film Thickness Measurement System). The thickness of the passivation layer was 250 nm and the refractive index was 1.66.

<Example 2> (Reference example, not in accordance with invention)

(Preparation of composition for forming passivation layer 2)

Composition for forming a passivation layer 2 was prepared by mixing 7.6 g of tantalum (V) methoxide (Kojundo Chemical Lab. Co., Ltd.), 8.9 g of zirconium ethoxide (Wako Pure Chemical Industries, Ltd., the same applies hereinafter), 45.5 g of the ethyl cellulose solution as prepared in Example 1 and 38.0 g of terpineol. The composition of composition for forming a passivation layer 2 is shown in Table 1.

Then, the shear viscosity, thixotropy and storage stability of composition for forming a passivation layer 2 were evaluated in the same manner as Example 1. Further, after applying composition for forming a passivation layer 2 onto a silicon substrate and performing thermal treatment (sintering), the print blur was evaluated, and the effective lifetime, the thickness and the refractive index of the passivation layer were measured. The results are shown in Table 2.

<Example 3>

Composition for forming a passivation layer 3 was prepared by mixing 6.7 g of niobium ethoxide, 4.0 g of tetraethyl orthosilicate ($Si(OC_2H_5)_4$, Wako Pure Chemical Industries, Ltd., the same applies hereinafter), 6.0 g of aluminum ethyl acetoacetate diisopropylate (Kawaken Fine Chemicals Co.,Ltd., trade name: ALCH, the same applies hereinafter), 56.0 g of the ethyl cellulose solution as prepared in Example 1 and 27.3 g of terpineol. The composition of composition for forming a passivation layer 3 is shown in Table 1.

Then, the shear viscosity, thixotropy and storage stability of composition for forming a passivation layer 3 were evaluated in the same manner as Example 1. Further, after applying composition for forming a passivation layer 3 onto a silicon substrate and performing thermal treatment (sintering), the print blur was evaluated, and the effective lifetime, the thickness and the refractive index of the passivation layer were measured. The results are shown in Table 2.

<Example 4> (Reference example, not in accordance with invention)

Composition for forming a passivation layer 4 was prepared by mixing 8.8 g of vanadium (V) oxytriethoxide, 7.7 g of zirconium ethoxide, 45.5 g of the ethyl cellulose solution as prepared in Example 1 and 38.0 g of terpineol. The composition of composition for forming a passivation layer 4 is shown in Table 1.

Then, the shear viscosity, thixotropy and storage stability of composition for forming a passivation layer 4 were evaluated in the same manner as Example 1. Further, after applying composition for forming a passivation layer 4 onto a silicon substrate and performing thermal treatment (sintering), the print blur was evaluated, and the effective lifetime, the thickness and the refractive index of the passivation layer were measured. The results are shown in Table 2.

<Example 5>

Composition for forming a passivation layer 5 was prepared by mixing 7.6 g of yttrium ethoxide (Kojundo Chemical Lab. Co., Ltd.), 5.3 g of tetraethyl orthosilicate, 3.6 of aluminum ethyl acetoacetate diisopropylate, 45.5 g of the ethyl cellulose solution as prepared in Example 1 and 38.0 g of terpineol. The composition of composition for forming a passivation layer 5 is shown in Table 1.

Then, the shear viscosity, thixotropy and storage stability of composition for forming a passivation layer 5 were evaluated in the same manner as Example 1. Further, after applying composition for forming a passivation layer 5 onto a silicon substrate and performing thermal treatment (sintering), the print blur was evaluated, and the effective lifetime, the thickness and the refractive index of the passivation layer were measured. The results are shown in Table 2.

<Example 6>

Composition for forming a passivation layer 6 was prepared by mixing 7.2 g of hafnium ethoxide (Kojundo Chemical Lab. Co., Ltd.), 5.4 g of titanium tetraisopropoxide, 3.9 g of aluminum ethyl acetoacetate diisopropylate, 45.5 g of the ethyl cellulose solution as prepared in Example 1 and 38.0 g of terpineol. The composition of composition for forming a passivation layer 6 is shown in Table 1.

Then, the shear viscosity, thixotropy and storage stability of composition for forming a passivation layer 6 were evaluated in the same manner as Example 1. Further, after applying composition for forming a passivation layer 6 onto a silicon substrate and performing thermal treatment (sintering), the print blur was evaluated, and the effective lifetime, the thickness and the refractive index of the passivation layer were measured. The results are shown in Table 2.

<Example 7> (Reference example, not in accordance with invention)

Composition for forming a passivation layer 7 was prepared by mixing 8.0 g of niobium ethoxide, 8.5 g of zirconium ethoxide, 45.5 g of the ethyl cellulose solution as prepared in Example 1 and 38.0 g of terpineol. The composition of composition for forming a passivation layer 7 is shown in Table 1.

Then, the shear viscosity, thixotropy and storage stability of composition for forming a passivation layer 7 were evaluated in the same manner as Example 1. Further, after applying composition for forming a passivation layer 7 onto a silicon substrate and performing thermal treatment (sintering), the print blur was evaluated, and the effective lifetime, the thickness and the refractive index of the passivation layer were measured. The results are shown in Table 2.

<Example 8>

Composition for forming a passivation layer 8 was prepared by mixing 5.6 g of vanadium (V) oxytriethoxide, 5.5 g of tetraethyl orthosilicate, 5.4 g of aluminum ethyl acetoacetate diisopropylate, 45.5 g of the ethyl cellulose solution as prepared in Example 1 and 38.0 g of terpineol. The composition of composition for forming a passivation layer 8 is shown in Table 1.

Then, the shear viscosity, thixotropy and storage stability of composition for forming a passivation layer 8 were evaluated in the same manner as Example 1. Further, after applying composition for forming a passivation layer 8 onto a silicon substrate and performing thermal treatment (sintering), the print blur was evaluated, and the effective lifetime, the thickness and the refractive index of the passivation layer were measured. The results are shown in Table 2.

<Comparative Example 1>

Composition for forming a passivation layer C1 was prepared by mixing 16.5 g of niobium ethoxide and 38.0 of terpineol. The composition of composition for forming a passivation layer C1 is shown in Table 1.

Then, the shear viscosity, thixotropy and storage stability of composition for forming a passivation layer C1 were evaluated in the same manner as Example 1. Further, after applying composition for forming a passivation layer C1 onto a silicon substrate and performing thermal treatment (sintering), the print blur was evaluated, and the effective lifetime, the thickness and the refractive index of the passivation layer were measured. The results are shown in Table 2.

<Comparative Example 2>

Composition for forming a passivation layer C2 was prepared by mixing 16.5 g of tetraethyl orthosilicate and 38.0 of terpineol. The composition of composition for forming a passivation layer C2 is shown in Table 1.

Then, the shear viscosity, thixotropy and storage stability of composition for forming a passivation layer C2 were evaluated in the same manner as Example 1. Further, after applying composition for forming a passivation layer C2 onto a silicon substrate and performing thermal treatment (sintering), the print blur was evaluated, and the effective lifetime, the thickness and the refractive index of the passivation layer were measured. The results are shown in Table 2.

<Comparative Example 3>

Composition for forming a passivation layer C3 was prepared by mixing 16.5 g of aluminum ethyl acetoacetate diisopropylate and 38.0 of terpineol. The composition of composition for forming a passivation layer C3 is shown in Table 1.

Then, the shear viscosity, thixotropy and storage stability of composition for forming a passivation layer C3 were evaluated in the same manner as Example 1. Further, after applying composition for forming a passivation layer C2 onto a silicon substrate and performing thermal treatment (sintering), the print blur was evaluated, and the effective lifetime, the thickness and the refractive index of the passivation layer were measured. The results are shown in Table 2.

Table 1

| | Metal species | Kind | Example 1* | Example 2* | Example 3 | Example 4* | Example 5 | Example 6 | Example 7* | Example 8 | Comp. Example 1 | Comp. Example 2 | Comp. Example 3 |
|---|---|---|---|---|---|---|---|---|---|---|---|---|---|
| Compound of Formula (I) | Nb | Niobium ethoxide | 9.8 | - | 6.7 | - | - | - | 8.0 | - | 16.5 | - | - |
| | Ta | Tantalum ethoxide | - | 7.6 | - | - | - | - | - | - | - | - | - |
| | V | Vanadium (V) oxytriethoxide | - | - | - | 8.8 | - | - | - | 5.6 | - | - | - |
| | Y | Yttrium ethoxide | - | - | - | - | 7.6 | - | - | - | - | - | - |
| | Hf | Hafnium ethoxide | - | - | - | - | - | 7.2 | - | - | - | - | - |
| Titanium compound | Titanium tetraisopropoxide | | 6.7 | - | - | - | - | 5.4 | - | - | - | - | - |
| Zirconium compound | Zirconium ethoxide | | - | 8.9 | - | 7.7 | - | - | 8.5 | - | - | - | - |
| Silicon alkoxide | Tetraethyl orthosilicate | | - | - | 4.0 | - | 5.3 | - | - | 5.5 | - | 16.5 | - |
| Compound of Formula (II) | ALCH | | - | - | 6.0 | - | 3.6 | 3.9 | - | 5.4 | - | - | 16.5 |
| Solvent | Terpineol | | 81.2 | 81.2 | 80.5 | 81.2 | 81.2 | 81.2 | 81.2 | 81.2 | 38.0 | 38.0 | 38.0 |
| Resin | Ethyl cellulose | | 2.3 | 2.3 | 2.8 | 2.3 | 2.3 | 2.3 | 2.3 | 2.3 | - | - | - |
| Composition for forming passivation layer | | | Composition 1 | Composition 2 | Composition 3 | Composition 4 | Composition 5 | Composition 6 | Composition 7 | Composition 8 | Composition C 1 | Composition C2 | Composition C3 |

(continued)

| Metal species | Kind | Example 1* | Example 2* | Example 3 | Example 4* | Example 5 | Example 6 | Example 7* | Example 8 | Comp. Example 1 | Comp. Example 2 | Comp. Example 3 |
|---|---|---|---|---|---|---|---|---|---|---|---|---|
| Conditions for thermal treatment (sintering) | Temperature (°C) | 700 | 700 | 700 | 700 | 700 | 700 | 700 | 700 | 700 | 700 | 700 |
| | Time (minute) | 10 | 10 | 10 | 10 | 10 | 10 | 10 | 10 | 10 | 10 | 10 |

* Reference example, not in accordance with invention

Table 2

| | Composition for forming passivation layer | Shear viscosity 1.0 $s^{-1}$ [Pa·s] | Shear viscosity 10 $s^{-1}$ [Pa·s] | Thixotropy | Storage stability | Print blur | Effective lifetime [μs] | Thickness [nm] | Refractive index |
|---|---|---|---|---|---|---|---|---|---|
| Example 1* | Composition 1 | 45.2 | 36.7 | 1.2 | A | A | 450 | 250 | 1.66 |
| Example 2* | Composition 2 | 47.1 | 42.0 | 1.1 | A | A | 438 | 235 | 1.70 |
| Example 3 | Composition 3 | 44.8 | 38.0 | 1.2 | A | A | 490 | 240 | 1.64 |
| Example 4* | Composition 4 | 41.9 | 33.3 | 1.3 | A | A | 413 | 220 | 1.66 |
| Example 5 | Composition 5 | 50.1 | 42.3 | 1.2 | A | A | 455 | 235 | 1.74 |
| Example 6 | Composition 6 | 47.5 | 40.2 | 1.2 | A | A | 421 | 240 | 1.69 |
| Example 7* | Composition 7 | 45.6 | 37.3 | 1.2 | A | A | 550 | 230 | 1.71 |
| Example 8 | Composition 8 | 43.3 | 32.4 | 1.3 | A | A | 439 | 225 | 1.63 |
| Comparative Example 1 | Composition C1 | 46.2 | 40.1 | 1.2 | B | A | 280 | 210 | 1.55 |
| Comparative Example 2 | Composition C2 | 38.1 | 35.4 | 1.1 | B | B | 105 | 225 | 1.46 |
| Comparative Example 3 | Composition C3 | 45.3 | 38.0 | 1.2 | A | B | 408 | 230 | 1.56 |

* Reference example, not in accordance with invention

As shown above, a passivation layer having an excellent passivation effect and a favorable refractive index can be formed by using the composition for forming a passivation layer of the invention. Further, the composition for forming a passivation layer of the invention exhibits a favorable storage stability. Further, by using the composition for forming a passivation layer of the invention, a passivation film can be formed into a desired shape by a simple method.

<Reference Embodiment 1 >

A passivation film, an application material, a photovoltaic cell element, and a silicon substrate having a passivation film of Reference Embodiment 1 are hereinafter described.

<1> A passivation film that comprises aluminum oxide and niobium oxide and is used for a photovoltaic cell element having a silicon substrate.
<2> The passivation film according to <1>, wherein a mass ratio of the niobium oxide to the aluminum oxide (niobium oxide /aluminum oxide) is from 30/70 to 90/10.
<3> The passivation film according to <1> or <2>, wherein a total content of the niobium oxide and the aluminum oxide is 90% by mass or more.
<4> The passivation film according to any one of from <1> to <3>, further comprising an organic component.
<5> The passivation film according to any one of from <1> to <4>, which is a thermally-treated product of an application material comprising an aluminum oxide precursor and a niobium oxide precursor.
<6> An application material that comprises an aluminum oxide precursor and a niobium oxide precursor, and is used for formation of a passivation film of a photovoltaic cell element having a silicon substrate.
<7> A photovoltaic cell element that comprises:

a p-type silicon substrate that comprises monocrystalline silicon or polycrystalline silicon, and has a light receiving surface and a back surface that is opposite to the light receiving surface;
an n-type impurity diffusion layer that is formed on the light receiving surface of the silicon substrate;
a first electrode that is formed on the n-type impurity diffusion layer of the light receiving surface of the silicon substrate;
a passivation film that is formed on the back surface of the silicon substrate, the passivation film having plural openings and comprising aluminum oxide and niobium oxide; and
a second electrode that is electrically connected to the back surface of the silicon substrate through the plural openings.

<8> A photovoltaic cell element that comprises:

a p-type silicon substrate that comprises monocrystalline silicon or polycrystalline silicon, and has a light receiving surface and a back surface that is opposite to the light receiving surface;
an n-type impurity diffusion layer that is formed on a light receiving surface of the silicon substrate;
a first electrode that is formed on a surface of the n-type impurity diffusion layer of the light receiving surface of the silicon substrate;
a p-type impurity diffusion layer formed on a portion or on the area of the back surface of the silicon substrate, and doped with an impurity at a higher concentration than the silicon substrate;
a passivation film that is formed on the back side surface of the silicon substrate, the passivation film having plural openings and including aluminum oxide and niobium oxide; and
a second electrode that is electrically connected to the back side surface of the p-type impurity diffusion layer of the silicon substrate through the plural openings.

<9> A photovoltaic cell element that comprises:

an n-type silicon substrate that comprises monocrystalline silicon or polycrystalline silicon and has a light receiving surface and a back surface that is opposite to the light receiving surface;
a p-type impurity diffusion layer that is formed on the light receiving surface of the silicon substrate;
a second electrode that is formed on the back surface of the silicon substrate;
a passivation film that is formed on the light receiving surface of the silicon substrate, the passivation film having plural openings and including aluminum oxide and niobium oxide; and
a first electrode that is formed on the light receiving surface of the p-type impurity diffusion layer of the silicon substrate, and forms electrical connection with a surface at the light receiving side of the silicon substrate.

<10> The photovoltaic cell element according to any one of from <7> to <9>, wherein a mass ratio of niobium oxide to aluminum oxide (niobium oxide /aluminum oxide) in the passivation film is from 30/70 to 90/10.
<11> The photovoltaic cell element according to any one of from <7> to <10>, wherein a total content of the niobium oxide and the aluminum oxide in the passivation film is 90% by mass or more.
<12> A silicon substrate having a passivation film that comprises:

a silicon substrate; and
the passivation film according to any one of from <1> to <5> that is provided on an entire or partial surface of the silicon substrate.

According to the Reference Embodiment, a passivation film that can extend the carrier lifetime of a silicon substrate and has a negative fixed charge can be attained at low cost. Further, an application material for forming the passivation film can be provided. Further, a photovoltaic cell element that has the passivation film and exhibits a high efficiency can be attained at low cost. Further, a silicon substrate having a passivation film that extends the carrier lifetime and has a negative fixed charge can be attained at low cost.
The passivation film of the present embodiment is a passivation film used for a silicon photovoltaic cell element, and includes aluminum oxide and niobium oxide.
In the present embodiment, the amount of the fixed charge of the passivation film can be controlled by changing the composition of the passivation film.
From the viewpoint of stabilizing a negative fixed charge, the mass ratio of niobium oxide and aluminum oxide is preferably from 30/70 to 80/20. From the viewpoint of further stabilizing a negative fixed charge, the mass ratio of niobium oxide and aluminum oxide is more preferably from 35/65 to 70/30. From the viewpoint of achieving both an improvement in carrier lifetime and a negative fixed charge, the mass ratio of niobium oxide and aluminum oxide is preferably from 50/50 to 90/10.
The mass ratio of niobium oxide and aluminum oxide in the passivation film can be measured by energy dispersive X-ray spectrometry (EDX), secondary ion mass spectrometry (SIMS) and induced coupled plasma-mass spectrometry (ICP-MS). Specific conditions for the measurement are as follows. A passivation film is dissolved in an acid or an alkaline aqueous solution, and the resulting solution is atomized and introduced in an Ar plasma. Then, a light that is released when an excited element returns to the ground state is dispersed, and its wavelength and intensity are measured. Then, qualitative analysis of the element is performed from the resulting wavelength, and quantitative analysis is performed from the resulting intensity.
The total content of niobium oxide and aluminum oxide in the passivation film is preferably 80% by mass or more, more preferably 90% by mass or more, from the viewpoint of maintaining favorable properties. The more the content of niobium oxide and aluminum oxide in the passivation film is, the greater the effect of the negative fixed charge is.
The total content of niobium oxide and aluminum oxide in the passivation film can be measured by thermogravimetric analysis, fluorescent X-ray analysis, ICP-MS, and X-ray absorption spectroscopy in combination. Specific conditions for the measurement are as follows. The proportion of an inorganic component is calculated by thermogravimetric analysis, the proportion of niobium and aluminum is calculated by fluorescent X-ray or ICP-MS analysis, and the proportion of an oxide is determined by X-ray absorption spectroscopy.
From the viewpoint of improving the film quality and adjusting the elasticity, the passivation film may include a component other than niobium oxide and aluminum oxide as an organic component. The existence of an organic component in the passivation film can be confirmed by elemental analysis and FT-IR measurement of the film.
The content of an organic component in the passivation film is more preferably less than 10% by mass, still more preferably less than 5% by mass or less, especially preferably 1% by mass or less, in the passivation film.
The passivation film may be obtained as a thermally-treated product of an application material that includes an aluminum oxide precursor and a niobium oxide precursor. The details of the application material are described below.
The application material of the present embodiment includes an aluminum oxide precursor and a niobium oxide precursor, and is used for the formation of a passivation film for a photovoltaic cell element having a silicon substrate.
The aluminum oxide precursor is not particularly limited so long as it can produce an aluminum oxide. As an aluminum oxide precursor, an organic aluminum oxide precursor is preferably used in view of dispersing aluminum oxide onto a silicon substrate in a uniform manner, and chemical stability. Examples of the organic aluminum oxide precursor include an aluminum triisopropoxide (structural formula: $Al(OCH(CH_3)_2)_3$, Kojundo Chemical Lab. Co., Ltd., SYM-AL04.
The niobium oxide precursor is not particularly limited so long as it produces niobium oxide. As a niobium oxide precursor, an organic niobium oxide precursor is preferably used from the viewpoint of dispersing the niobium oxide precursor onto a silicon substrate in a uniform manner and chemical stability. Examples of the organic niobium oxide precursor include niobium (V) ethoxide (structural formula: $Nb(OC_2H_5)_5$, molecular weight: 318.21), Kojundo Chemical Lab. Co., Ltd., Nb-05.
The application material including an organic-based niobium oxide precursor and an organic-based aluminum

oxide precursor may be used to obtain a passivation film by forming a film by coating or printing, and removing an organic component by the subsequent thermal treatment (sintering). Therefore, as a result, the passivation film may include an organic component.

<Description of Structure of Photovoltaic Cell Element>

The structure of a photovoltaic cell element of the embodiment will be illustrated by referring to Figures 6 to 9. Figures 6 to 9 are cross sectional views of first to fourth structural examples in which a passivation film is provided at a back surface of the embodiment.

Silicon substrate used in this embodiment (a crystalline silicon substrate, a semiconductor substrate) 101 may be either monocrystalline silicon or polycrystalline silicon. Further, silicon substrate 101 may be either crystalline silicon having a p-type conductivity or crystalline silicon having an n-type conductivity. From the viewpoint of exhibiting an effect of the embodiment, a crystalline silicon having a p-type conductivity is more suitable.

In Figures 6 to 9, an example in which a p-type monocrystalline silicon as silicon substrate 101 is used is illustrated. The type of the monocrystalline silicon or polycrystalline silicon used for silicon substrate 101 is not particularly limited, but a monocrystalline silicon or a polycrystalline silicon having a resistivity of from 0.5 $\Omega\cdot$cm to 10 $\Omega\cdot$cm is preferred.

As shown in Figure 6 (first structural example), n-type diffusion layer 102 doped with a V-group element such as phosphorus is formed at a light receiving surface (upper side in the drawing, a first surface) of p-type silicon substrate 101. Then, a pn conjunction is formed between silicon substrate 101 and diffusion layer 102. On a surface of diffusion layer 102, light receiving surface anti-reflection film 103 such as a silicon nitride (SiN) film, and first electrode 105 (an electrode formed at the light receiving surface, a first electrode, a top electrode or a light receiving surface electrode) of silver (Ag) or the like are formed. Light receiving surface anti-reflection film 103 may function as a passivation film of a light receiving surface. By using a SiN film, the film can function as an anti-reflection film of a light receiving surface and function as a passivation film of a light receiving surface, respectively.

The photovoltaic cell element of the embodiment may have light receiving surface anti-reflection film 103, or may not. At the light receiving surface of a photovoltaic cell element, it is preferred to form a concave-convex structure (textured structure) in order to reduce the reflectivity at the surface. However, a photovoltaic cell element of the embodiment may not have a textured structure.

At the back surface (lower side in the drawing, second surface or a back surface) of silicon substrate 101, BSF (Back Surface Field) layer 104, which is a layer doped with a III-group element such as aluminum or boron, is formed. However, the photovoltaic cell element of the embodiment may include BSF layer 104, or may not.

At the back surface of silicon substrate 101, second electrode 106 (a back surface electrode, a second electrode or a back surface electrode) formed of aluminum or the like is formed in order to achieve a contact (electrical contact) with BSF layer 104 (or the back surface of silicon substrate 101 when BSF layer 104 is not formed).

In addition, in Figure 6 (first constitutional example), passivation film (a passivation layer) 107 that includes aluminum oxide and niobium oxide is formed at an area excluding a contact region (opening OA) at which BSF layer 104 (or back side surface of the silicon substrate 101 when BSF layer 104 is not formed) and second electrode 106 are electrically connected. Passivation film 107 of the present embodiment may have a negative fixed charge. By this fixed charge, electrons that correspond to minority carriers among those generated in silicon substrate 101 by light are reflected toward the surface side. Therefore, it is expected that a short-circuit current is increased and an incident photon-to-current conversion efficiency is improved.

Next, a second constitutional example shown in Figure 7 will be explained. In Figure 6 (first constitutional example), second electrode 106 is formed at a contact region (an opening OA) and at an entire surface of passivation film 107. In Figure 7 (second constitutional example), second electrode 106 is formed only at a contact region (opening OA). It is also possible that second electrode 106 is formed at a contact region (opening OA) and at a portion of passivation film 107. With the photovoltaic cell element having a constitution shown in Figure 7, a similar effect to the photovoltaic cell element shown in Figure 6 (first constitutional example) can be obtained.

Subsequently, a third constitutional example shown in Figure 8 will be explained. In the third constitutional example shown in Figure 8, BSF layer 104 is formed only at a portion of a back surface including a contact region (opening OA) with second electrode 106, rather than at an entire area of the back surface as shown in Figure 6 (first constitutional example). A photovoltaic cell element having a constitution as described above (Figure 8) can exhibit a similar effect to the photovoltaic cell element shown in Figure 6 (first constitutional example). Further, in the photovoltaic cell element of the third constitutional example as shown in Figure 8, since the area of BSF layer 104, i.e., the region that is doped with an impurity such as a third group element such as aluminum or boron at a higher concentration than that of silicon substrate 101 is small. Therefore, it is possible to obtain a higher incident photon-to-current conversion efficiency than the photovoltaic cell element shown in Figure 6 (first constitutional example).

Subsequently, a fourth constitutional example shown in Figure 9 will be explained. In Figure 8 (third constitutional example), second electrode 106 is formed at a contact region (opening OA) and at an entire surface of passivation film

107. In Figure 9 (fourth constitutional example), second electrode 106 is formed only at a contact region (opening OA). Second electrode 106 may be formed at the contact region (opening OA) and at a portion of passivation film 107. With a photovoltaic cell element shown in Figure 9, a similar effect to the photovoltaic cell element shown in Figure 8 (third constitutional example) can be obtained.

In the case in which second electrode 106 is formed at an entire back surface by printing and sintering at high temperature, a convex warpage tends to occur as the temperature decreases. Such a warpage may cause a damage to a photovoltaic cell element and affect the production yield. Further, as the thickness of a silicon substrate becomes smaller, the problem associated with a warpage becomes greater. The warpage is caused by a stress generated by contraction of second electrode 106 including a metal (such as aluminum) that is greater than that of a silicon substrate, which occurs during the temperature decrease because of its greater thermal expansion coefficient than that of the silicon substrate.

As described above, it is preferred not to form second electrode 106 on an entire area of the back surface, as is shown in Figure 7 (second constitutional example) and Figure 8 (fourth constitutional example), because the electrode structures at the upper and lower sides tend to be symmetry and a stress caused by a difference in the thermal expansion coefficient is less likely to occur. In that case, however, it is preferred to provide an anti-reflection layer.

<Description of method of producing photovoltaic cell element>

Subsequently, an example of a method for producing a photovoltaic cell element of this embodiment having a constitution as described above (Figures 6 to 9) will be explained. However, this embodiment is not limited to a photovoltaic cell element that is prepared by the method described below.

First, a textured structure is formed at a surface of silicon substrate 101, as shown in Figure 6, for example. The textured structure may be formed at both sides of silicon substrate 101, or only at one side (a light receiving surface side) of silicon substrate 101. In order to form a textured structure, silicon substrate 101 is immersed in a heated solution of potassium hydroxide or sodium hydroxide to remove a damaged layer of silicon substrate 101. Subsequently, by immersing silicon substrate 101 in a solution including potassium hydroxide and isopropyl alcohol as major components, a textured structure is formed at both sides or at one side (a light receiving surface side) of silicon substrate 101. As described above, this process may be omitted because the photovoltaic cell element of this embodiment may have a textured structure or may not.

Subsequently, after washing silicon substrate 101 with a solution of hydrochloric acid, hydrofluoric acid or the like, a phosphorus diffusion layer ($n^+$ layer) is formed as diffusion layer 102 on silicon substrate 101 by performing thermal diffusion of phosphorus oxychloride ($POCl_3$) or the like. The phosphorus diffusion layer may be formed by, for example, applying an application-type doping material solution containing phosphorus to silicon substrate 101 and performing thermal treatment. After the thermal treatment, by removing the phosphorus glass layer formed at a surface with an acid such as hydrofluoric acid, a phosphorus diffusion layer ($n^+$ layer) is formed as diffusion layer 102. The method of forming a phosphorus diffusion layer is not particularly limited. It is preferred to form a phosphorus diffusion layer such that the depth is in the range of from 0.2 $\mu$m to 0.5 $\mu$m from the surface of silicon substrate 101, and the sheet resistance is in the range of from 40 $\Omega$/square to 100 $\Omega$/square (ohm/square).

Subsequently, BSF layer 104 is formed at a back surface by applying an application doping material solution including boron, aluminum or the like at a back surface of silicon substrate 101 and performing thermal treatment. For the application, a method such as screen printing, ink-jetting, dispensing and spin coating may be used. After the thermal treatment, BSF layer 104 is formed by removing a layer of boron glass, aluminum or the like that is formed at the back surface with hydrofluoric acid, hydrochloric acid or the like. The method of forming BSF layer 104 is not particularly limited. Preferably, BSF layer 104 is formed such that the concentration of boron, aluminum or the like is in the range of from $10^{18}$ $cm^{-3}$ to $10^{22}$ $cm^{-3}$, and BSF layer 104 is formed in the form of a dot or a line. Since the photovoltaic cell element of this embodiment may include BSF layer 104 or may not, this process may be omitted.

Further, when both diffusion layer 102 at the light receiving surface, and BSF layer 104 at the back surface are formed with an application solution of a doping material, it is possible to apply the doping material solution onto both sides of silicon substrate 101, form a phosphorus diffusion layer ($n^+$ layer) as diffusion layer 102 and BSF layer 104 at one process, and then remove phosphorus glass, boron glass, or the like formed on the surface at one process.

Subsequently, a silicon nitride film, which is light receiving surface anti-reflection film 103, is formed on diffusion layer 102. The method of forming light receiving surface anti-reflection film 103 is not particularly limited. It is preferred to form light receiving surface anti-reflection film 103 such that the thickness is in the range of from 50 to 100 nm, and the refractive index is in the range of from 1.9 to 2.2. Light receiving surface anti-reflection film 103 is not limited to a silicon nitride film, and may be a silicon oxide film, an aluminum oxide film, a titanium oxide film or the like. Light receiving surface anti-reflection film 103 such as a silicon nitride film may be formed by plasma CVD, thermal CVD or the like, and is preferably formed by plasma CVD that can be performed at a temperature range of from 350°C to 500°C.

Subsequently, passivation film 107 is formed at the back surface of silicon substrate 101. Passivation film 107

includes aluminum oxide and niobium oxide, and is formed by, for example, applying a material including an aluminum oxide precursor represented by a metal-organic-decomposition application material that produces aluminum oxide upon thermal treatment (burning), and a niobium oxide precursor represented by a commercially available metal-organic-decomposition application material, from which niobium oxide is obtained upon thermal treatment (sintering) (a passivation material) and performing thermal treatment (sintering).

Passivation film 107 may be formed by a process as described below, for example. The application material is applied by spin coating onto one side of a p-type silicon substrate (from 8 Ωcm to 12 Ωcm) of 8 inches (20.32 cm) with a thickness of 725 μm, from which a spontaneously oxidized film had been removed in advance with hydrofluoric acid at a concentration of 0.049% by mass. Then, the silicon substrate is placed on a hot plate and pre-baked at 120°C for 3 minutes. Subsequently, thermal treatment is performed at 650°C for an hour in a nitrogen atmosphere. In that case, a passivation film including aluminum oxide and niobium oxide is obtained. The film thickness of passivation film 107 formed by the above method as measured with an ellipsometer is generally approximately several ten nm.

The above application material is applied by printing such as screen printing, offset printing, ink-jet printing, or with a dispenser, in the form of a predetermined pattern including a contact region (opening OA). Passivation film 107 (oxide film) is preferably formed by evaporating a solvent by performing pre-baking to the application material in a temperature range of 80°C to 180°C after application thereof, and performing thermal treatment (annealing) in a nitrogen atmosphere or an air atmosphere at a temperature of from 600°C to 1000°C for approximately 30 minutes to approximately 3 hours.

Opening (opening for contact) OA is preferably formed on BSF layer 104 in the form of a dot or a line.

Passivation film 107 used for the photovoltaic cell element as described above preferably has a mass ratio of niobium oxide and aluminum oxide (niobium oxide /aluminum oxide) of from 30/70 to 90/10, more preferably from 30/70 to 80/20, even more preferably from 35/65 to 70/30. By satisfying this range, a negative fixed charge can be stabilized. From the viewpoint of attaining both improvement in carrier lifetime and a negative fixed charge, the mass ratio of niobium oxide and aluminum oxide is preferably from 50/50 to 90/10.

Further, passivation film 107 preferably has a total content of niobium oxide and aluminum oxide of 80% by mass or more, more preferably 90% by mass or more.

Subsequently, first electrode 105, which is formed at the light receiving surface side, is formed. First electrode 105 is formed by applying a paste mainly composed of silver (Ag) onto light receiving surface anti-reflection film 103 by screen printing, and performing thermal treatment (fire through). The shape of first electrode 105 may be any form, such as a known shape formed of a finger electrode and a bus bar electrode.

Then, second electrode 106, which is a back surface electrode, is formed. Second electrode 106 may be formed by applying a paste mainly composed of aluminum by screen printing or with a dispenser, and subjecting the paste to thermal treatment. The shape of second electrode 106 is preferably the same shape as that of BSF layer 104, a shape covering the entire back surface, a comb-shape, a lattice-shape, or the like. It is also possible to perform printing of the paste for forming first electrode 105, which is an electrode formed at the light receiving surface side, and perform printing of the paste for forming second electrode 106, and subsequently performing thermal treatment (sintering) to form first electrode 105 and second electrode 106 at one process.

By using a paste mainly composed of aluminum (Al) for the formation of second electrode 106, aluminum diffuses as a dopant and BSF layer 104 is formed at a contact portion of second electrode 106 and silicon substrate 101 by self-aligning. As mentioned previously, BSF layer 104 may be formed separately by applying an application solution of a doping material containing boron, aluminum or the like, and subjecting the same to thermal treatment.

In the above description, although a p-type silicon is used as silicon substrate 101 in the structural and production examples, an n-type silicon may be used as silicon substrate 101. In that case, diffusion layer 102 is formed as a layer doped with a III-group element such as boron, and BSF layer 104 is formed by doping a V-group element such as phosphorus. However, it should be noted that there are cases in which a leakage current flows through a portion at which an inversion layer formed at an interface by a negative fixed charge contacts a metal at the back surface side, and it is difficult to increase conversion efficiency.

In a case in which an n-type silicon substrate is used, passivation film 107 that includes niobium oxide and aluminum oxide can be used at the light receiving surface, as shown in Figure 10. Figure 10 shows a constitutional example of a photovoltaic cell element in which a light receiving surface passivation film of the present embodiment is used.

In that case, diffusion layer 102 formed at the light receiving surface is converted to p-type by doping with boron, and among the generated carriers, holes are collected at the light receiving surface side and electrons are collected at the back surface side. Therefore, passivation film 107, which has a negative fixed charge, is preferably formed at the light receiving surface side.

On the passivation film that includes niobium oxide and aluminum oxide, an anti-reflection film composed of SiN or the like may be further formed by CVD or the like.

In the following, details of the present embodiment will be explained by referring to the Reference Examples and the Comparative Examples.

[Reference Example 1-1]

Passivation material (a-1) as an application material was prepared by mixing 3.0 g of a commercially available metal-organic-decomposition application material [Kojundo Chemical Lab. Co., Ltd., SYM-AL04, concentration: 2.3% by mass], from which aluminum oxide ($Al_2O_3$) is obtained upon thermal treatment (sintering) and 3.0 g of a commercially available metal-organic-decomposition application material [Kojundo Chemical Lab. Co., Ltd., Nb-05, concentration: 5% by mass], from which niobium oxide ($Nb_2O_5$) is produced upon thermal treatment (sintering).

Passivation material (a-1) was applied by spin-coating on one side of a p-type silicon substrate (from 8 Ω·cm to 12 Ω·cm) having a size of 8 inches and 725 μm in thickness, from which a spontaneously oxidized film had been previously removed with hydrofluoric acid at 0.049% by mass concentration, and the silicon substrate was pre-baked on a hot plate at 120°C for 3 minutes. Subsequently, thermal treatment (sintering) was performed under a nitrogen atmosphere at 650°C for an hour, thereby obtaining a passivation film including aluminum oxide and niobium oxide [niobium oxide /aluminum oxide = 68/32 (mass ratio)]. The film thickness as measured with an ellipsometer was 43 nm. As a result of FT-IR measurement of the passivation film, a slight peak derived from an alkyl group was observed at approximately 1,200 $cm^{-1}$.

Subsequently, a capacitor having a MIS (metal-insulator-semiconductor) structure was prepared by forming plural aluminum electrodes having a diameter of 1 mm on the passivation film by vapor deposition though a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +0.32 V. From this amount of shift, it was found that the passivation film obtained from passivation material (a-1) exhibited a negative fixed charge at a fixed charge density (Nf) of $-7.4 \times 10^{11}$ $cm^{-2}$.

In the same manner as the above, passivation material (a-1) was applied onto both sides of an 8-inch p-type silicon substrate. Then, the silicon substrate was pre-baked and subjected to thermal treatment (sintering) under a nitrogen atmosphere at 650°C for an hour, thereby preparing a sample of a silicon substrate having both sides covered with a passivation film. The carrier lifetime of this sample was measured with a lifetime measurement device (Kobelco Research Institute Inc., RTA-540). As a result, the carrier lifetime was 530 μs. For comparison, the carrier lifetime of the same 8-inch p-type silicon substrate, which was passivated by an iodine passivation method, was measured. The result was 1,100 μs.

From the above description, it was found that a passivation film obtained by thermal treatment (sintering) of the passivation material (a-1) exhibited a certain degree of passivation performance, and had a negative fixed charge.

[Reference Example 1-2]

In the same manner as Reference Example 1-1, a commercially available metal-organic decomposition application material [Kojundo Chemical Lab. Co., Ltd., SYM-AL04, concentration: 2.3% by mass] from which aluminum oxide ($Al_2O_3$) is obtained upon thermal treatment (sintering) and a commercially available metal-organic decomposition application material [Kojundo Chemical Lab. Co., Ltd., Nb-05, concentration: 5% by mass] from which niobium oxide ($Nb_2O_5$) is obtained upon thermal treatment (sintering) were mixed at different ratios, and passivation materials (a-2) to (a-7) shown in Table 3 were prepared.

In the same manner as Reference Example 1-1, a passivation film was prepared by applying each of passivation materials (a-2) to (a-7) onto one side of a p-type silicon substrate, and performing thermal treatment (sintering). The voltage dependency of the electrostatic capacitance of the resulting passivation film was measured, and the fixed charge density was calculated therefrom.

Further, in the same manner as Reference Example 1-1, a sample was prepared by applying a passivation material onto both sides of a p-type silicon substrate, and performing thermal treatment (sintering). The sample was used for the measurement of carrier lifetime. The results are summarized in Table 3.

Since passivation materials (a-2) to (a-7) exhibited a certain degree of carrier lifetime after thermal treatment (sintering), although the results were different depending on the ratios of niobium oxide /aluminum oxide (mass ratio) after thermal treatment (sintering), it was suggested that these passivation materials were capable of functioning as passivation films. It was found that all of the passivation films obtained from passivation materials (a-2) to (a-7) exhibited a negative fixed charge in a stable manner, and that the passivation films were suitable for the purpose of passivating a p-type silicon substrate.

Table 3

| Material | Niobium Oxide/Aluminum Oxide After Thermal treatment (Mass Ratio) | Film Thickness After Thermal treatment (nm) | Fixed Charge Density ($cm^{-2}$) | Carrier Lifetime (μs) |
|---|---|---|---|---|
| a-2 | 30/70 | 35 | $-1.1\times10^{10}$ | 610 |
| a-3 | 40/60 | 42 | $-2.1\times10^{10}$ | 540 |
| a-4 | 50/50 | 41 | $-7.1\times10^{10}$ | 530 |
| a-5 | 60/40 | 42 | $-4.1\times10^{11}$ | 400 |
| a-6 | 80/20 | 53 | $-8.3\times10^{11}$ | 280 |
| a-7 | 90/10 | 55 | $-9.5\times10^{11}$ | 100 |

[Reference Example 1-3]

3.18 g (0.010 mol) of a commercially available niobium (V) ethoxide (structural formula: $Nb(OC_2H_5)_5$, molecular weight: 318.21) and 1.02 g (0.005 mol) of a commercially available aluminum triisopropoxide (structural formula: $Al(OCH(CH_3)_2)_3$, molecular weight: 204.25) were dissolved in 80 g of cyclohexane, and passivation material (c-1) at a concentration of 5% by mass was prepared.

Passivation material (c-1) was applied by spin coating on one side of a p-type silicon substrate (from 8 Ω·cm to 12 Ω·cm) having a size of 8 inches and 725 μm in thickness, from which a spontaneously oxidized film had been previously removed with hydrofluoric acid at 0.049% by mass concentration, and the silicon substrate was pre-baked on a hot plate at 120°C for 3 minutes. Subsequently, thermal treatment (sintering) was performed under a nitrogen atmosphere at 600°C for an hour, thereby obtaining a passivation film including aluminum oxide and niobium oxide. The film thickness as measured with an ellipsometer was 50 nm. As a result of elemental analysis, the ratio Nb/Al/C was 81/14/5 (% by mass). As a result of FT-IR measurement of the passivation film, a slight peak derived from an alkyl group was observed at approximately 1,200 $cm^{-1}$.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +4.7 V. From this amount of shift, it was found that the passivation film obtained from passivation material (c-1) exhibited a negative fixed charge at a fixed charge density (Nf) of $-3.2 \times 10^{12}$ $cm^{-2}$.

In the same manner as the above, passivation material (c-1) was applied onto both sides of an 8-inch p-type silicon substrate, and the silicon substrate was pre-baked and subjected to thermal treatment (sintering) under a nitrogen atmosphere at 600°C for an hour, and a sample of a silicon substrate having both sides covered with a passivation film was prepared. The carrier lifetime of the sample was measured with a lifetime measurement device (Kobelco Research Institute Inc., RTA-540). As a result, the carrier lifetime was 330 μs. For comparison, the carrier lifetime of the same 8-inch p-type silicon substrate that had been passivated by an iodine passivation method was measured. The result was 1,100 μs.

In view of the above, it was found that a passivation film obtained by performing thermal treatment (sintering) to passivation material (c-1) exhibited a certain degree of passivation performance and a negative fixed charge.

[Reference Example 1-4]

Passivation material (c-2) was prepared by dissolving 2.35 g (0.0075 mol) of a commercially available niobium (V) ethoxide (structural formula: $Nb(OC_2H_5)_5$, molecular weight: 318.21), 1.02 g (0.005 mol) of a commercially available aluminum triisopropoxide (structural formula: $Al(OCH(CH_3)_2)_3$, molecular weight: 204.25) and 10 g of a novolac resin in 10 g of diethyleneglycol monobutyl ether acetate and 10 g of cyclohexane.

Passivation material (c-2) was applied by spin coating onto one side of a p-type silicon substrate (from 8 Ω·cm to 12 Ω·cm) having a size of 8 inches and 725 μm in thickness, from which a spontaneously oxidized film had been previously removed with hydrofluoric acid at 0.049% by mass concentration. The silicon substrate was pre-baked on a hot plate at 120°C for 3 minutes. Subsequently, thermal treatment (sintering) was performed under a nitrogen atmosphere at 600°C for an hour, and a passivation film including aluminum oxide and niobium oxide was prepared. The film thickness as measured with an ellipsometer was 14 nm. As a result of elemental analysis, the ratio Nb/Al/C was 75/17/8 (% by mass). As a result of FT-IR measurement of a passivation film, a slight peak derived from an alkyl group was observed

at approximately 1,200 $cm^{-1}$.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +0.10V. From this amount of shift, it was found that the passivation film obtained from passivation material (c-2) exhibited a negative fixed charge at a fixed charge density (Nf) of $-0.8 \times 10^{11}$ $cm^{-2}$.

In the same manner as the above, passivation material (c-2) was applied on both sides of an 8-inch p-type silicon substrate. The silicon substrate was pre-baked and subjected to thermal treatment (sintering) under a nitrogen atmosphere at 600°C for an hour, and a sample of a silicon substrate having both sides covered with a passivation film was prepared. The carrier lifetime of the sample was measured with a lifetime measurement device (Kobelco Research Institute Inc., RTA-540). As a result, the carrier lifetime was 200 μs. For comparison, the carrier lifetime of the same 8-inch p-type silicon substrate, which was passivated by an iodine passivation method, was measured. The result was 1,100 μs.

In view of the above, it was found that a passivation film obtained by performing thermal treatment (sintering) of passivation material (c-2) exhibited a certain degree of passivation performance and a negative fixed charge.

[Reference Example 1-5 and Reference Comparative Example 1-1]

In the same manner as Reference Example 1-1, a commercially available metal-organic decomposition application material [Kojundo Chemical Lab. Co., Ltd., SYM-AL04, concentration: 2.3% by mass] from which aluminum oxide ($Al_2O_3$) is obtained upon thermal treatment (sintering), a commercially available metal-organic decomposition application material [Kojundo Chemical Lab. Co., Ltd., Nb-05, concentration: 5% by mass] from which niobium oxide ($Nb_2O_5$) is obtained upon thermal treatment (sintering) were mixed at different ratios, and passivation materials (b-1) to (b-7) shown in Table 4 were prepared.

In the same manner as Reference Example 1-1, a passivation film was prepared by applying each of passivation materials (b-1) to (b-7) on one side of a p-type silicon substrate and performing thermal treatment (sintering). By using the passivation film, voltage dependency of the electrostatic capacitance was measured and a fixed charge density was calculated therefrom.

In the same manner as Reference Example 1-1, a sample obtained by applying a passivation material (an application material) on both sides of a p-type silicon substrate and curing the same was used for the measurement of a carrier lifetime. The results are shown in Table 4.

Table 4

| Material | Niobium Oxide/Aluminum Oxide after Thermal treatment (Weight Ratio) | Film Thickness after Thermal treatment (nm) | Fixed Charge Density ($cm^{-2}$) | Carrier Lifetime (μs) |
|---|---|---|---|---|
| b-1 | 10/90 | 35 | $2.3 \times 10^{11}$ | 600 |
| b-2 | 20/80 | 36 | $2.2 \times 10^{11}$ | 540 |
| b-3 | 10/90 | 40 | $1.1 \times 10^{10}$ | 480 |
| b-4 | 10/90 | 42 | $-1.2 \times 10^{10}$ | 520 |
| b-5 | 20/80 | 45 | $-1.0 \times 10^{10}$ | 440 |
| b-6 | 20/80 | 38 | $1.3 \times 10^{10}$ | 470 |
| b-7 | 0/100 | 34 | $2.2 \times 10^{11}$ | 600 |

It was found that all of the passivation films obtained from passivation materials (b-1) to (b-6) had a long carrier lifetime and were capable of functioning as a passivation film. In the cases in which niobium oxide / aluminum oxide was 10/90 and 20/80, there was a significant variability among the values of the fixed charge density and a negative fixed charge density was not obtained in a stable manner. However, it was confirmed that a negative fixed charge density could be achieved by using aluminum oxide and niobium oxide. When the measurement was performed by a CV method using a passivation material in which niobium oxide /aluminum oxide was 10/90 and 20/80, the resulting passivation film exhibited a positive fixed charge in some cases, and did not exhibit a negative fixed charge in a stable manner. A passivation film that exhibits a positive fixed charge can be used for passivation of an n-type silicon substrate.

On the other hand, a negative fixed charge density could not be obtained from passivation material (b-7)

composed of 100% by mass of aluminum oxide.

[Reference Comparative Example 1-2]

As passivation material (d-1), a commercially available metal-organic decomposition application material [Kojundo Chemical Lab. Co., Ltd., Ti-03-P, concentration: 3% by mass] from which titanium oxide ($TiO_2$) is obtained upon thermal treatment (sintering); as a passivation material (d-2), a commercially available metal-organic decomposition application material [Kojundo Chemical Lab. Co., Ltd., BT-06, concentration: 6% by mass] from which barium titanate ($BaTiO_3$) is obtained upon thermal treatment (sintering); and as passivation material (d-3), a commercially available metal-organic decomposition application material [Kojundo Chemical Lab. Co., Ltd., Hf-05, concentration: 5% by mass] from which hafnium oxide ($HfO_2$) is obtained upon thermal treatment (sintering), were prepared.

In the same manner as Reference Example 1-1, each of passivation materials (d-1) to (d-3) was applied on one side of a p-type silicon substrate, and the silicon substrate was subjected to thermal treatment (sintering) to prepare a passivation film. The passivation film was used for the measurement of voltage dependency of electrostatic capacitance, and a fixed charge density was calculated therefrom.

Moreover, in the same manner as Reference Example 1-1, a passivation material was applied on both sides of a p-type silicon substrate, and the carrier lifetime was measured using a sample obtained by performing thermal treatment (sintering). The results are shown in Table 5.

Table 5

| Material | Metal Oxide | Film Thickness after Thermal treatment (nm) | Fixed Charge Density ($cm^{-2}$) | Carrier Lifetime ($\mu s$) |
|---|---|---|---|---|
| d-1 | $TiO_2$ | 53 | $5.0\times10^9$ | 4 |
| d-2 | $BaTiO_3$ | 51 | $4.2\times10^9$ | 5 |
| d-3 | $HfO_2$ | 60 | $-4.0\times10^8$ | 54 |

All of the passivation film obtained from passivation materials (d-1) to (d-3) exhibited a small carrier lifetime, and exhibited an insufficient passivation performance. In addition, these passivation films exhibited a positive fixed charge. A passivation film obtained from passivation material (d-3) exhibited a negative fixed charge, but the value was small. In addition, the carrier lifetime was relatively small, which proved an insufficient function as a passivation film.

[Reference Example 1-6]

A photovoltaic cell element of a structure shown in Figure 8 was prepared using a monocrystalline silicon substrate doped with boron as silicon substrate 101. After performing texture processing to a surface of silicon substrate 101, the application-type phosphorus diffusion material was applied onto a light receiving surface, and diffusion layer 102 (a phosphorus diffusion layer) was formed by performing thermal treatment. Subsequently, the application-type phosphorus diffusion material was removed with dilute hydrofluoric acid.

Subsequently, a SiN film was formed by plasma CVD as light receiving surface anti-reflection film 103 on a light receiving surface. Then, passivation material (a-1) as prepared in Reference Example 1-1 was applied onto a region excluding a contact region (opening OA) at a back surface of silicon substrate 101 by an ink-jet method. Subsequently, passivation film 107 having opening OA was formed by performing thermal treatment.

As a sample, passivation film 107 was prepared, by using passivation material (c-1) prepared in Reference Example 1-3.

Subsequently, on light receiving surface anti-reflection film 103 (SiN film) formed on silicon substrate 101, a paste mainly composed of silver was applied by screen printing in the shape of predetermined finger electrodes and bus bar electrodes. On the back surface, a paste mainly composed of aluminum was applied onto an entire surface by screen printing. Subsequently, thermal treatment (fire through) was performed at 850°C to form an electrode (first electrode 105 and second electrode 106), and BSF layer 104 was formed by allowing aluminum to diffuse in a portion of opening OA at the back surface. A photovoltaic cell element having a structure shown in Figure 8 was thus prepared.

In the aforementioned method, the silver electrode at the light receiving surface was formed by a fire through process without forming an opening in the SiN film. However, it is also possible to form a silver electrode by forming opening OA to the SiN film, and then forming the silver electrode.

For comparison, an aluminum paste was applied onto an entire back surface according to the above preparation process, except that passivation film 107 was not formed. Then, $p^+$ layer 114 corresponding to BSF layer 104 and

electrode 116 corresponding to second electrode were formed on the entire surface, thereby forming a photovoltaic cell element having a structure shown in Figure 5. With these photovoltaic cell elements, characterization (short-circuit current, open-voltage, fill factor, and conversion efficiency) was performed. The characterization was performed according to JIS-C-8913 (2005) and JIS-C-8914 (2005). The results are shown in Table 6.

From the results shown in Table 6, it was found that a photovoltaic cell element having passivation film 107 including niobium oxide and aluminum oxide exhibited an increased short-circuit current and an increased open voltage, as compared to a photovoltaic cell element not having passivation film 107, and that the conversion efficiency (incident photon-to-current conversion efficiency) was increased by up to 1%.

Table 6

| Back Surface Passivation Film | Short-Circuit Current ($mA/cm^2$) | Open Voltage (V) | Fill Factor | Conversion Efficiency (%) |
|---|---|---|---|---|
| a-1 | 33.5 | 0.635 | 0.804 | 17.0 |
| c-1 | 33.4 | 0.625 | 0.803 | 16.7 |
| None | 32.8 | 0.61 | 0.80 | 16.0 |

<Reference Embodiment 2>

The following are a passivation film, an application material, a photovoltaic cell element and a silicon substrate having a passivation film, according to Reference Embodiment 2.

<1> A passivation film comprising an oxide of at least one vanadium-group element (vanadium-group element oxide) selected from the group consisting of aluminum oxide, vanadium oxide and tantalum oxide, the passivation film being used for a photovoltaic cell element having a silicon substrate.
<2> The passivation film according to <1>, wherein a mass ratio of the vanadium-group element oxide to the aluminum oxide (vanadium group element oxide / aluminum oxide) is from 30/70 to 90/10.
<3> The passivation film according to <1> or <2>, wherein a total content of the vanadium-group element oxide and the aluminum oxide is 90% or more.
<4> The passivation film according to any one of from <1> to <3>, comprising two or three vanadium-group element oxides selected from the group consisting of vanadium oxide, niobium oxide and tantalum oxide, as the oxide of vanadium-group element.
<5> The passivation film according to any one of from <1> to <4>, which is a thermally-treated product of an application material that comprises a precursor of at least one vanadium-group element oxide selected from the group consisting of an aluminum oxide precursor, a vanadium oxide precursor and a tantalum oxide precursor.
<6> An application material, comprising a precursor of at least one vanadium-group element oxide selected from the group consisting of an aluminum oxide precursor, a vanadium oxide precursor, and a tantalum oxide precursor, the application material being used for formation of a passivation film of a photovoltaic cell element having a silicon substrate.
<7> A photovoltaic cell element, comprising:

a p-type silicon substrate;
an n-type impurity diffusion layer formed at a first surface that is a light receiving surface of the silicon substrate;
a first electrode formed on the impurity diffusion layer;
a passivation film that has an opening and is formed on a second surface of the silicon substrate that is opposite to the light receiving surface; and
a second electrode that is formed on the second surface of the silicon substrate and is electrically connected through the opening of the passivation film to the second surface of the silicon substrate,
the passivation film being at least one vanadium-group element oxide selected from the group consisting of aluminum oxide, vanadium oxide and tantalum oxide.

<8> The photovoltaic cell element according to <7>, comprising a p-type impurity diffusion layer that is formed on a partial or an entire surface of the second surface of the silicon substrate, and is added with an impurity at a concentration higher than the concentration of the silicon substrate,
the second electrode being electrically connected through an opening of the passivation film to the p-type impurity diffusion layer.

<9> A photovoltaic cell element, comprising:

an n-type silicon substrate;
a p-type impurity diffusion layer that is formed on a first surface that is a light receiving surface of the silicon substrate;
a first electrode that is formed on the impurity diffusion layer;
a passivation film that has an opening and is formed on a second surface of the silicon substrate that is opposite to the light receiving surface; and
a second electrode that is formed on a second surface of the silicon substrate and is electrically connected through the opening of the passivation film to the second surface of the silicon substrate,
the passivation film comprising at least one vanadium-group element oxide selected from the group consisting of aluminum oxide, vanadium oxide and tantalum oxide.

<10> The photovoltaic cell according to <9>, comprising an n-type impurity diffusion layer that is formed on a partial or an entire surface of a second surface of the silicon substrate, and is added with an impurity at a concentration higher than the concentration of the silicon substrate,
the second electrode being electrically connected through the opening of the passivation film to the n-type impurity diffusion layer.
<11> The photovoltaic cell element according to any one of from <7> to <10>, wherein a mass ratio of the vanadium-group element oxide and the aluminum oxide in the passivation film is from 30/70 to 90/10.
<12> The photovoltaic cell element according to any one of from <7> to <11>, wherein a total content of the vanadium-type element oxide and the aluminum oxide in the passivation film is 90% or more.
<13> The photovoltaic cell element according to any one of from <7> to <12>, comprising two or three vanadium-group element oxides selected from the group consisting of vanadium oxide, niobium oxide, and tantalum oxide as the vanadium-group element oxide.
<14> The silicon substrate having a passivation film, comprising:

a silicon substrate; and
the passivation film for a photovoltaic cell element according to any one of from <1> to <5> which is provided on an entire or partial surface of the silicon substrate.

According to the Reference Embodiments as described above, a passivation film that can extend a carrier lifetime of a silicon substrate and has a negative fixed charge can be attained at low cost. In addition, an application material that attains formation the passivation film can be provided. In addition, a photovoltaic cell element that utilizes the passivation film and exhibits a high efficiency at low cost can be provided. Moreover, a silicon substrate having a passivation film that extends a carrier lifetime of a silicon substrate and has a negative fixed charge can be attained at low cost.
The passivation film of the present embodiment is a passivation film used for a silicon photovoltaic cell element, and includes at least one vanadium-group element oxide selected from the group consisting of aluminum oxide, vanadium oxide, and tantalum oxide.
In addition, in the present embodiment, the amount of a fixed charge of the passivation film can be controlled by changing the composition of the passivation film. A vanadium-group element herein refers to an element that belongs to group 5 in the periodic table, which is selected from vanadium, niobium and tantalum.
From the viewpoint of being able to stabilizing a negative fixed charge, the mass ratio of a vanadium-group element oxide to an aluminum oxide is more preferably from 35/65 to 90/10, further preferably from 50/50 to 90/10.
The mass ratio of a vanadium-group element oxide to an aluminum oxide in the passivation film can be measured by energy dispersive X-ray spectrometry (EDX), secondary ion mass spectrometry (SIMS) and induced coupled plasma-mass spectrometry (ICP-MS). Specific conditions for the measurement are as follows. A passivation film is dissolved in an acid or an alkaline aqueous solution, and the resulting solution is atomized and introduced in an Ar plasma. The light released when an excited element returns to the ground state is dispersed, and its wavelength and intensity are measured. The resulting wavelength is used for a qualitative analysis of an element, and the resulting intensity is used for quantitative analysis.
The total content of a vanadium-group element oxide and an aluminum oxide in a passivation film is preferably 80% by mass or more, and more preferably 90% by mass or more from the viewpoint of being able to maintaining a favorable property. The more the components other than a vanadium-group element oxide and an aluminum oxide in the passivation film are, the greater the effect of a negative fixed charge is.
From the viewpoint of improving the film quality and adjusting the elastic modulus, a component other than a vanadium-group element oxide and an aluminum oxide may be included in the passivation film as an organic component.

The existence of an organic component in the passivation film can be confirmed by elemental analysis and FT-IR measurement of the film.

From the viewpoint of obtaining a greater negative fixed charge, vanadium oxide ($V_2O_5$) is preferably selected as the vanadium-group element oxide.

The passivation film may include, as a vanadium-group element oxide, two or three kinds of vanadium-group element oxides selected from the group consisting of vanadium oxide, niobium oxide and tantalum oxide.

The passivation film is preferably obtained by performing thermal treatment of an application material, more preferably obtained by forming a film from an application material by a coating method or a printing method, and performing thermal treatment to remove an organic component from the film. That is, the passivation film may be obtained as a thermally-treated product of an application material that includes an aluminum oxide precursor and a vanadium-group element oxide precursor. Details of the application material will be described below.

The application material of the present embodiment is an application material used for a passivation film for a photovoltaic cell element having a silicon substrate, and includes a precursor of an aluminum oxide precursor and at least one vanadium-group element oxide precursor selected from a vanadium oxide precursor and a tantalum oxide precursor. As a vanadium-group element oxide precursor included in the application material, a vanadium oxide ($V_2O_5$) precursor is preferably selected from the viewpoint of a negative fixed charge of a passivation film formed from the applicable material. The application material may include, as a vanadium-group element oxide precursor, two or three kinds of vanadium-group element oxide precursor selected from the group consisting of a vanadium oxide precursor, a niobium oxide precursor and a tantalum oxide precursor.

The aluminum oxide precursor is not particularly limited so long as it can produce aluminum oxide. From the viewpoint of dispersing aluminum oxide to a silicon substrate in a uniform manner, and chemical stability, the aluminum oxide precursor is preferably an organic aluminum oxide precursor. Examples of an organic aluminum oxide precursor include aluminum triisopropoxide (structural formula: $Al(OCH(CH_3)_2)_3$, Kojundo Chemical Lab. Co., Ltd., SYM-AL04.

The vanadium-group element oxide precursor is not particularly limited so long as it can produce a vanadium-group element oxide. From the viewpoint of dispersing aluminum oxide to a silicon substrate in a uniform manner, and chemical stability, the vanadium-group element oxide precursor is preferably an organic vanadium-group element oxide precursor.

Examples of an organic vanadium oxide precursor include vanadium (V) oxytriethoxide (structural formula: $VO(OC_2H_5)_3$, molecular weight: 202.13), Kojundo Chemical Lab. Co., Ltd., V-02. Examples of an organic tantalum oxide precursor include tantalum (V) methoxide (structural formula: $Ta(OCH_3)_5$, molecular weight: 336.12), Kojundo Chemical Lab. Co., Ltd., Ta-10-P. Example of an organic niobium oxide precursor include niobium (V) ethoxide (structural formula: $Nb(OC_2H_5)_5$, molecular weight: 318.21), Kojundo Chemical Lab. Co., Ltd., Nb-05.

A passivation film can be obtained by forming a film from the application material that includes an organic vanadium-group element oxide precursor and an organic aluminum oxide precursor by a coating method or a printing method, and then performing thermal treatment to remove an organic component from the film. Accordingly, the passivation film may include an organic component. The content of an organic component in the passivation film is more preferably less than 10% by mass, still more preferably 5% by mass or less, especially preferably 1% by mass or less.

The photovoltaic cell element (photoelectric conversion device) of the present embodiment includes a passivation film (an insulating film, a protective insulating film) as described in the above embodiment, i.e., a film including aluminum oxide and at least one vanadium-group element oxide selected from vanadium oxide and tantalum oxide, near a photoelectric interface of a silicon substrate. By including aluminum oxide and at least one vanadium-group element oxide selected from the group consisting of vanadium oxide and tantalum oxide, it is possible to extend a carrier lifetime of a silicon substrate and exhibit a negative fixed charge, thereby improving the properties of a photovoltaic cell element (incident photon-to-current conversion efficiency).

For the description of the structure and the production method of the photovoltaic cell element according to the present embodiment, the description of the structure of and the production method of the photovoltaic cell element according to Reference Embodiment 1 may be referred to.

The present embodiments will be hereinafter described in detail by referring to the Reference Examples and the Comparative Examples.

<Vanadium oxide used as vanadium-group element oxide>

[Reference Example 2-1]

Passivation material (a2-1) as an application material was prepared by mixing 3.0 g of a commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering), and 6.0 g of a commercially available organic metal film application material [Kojundo Chemical Lab. Co., Ltd., V-02, concentration: 2% by mass] from which

vanadium oxide ($V_2O_5$) is obtained upon thermal treatment (sintering).

Passivation material (a2-1) was applied by spin coating on one side of a p-type silicon substrate (from 8 Ω·cm to 12 Ω·cm) having a size of 8 inches and 725 μm in thickness, from which a spontaneously oxidized film had been previously removed with hydrofluoric acid at 0.49% by mass concentration. The silicon substrate was pre-baked on a hot plate at 120°C for 3 minutes. Subsequently, thermal treatment (sintering) was performed under a nitrogen atmosphere at 700°C for 30 minutes, thereby obtaining a passivation film including aluminum oxide and vanadium oxide [vanadium oxide / aluminum oxide = 63/37 (% by mass)]. The film thickness as measured with an ellipsometer was 51 nm. As a result of FT-IR measurement of the passivation film, a slight peak derived from an alkyl group was observed at approximately 1,200 $cm^{-1}$.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +0.02 V. From this amount of shift, it was found that the passivation film obtained from passivation material (a2-1) exhibited a negative fixed charge at a fixed charge density (Nf) of $-5.2 \times 10\ cm^{-2}$.

In a similar manner to the above, passivation material (a2-1) was applied on both sides of an 8-inch p-type silicon substrate, and the silicon substrate was pre-baked and subjected to thermal treatment (sintering) under a nitrogen atmosphere at 650°C for an hour, thereby preparing a sample of a silicon substrate having both sides covered with a passivation film. The carrier lifetime of the sample was measured with a lifetime measurement device (Kobelco Research Institute Inc., RTA-540). As a result, the carrier lifetime was 400 μs. For comparison, the carrier lifetime of the same 8-inch p-type silicon substrate, which was passivated by an iodine passivation method, was measured. The result was 1,100 μs. Further, the carrier lifetime was measured again after 14 days from the preparation of the sample. The result was 380 μs. From these results, it was found that a decrease in the carrier lifetime (from 400 μs to 380 μs) was less than -10%, indicating that a decrease in carrier lifetime was small.

In view of the above, it was found that a passivation film obtained by performing thermal treatment (sintering) of passivation material (a2-1) exhibited a certain degree of passivation performance and a negative fixed charge.

[Reference Example 2-2]

In the same manner as Reference Example 2-1, a commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering), and a commercially available organic metal film application material [Kojundo Chemical Lab. Co., Ltd., V-02, concentration: 2% by mass] from which vanadium oxide ($V_2O_5$) is obtained upon thermal treatment were mixed at different ratios, and passivation materials (a2-2) to (a2-7) as shown in Table 7 were prepared.

In the same manner as Reference Example 2-1, a passivation film was prepared by applying each of passivation materials (a2-2) to (a2-7) onto one side of a p-type silicon substrate, and subjecting the same to thermal treatment (sintering). The voltage dependency of the electrostatic capacitance of the resulting passivation film was measured, and the fixed charge density was calculated therefrom.

In addition, in the same manner as Reference Example 2-1, a sample was prepared by applying a passivation material onto both sides of a p-type silicon substrate and performing thermal treatment (sintering), and the carrier lifetime of the sample was measured.

The obtained results are shown in Table 7. Further, the carrier lifetime was measured again after 14 days from the preparation of the sample. As a result, it was found that a decrease in the carrier lifetime of all of the passivation films obtained from passivation materials (a2-2) to (a2-7) as shown in Table 7 was less than -10%, indicating that the decrease in the carrier lifetime was small.

From the results that all of passivation materials (a2-2) to (a2-7) showed a negative fixed charge and a certain degree of carrier lifetime after the thermal treatment (sintering), it is suggested that the samples can function as a passivation film, although the results are different depending on the ratio of vanadium oxide / aluminum oxide (mass ratio) after the thermal treatment (sintering). All of the passivation films obtained from passivation materials (a2-2) to (a2-7) exhibited a negative fixed charge in a stable manner, and found to be suitably utilized for passivation of a p-type silicon substrate.

Table 7

| | Vanadium Oxide/Aluminum Oxide after Thermal treatment (Mass Ratio) | Film Thickness after Thermal treatment (nm) | Fixed Charge Density ($cm^{-2}$) | Carrier Lifetime (μs) |
|---|---|---|---|---|
| a2-2 | 30/70 | 71 | $-1.0\times10^{10}$ | 600 |

(continued)

| | Vanadium Oxide/Aluminum Oxide after Thermal treatment (Mass Ratio) | Film Thickness after Thermal treatment (nm) | Fixed Charge Density ($cm^{-2}$) | Carrier Lifetime ($\mu s$) |
|---|---|---|---|---|
| a2-3 | 40/60 | 69 | $-1.7\times10^{10}$ | 540 |
| a2-4 | 50/50 | 73 | $-6.3\times10^{10}$ | 530 |
| a2-5 | 60/40 | 77 | $-4.9\times10^{11}$ | 420 |
| a2-6 | 80/20 | 75 | $-7.2\times10^{11}$ | 220 |
| a2-7 | 90/10 | 75 | $-8.3\times10^{11}$ | 130 |

[Reference Example 2-3]

As a compound from which vanadium oxide ($V_2O_5$) is obtained upon thermal treatment (sintering), 1.02 g (0.010 mol) of a commercially available vanadium (V) oxytriethoxide (structural formula: $VO(OC_2H_5)_3$, molecular weight: 202.13) and, as a compound from which aluminum oxide ($Al_2O_3$) is obtained upon thermal treatment (sintering), 2.04 g (0.010 mol) of a commercially available aluminum triisopropoxide (structural formula: $Al(OCH(CH_3)_2)_3$, molecular weight: 204.25) were dissolved in 60 g of cyclohexane, thereby preparing passivation material (b2-1) at a concentration of 5% by mass.

Passivation material (b2-1) was applied by spin coating on one side of a p-type silicon substrate (from 8 Ω·cm to 12 Ω·cm) having a size of 8 inches and 725 μm in thickness, from which a spontaneously oxidized film had been previously removed with hydrofluoric acid at 0.49% by mass concentration. The silicon substrate was pre-baked on a hot plate at 120°C for 3 minutes. Subsequently, the silicon substrate was subjected to thermal treatment under a nitrogen atmosphere at 650°C for an hour, thereby obtaining a passivation film including aluminum oxide and vanadium oxide. The film thickness as measured with an ellipsometer was 60 nm. As a result of elemental analysis, the ratio V/A1/C was 64/33/3 (% by mass). As a result of FT-IR measurement of a passivation film, a slight peak derived from an alkyl group was observed at approximately 1,200 $cm^{-1}$.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +0.10V. From this amount of shift, it was found that the passivation film obtained from passivation material (b2-1) exhibited a negative fixed charge at a fixed charge density (Nf) of $-6.2 \times 10^{11}$ $cm^{-2}$.

In the same manner as the above, passivation material (b2-1) was applied on both sides of an 8-inch p-type silicon substrate, and the silicon substrate was pre-baked and subjected to thermal treatment (sintering) under a nitrogen atmosphere at 600°C for an hour, thereby preparing a sample of a silicon substrate having both sides covered with a passivation film. The carrier lifetime of the sample was measured with a lifetime measurement device (Kobelco Research Institute Inc., RTA-540). As a result, the carrier lifetime was 400 μs. For comparison, the carrier lifetime of the same 8-inch p-type silicon substrate, which was passivated by an iodine passivation method, was measured. The result was 1,100 μs.

In view of the above, it was found that a passivation film obtained by performing thermal treatment (sintering) of passivation material (b2-1) exhibited a certain degree of passivation performance and a negative fixed charge.

[Reference Example 2-4]

Passivation material (b2-2) was prepared by dissolving 1.52 g (0.0075 mol) of a commercially available vanadium (V) oxytriethoxide (structural formula: $VO(OC_2H_5)_3$, molecular weight: 202.13), 1.02 g (0.005 mol) of a commercially available aluminum triisopropoxide (structural formula: $Al(OCH(CH_3)_2)_3$, molecular weight: 204.25) and 10 g of a novolac resin were dissolved in 10 g of diethyleneglycol monobutyl ether acetate and 10 g of cyclohexane.

Passivation material (b2-2) was applied by spin coating on one side of a p-type silicon substrate (from 8 Ω·cm to 12 Ω·cm) having a size of 8 inches and 725 μm in thickness, from which a spontaneously oxidized film had been previously removed with hydrofluoric acid at 0.49% by mass concentration. The silicon substrate was pre-baked on a hot plate at 120°C for 3 minutes. Subsequently, the silicon substrate was subjected to thermal treatment under a nitrogen atmosphere at 650°C for an hour, thereby obtaining a passivation film including aluminum oxide and vanadium oxide. The film thickness as measured with an ellipsometer was 22 nm. As a result of elemental analysis, the ratio V/Al/C was 71/22/7 (% by mass). As a result of FT-IR measurement of a passivation film, a slight peak derived from an alkyl group

was observed at approximately 1,200 $cm^{-1}$.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to +0.03 V. From this amount of shift, it was found that the passivation film obtained from passivation material (b2-2) exhibited a negative fixed charge at a fixed charge density (Nf) of -2.0 x $10^{11}$ $cm^{-2}$.

In the same manner as the above, passivation material (b2-2) was applied on both sides of an 8-inch p-type silicon substrate. The silicon substrate was pre-baked and subjected to thermal treatment (sintering) under a nitrogen atmosphere at 600°C for an hour, thereby preparing a sample of a silicon substrate having both sides covered with a passivation film. The carrier lifetime of the sample was measured with a lifetime measurement device (Kobelco Research Institute Inc., RTA-540). As a result, the carrier lifetime was 170 μs. For comparison, the carrier lifetime of the same 8-inch p-type silicon substrate, which was passivated by an iodine passivation method, was measured. The result was 1,100 μs.

In view of the above, it was found that a passivation film obtained by curing passivation material (b2-2) exhibited a certain degree of passivation performance and a negative fixed charge.

<Tantalum oxide used as vanadium-group element oxide>

[Reference Example 2-5]

A commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering) and a commercially available organic metal film application material [Kojundo Chemical Lab. Co., Ltd., Ta-10-P, concentration: 10% by mass] from which tantalum oxide ($Ta_2O_5$) was obtained upon thermal treatment were mixed at different ratios, and passivation materials (c2-1) to (c2-6) as shown in Table 8 were prepared.

Each of passivation materials (c2-1) to (c2-6) was applied by spin coating on one side of a p-type silicon substrate (from 8 Ω·cm to 12 Ω·cm) having a size of 8 sizes and 725 μm in thickness, from which a spontaneously oxidized film had been previously removed with hydrofluoric acid at 0.49% by mass concentration. The silicon substrate was pre-baked on a hot plate at 120°C for 3 minutes. Subsequently, thermal treatment (sintering) was performed under a nitrogen atmosphere at 700°C for 30 minutes, thereby obtaining a passivation film including aluminum oxide and tantalum oxide. This passivation film was used to measure the voltage dependency of electrostatic capacitance, and the fixed charge density was calculated therefrom.

Subsequently, each of passivation materials (c2-1) to (c2-6) was applied on both sides of an 8-inch p-type silicon substrate, and the silicon substrate was subjected to pre-baking and thermal treatment (sintering) under a nitrogen atmosphere at 650°C for an hour, and a sample of a silicon substrate having both sides covered with a passivation film was prepared. The carrier lifetime of the sample was measured with a lifetime measurement device (Kobelco Research Institute Inc., RTA-540).

The results are shown in Table 8. Further, the carrier lifetime was measured again 14 days after the preparation of the sample. As a result, a decrease in carrier lifetime was less than - 10% in all of the passivation films obtained from passivation materials (c2-1) to (c2-6) as shown in Table 8, indicating that a decrease in carrier lifetime is small.

Since all of passivation materials (c2-1) to (c2-6) exhibited a negative fixed charge and a certain level of carrier lifetime after the thermal treatment (sintering), although the results were different depending on the ratio of tantalum oxide / aluminum oxide (mass ratio) after the thermal treatment (sintering), suggesting that they can function as a passivation film.

Table 8

| | Tantalum Oxide/Aluminum Oxide after Thermal treatment (Mass Ratio) | Film Thickness after Thermal treatment (nm) | Fixed Charge Density ($cm^{-2}$) | Carrier Lifetime (μs) |
|---|---|---|---|---|
| c2-1 | 30/70 | 44 | $-1.1\times10^{10}$ | 710 |
| c2-2 | 40/60 | 48 | $-1.3\times10^{10}$ | 580 |
| c2-3 | 50/50 | 43 | $-3.2\times10^{10}$ | 600 |
| c2-4 | 60/40 | 51 | $-5.8\times10^{10}$ | 520 |
| c2-5 | 80/20 | 52 | $-5.5\times10^{10}$ | 300 |

(continued)

| | Tantalum Oxide/Aluminum Oxide after Thermal treatment (Mass Ratio) | Film Thickness after Thermal treatment (nm) | Fixed Charge Density ($cm^{-2}$) | Carrier Lifetime (μs) |
|---|---|---|---|---|
| c2-6 | 90/10 | 52 | $-7.3\times10^{10}$ | 150 |

[Reference Example 2-6]

As a compound from which tantalum oxide ($Ta_2O_5$) is obtained upon thermal treatment (sintering), 1.18 g (0.0025 mol) of a commercially available tantalum (V) methoxide (structural formula: $Ta(OCH_3)_5$, molecular weight: 336.12) and as a compound from which aluminum oxide ($Al_2O_3$) is obtained upon thermal treatment (sintering), 2.04 g (0.010 mol) of a commercially available aluminum triisopropoxide (structural formula: $Al(OCH(CH_3)_2)_3$, molecular weight: 204.25) were dissolved in 60 g of cyclohexane, and passivation material (d2-1) at a concentration of 5% by mass was prepared.

Passivation material (d2-1) was applied by spin coating on one side of a p-type silicon substrate (from 8 Ω·cm to 12 Ω·cm) having a size of 8 inches and 725 μm in thickness, from which a spontaneously oxidized film had been previously removed with hydrofluoric acid at 0.49% by mass concentration. The silicon substrate was pre-baked on a hot plate at 120°C for 3 minutes. Subsequently, the silicon substrate was subjected to thermal treatment under a nitrogen atmosphere at 700°C for an hour, thereby obtaining a passivation film including aluminum oxide and tantalum oxide. The film thickness as measured with an ellipsometer was 40 nm. As a result of elemental analysis, the ratio Ta/Al/C was 75/22/3 (wt%). As a result of FT-IR measurement of the passivation film, a slight peak derived from an alkyl group was observed at approximately 1,200 $cm^{-1}$.

Subsequently, a capacitor having a MIS (metal-insulator-semiconductor) structure was prepared by forming plural aluminum electrodes having a diameter of 1 mm on the passivation film by vapor deposition through a metal mask. The voltage dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to -0.30 V. From this amount of shift, it was found that the passivation film obtained from passivation material (d2-1) exhibited a negative fixed charge at a fixed charge density (Nf) of $-6.2 \times 10^{10}$ $cm^{-2}$.

In the same manner as the above, passivation material (d2-1) was applied on both sides of an 8-inch p-type silicon substrate, and the silicon substrate was pre-baked and subjected to thermal treatment (sintering) under a nitrogen atmosphere at 600°C for an hour, thereby preparing a sample of a silicon substrate having both sides covered with a passivation film. The carrier lifetime of the sample was measured with a lifetime measurement device (Kobelco Research Institute Inc., RTA-540). As a result, the carrier lifetime was 610 μs. For comparison, the carrier lifetime of the same 8-inch p-type silicon substrate, which was passivated by an iodine passivation method, was measured. The result was 1,100 μs.

In view of the above, it was found that the passivation film obtained by performing thermal treatment to passivation material (d2-1) exhibited a certain level of passivation performance and a negative fixed charge.

[Reference Example 2-7]

As a compound from which tantalum oxide ($Ta_2O_5$) is obtained upon thermal treatment (sintering), 1.18 g (0.005 mol) of a commercially available tantalum (V) methoxide (structural formula: $Ta(OCH_3)_5$, molecular weight: 336.12), as a compound from which aluminum oxide ($Al_2O_3$) is obtained upon thermal treatment (sintering), 1.02 g (0.005 mol) of a commercially available aluminum triisopropoxide (structural formula: $Al(OCH(CH_3)_2)_3$, molecular weight: 204.25), and 10 g of a novolac resin were dissolved in a mixture of 10 g of diethyleneglycol monobutyl ether acetate and 10 g of cyclohexane, thereby preparing passivation material (d2-2).

Passivation material (d2-2) was applied by spin coating on one side of a p-type silicon substrate (from 8 Ω·cm to 12 Ω·cm) having a size of 8 inches and 725 μm in thickness, from which a spontaneously oxidized film had been previously removed with hydrofluoric acid at 0.49% by mass concentration. The silicon substrate was pre-baked on a hot plate at 120°C for 3 minutes. Subsequently, thermal treatment was performed under a nitrogen atmosphere at 650°C for an hour, thereby obtaining a passivation film including aluminum oxide and tantalum oxide. The film thickness as measured with an ellipsometer was 18 nm. As a result of elemental analysis, it was found that the ratio Ta/Al/C was 72/20/8 (wt%). As a result of FT-IR measurement of the passivation film, a slight peak derived from an alkyl group was observed at approximately 1,200 $cm^{-1}$.

Subsequently, a capacitor having a MIS (metal-insulator-semiconductor) structure was prepared by forming plural aluminum electrodes having a diameter of 1 mm on the passivation film though a metal mask. The voltage

dependency of electrostatic capacitance (C-V property) of the capacitor was measured with a commercially available prober and a commercially available LCR meter (Hewlett-Packard Company, 4275A). As a result, it was found that the flat band voltage (Vfb) shifted from the ideal value of -0.81 V to -0.43 V. From this amount of shift, it was found that the passivation film obtained from passivation material (d-2) exhibited a negative fixed charge at a fixed charge density (Nf) of $-5.5 \times 10^{10}$ $cm^{-2}$.

In the same manner as the above, passivation material (d2-2) was applied on both sides of an 8-inch p-type silicon substrate. The silicon substrate was pre-baked and subjected to thermal treatment (sintering) under a nitrogen atmosphere at 600°C for an hour, thereby preparing a sample of a silicon substrate having both sides covered with a passivation film. The carrier lifetime of the sample was measured with a lifetime measurement device (Kobelco Research Institute Inc., RTA-540). As a result, the carrier lifetime was 250 μs. For comparison, the carrier lifetime of the same 8-inch p-type silicon substrate, which was passivated by an iodine passivation method, was measured. The result was 1,100 μs.

In view of the above, it was found that the passivation film obtained by performing thermal treatment (sintering) of passivation material (d2-2) exhibited a certain level of passivation performance and a negative fixed charge.

<Combination use of two or more vanadium-group element oxides>

[Reference Example 2-8]

A commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering), a commercially available organic metal film application material [Kojundo Chemical Lab. Co., Ltd., V-02, concentration: 2% by mass] from which vanadium oxide ($V_2O_5$) is obtained upon thermal treatment (sintering) and a commercially available organic metal film application material [Kojundo Chemical Lab. Co., Ltd., Ta-10-P, concentration: 10% by mass] from which tantalum oxide ($Ta_2O_5$) is obtained upon thermal treatment (sintering) were mixed to produce passivation material (e2-1) as an application material (see Table 9).

A commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering), a commercially available organic metal film application material [Kojundo Chemical Lab. Co., Ltd., V-02, concentration: 2% by mass] from which vanadium oxide ($V_2O_5$) is obtained upon thermal treatment (sintering) and a commercially available organic metal film application material [Kojundo Chemical Lab. Co., Ltd., Nb-05, concentration: 5% by mass] from which niobium oxide ($Nb_2O_5$) is obtained upon thermal treatment (sintering) were mixed, thereby preparing passivation material (e2-2) as an application material (see Table 9).

A commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering), a commercially available organic metal film application material [Kojundo Chemical Lab. Co., Ltd., Ta-10-P, concentration: 10% by mass] from which tantalum oxide ($Ta_2O_5$) is obtained upon thermal treatment (sintering) and a commercially available organic metal film application material [Kojundo Chemical Lab. Co., Ltd., Nb-05, concentration: 5% by mass] from which niobium oxide ($Nb_2O_5$) is obtained upon thermal treatment (sintering) were mixed, thereby preparing a passivation material (e2-3) as an application material (see Table 9).

A commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering), a commercially available organic metal film application material [Kojundo Chemical Lab. Co., Ltd., V-02, concentration: 2% by mass] from which vanadium oxide ($V_2O_5$) is obtained upon thermal treatment (sintering), a commercially available organic metal film application material [Kojundo Chemical Lab. Co., Ltd., Ta-10-P, concentration: 10% by mass] from which tantalum oxide ($Ta_2O_5$) is obtained upon thermal treatment (sintering) and a commercially available organic metal film application material [Kojundo Chemical Lab. Co., Ltd., Nb-05, concentration: 5% by mass] from which niobium oxide ($Nb_2O_5$) is obtained upon thermal treatment (sintering) were mixed, thereby preparing passivation material (e2-4) as an application material (see Table 9).

In the same manner as Reference Example 2-1, each of passivation materials (e2-1) to (e2-4) was applied by spin coating on one side of a p-type silicon substrate (from 8 Ω·cm to 12 Ω·cm) having a size of 8 inches and 725 μm in thickness from which a spontaneously oxidized film had been removed with hydrofluoric acid at a concentration of 0.49% by mass, and the silicon substrate was pre-baked on a hot plate at 120°C for 3 minutes. Subsequently, the silicon substrate was subjected to thermal treatment (sintering) under a nitrogen atmosphere at 650°C for an hour, thereby obtaining a passivation film including aluminum oxide and two or more kinds of vanadium-group element oxides.

With the passivation film obtained above, the voltage dependency of electrostatic capacitance was measured and the fixed charge density was calculated therefrom.

Subsequently, each of passivation materials (e2-1) to (e2-4) was applied on both sides of a 8-inch p-type silicon

substrate, and the silicon substrate was pre-baked and subjected to thermal treatment (sintering) under a nitrogen atmosphere at 650°C for an hour, thereby preparing a sample of a silicon substrate having both sides covered with a passivation film. The carrier lifetime of the sample was measured with a lifetime measurement device (Kobelco Research Institute Inc., RTA-540).

The results are shown in Table 9.

All of the passivation films obtained from passivation materials (e2-1) to (e2-4) exhibited a negative fixed charge after performing thermal treatment (sintering) and a certain degree of carrier lifetime, although the results were different depending on the ratio (mass ratio) of the two or more kinds of vanadium-group element oxides to aluminum oxide after the thermal treatment (burning), suggesting that they can function as a passivation film.

Table 9

| | Mass Ratio of Metal Oxide after Thermal treatment | | | | Film Thickness after Thermal treatment (nm) | Fixed Charge Density ($cm^{-2}$) | Carrier Lifetime ($\mu s$) |
|---|---|---|---|---|---|---|---|
| | $Al_2O_3$ | $V_2O_5$ | $Ta_2O_5$ | $Nb_2O_5$ | | | |
| e2-1 | 30 | 40 | 30 | 0 | 55 | $-3.1\times10^{11}$ | 480 |
| e2-2 | 30 | 35 | 0 | 35 | 50 | $-8.2\times10^{11}$ | 440 |
| e2-3 | 30 | 0 | 30 | 40 | 41 | $-4.3\times10^{11}$ | 510 |
| e2-4 | 30 | 20 | 20 | 20 | 45 | $-6.5\times10^{11}$ | 450 |

[Reference Example 2-9]

In the same manner as Reference Example 2-1, a commercially available organic metal film application material [Kojundo Chemical Lab. Co., Ltd., SYM-AL04, concentration: 2.3% by mass] from which aluminum oxide ($Al_2O_3$) is obtained upon thermal treatment (sintering), a commercially available organic metal film application material [Kojundo Chemical Lab. Co., Ltd., V-02, concentration: 2% by mass] from which vanadium oxide ($V_2O_5$) is obtained upon thermal treatment (sintering) and a commercially available organic metal film application material [Kojundo Chemical Lab. Co., Ltd., Ta-10-P, concentration; 10% by mass] from which tantalum oxide ($Ta_2O_5$) is obtained upon thermal treatment (sintering) were mixed, thereby preparing passivation materials (f2-1) to (f2-8) as an application material (see Table 10).

Further, passivation material (f2-9) in which aluminum oxide was used alone was prepared (see Table 10).

In the same manner as Reference Example 2-1, each of passivation materials (f2-1) to (f2-9) was applied on one side of a p-type silicon substrate, and the silicon substrate was subjected to thermal treatment (sintering) to prepare a passivation film. With the passivation film, the voltage dependency of electrostatic capacitance was measured and the fixed charge density was calculated therefrom.

Further, in the same manner as Reference Example 2-1, each of passivation materials (f2-1) to (f2-9) was applied on both sides of a p-type silicon substrate, and the silicon substrate was subjected to thermal treatment (sintering), thereby preparing a sample. The carrier lifetime of the sample was measured, and the results are shown in Table 10.

As shown in Table 10, in the cases in which aluminum oxide / vanadium oxide or tantalum oxide of the passivation material is 90/10 and 80/20, there was a significant variability among fixed charge density values, and a negative fixed charge density could not be obtained in a stable manner. However, it was determined that a negative fixed charge density could be attained by using aluminum oxide and niobium oxide. When the measurement was performed by a CV method in the cases in which aluminum oxide / vanadium oxide or tantalum oxide of the passivation material was 90/10 and 80/20 by a CV method, the passivation film exhibited a positive fixed charge in some cases and did not exhibit a negative fixed charge in a stable manner. A passivation film that exhibits a positive fixed charge can be used as a passivation film for an n-type silicon substrate. On the other hand, a negative fixed charge density could not be obtained with passivation material (f2-9) including 100% by mass of aluminum oxide.

Table 10

| | Mass Ratio of Metal Oxide after Thermal treatment | | | Film Thickness after Thermal treatment (nm) | Fixed Charge Density ($cm^{-2}$) | Carrier Lifetime ($\mu s$) |
|---|---|---|---|---|---|---|
| | $Al_2O_3$ | $V_2O_5$ | $Ta_2O_5$ | | | |
| f2-1 | 90 | 10 | 0 | 55 | $2.1\times10^{11}$ | 600 |
| f2-2 | 80 | 20 | 0 | 50 | $1.9\times10^{11}$ | 590 |

(continued)

| | Mass Ratio of Metal Oxide after Thermal treatment | | | Film Thickness after Thermal treatment (nm) | Fixed Charge Density ($cm^{-2}$) | Carrier Lifetime ($\mu s$) |
|---|---|---|---|---|---|---|
| | $Al_2O_3$ | $V_2O_5$ | $Ta_2O_5$ | | | |
| f2-3 | 90 | 0 | 10 | 41 | $2.3\times10^{11}$ | 610 |
| f2-4 | 80 | 0 | 20 | 45 | $2.1\times10^{11}$ | 570 |
| f2-5 | 90 | 10 | 0 | 48 | $-7.8\times10^{9}$ | 580 |
| f2-6 | 80 | 20 | 0 | 52 | $-8.3\times10^{9}$ | 480 |
| f2-7 | 90 | 0 | 10 | 46 | $-1.3\times10^{10}$ | 560 |
| f2-8 | 80 | 0 | 20 | 56 | $-9.6\times10^{9}$ | 490 |
| f2-9 | 100 | 0 | 0 | 34 | $2.2\times10^{11}$ | 600 |

[Reference Example 2-10]

A photovoltaic cell element having a structure shown in Figure 14 was prepared by using as silicon substrate 101, a monocrystalline silicon substrate doped with boron. The surface of silicon substrate 101 was subjected to texture processing, and an application-type phosphorus diffusion material was applied only onto a light receiving surface, and diffusion layer 102 (a phosphorus diffusion layer) was formed by performing thermal treatment. Thereafter, the application-type phosphorus diffusion material was removed with dilute hydrofluoric acid.

Subsequently, at the light receiving surface side, a SiN film was formed by plasma CVD as light receiving surface anti-reflection film 103. Then, passivation material (a2-1) as prepared in Reference Example 2-1 was applied by an ink jet method to a region excluding a contact region (opening OA) at the back surface side of silicon substrate 101. Thereafter, thermal treatment was performed to form passivation film 107 having opening OA. A sample in which passivation film 107 was formed from passivation material (c2-1) as prepared in Reference Example 2-5 was also prepared.

Subsequently, a paste mainly composed of silver was applied by screen printing in the form of predetermined finger electrodes and bus bar electrodes, on light receiving surface anti-reflection film 103 (SiN film) formed on the light receiving surface of silicon substrate 101. At the back surface side, a paste mainly composed of aluminum was applied by screen printing on an entire surface. Thereafter, thermal treatment (fire through) was performed at 850°C to form an electrode (first electrode 105 and second electrode 106), and BSF layer 104 was formed by allowing aluminum to diffuse in opening OA, thereby forming a photovoltaic cell element having a structure shown in Figure 8.

Although the method of forming a silver electrode at the light receiving surface as described herein includes a fire-through process without forming an opening to the SiN film, it is also possible to form a silver electrode by a method in which opening OA is formed to the SiN film by etching or the like, and subsequently the silver electrode is formed.

For comparison, a photovoltaic cell element having a structure shown in Figure 5 was prepared by a method as described above, except that passivation film 107 was not formed and an aluminum paste was applied on an entire region of the back surface, and $p^+$ layer 114 corresponding to BSF layer 104 and electrode 116 corresponding to the second electrode were formed on the entire region of the back surface. With these photovoltaic cell elements, characterization (short-circuit current, open-voltage, fill factor and conversion efficiency) was performed. The characterization was performed according to JIS-C-8913 (2005) and JIS-C-8914 (2005). The results are shown in Table 11.

From the results shown in Table 11, it was found that the photovoltaic cell element having passivation film 107 exhibited an increase in short-circuit current and open voltage, as compared with a photovoltaic cell element not having passivation film 107. In addition, it was found that the photovoltaic cell element having passivation film 107 exhibited an improved conversion efficiency (incident photon-to-current conversion efficiency) by up to 0.6%.

Table 11

| Passivation Film | Short-Circuit Current ($mA/cm^2$) | Open Voltage (V) | Fill Factor | Conversion Efficiency (%) |
|---|---|---|---|---|
| a2-1 | 33.3 | 0.623 | 0.798 | 16.6 |
| c2-1 | 33.2 | 0.620 | 0.799 | 16.4 |
| None | 32.8 | 0.610 | 0.800 | 16.0 |

## Claims

1. A composition for forming a passivation layer, comprising an alkoxide represented by the following Formula (I); at least one compound selected from the group consisting of a titanium compound, a zirconium compound and a silicon alkoxide; a solvent; and a resin:

$$M(OR^1)_m \qquad (I)$$

wherein, in Formula (I), M comprises at least one metal element selected from the group consisting of Nb, Ta, V, Y and Hf, each $R^1$ independently represents an alkyl group having from 1 to 8 carbon atoms or an aryl group having from 6 to 14 carbon atoms, and m represents an integer from 1 to 5; **characterised in that** the composition further comprises a compound represented by the following Formula (II):

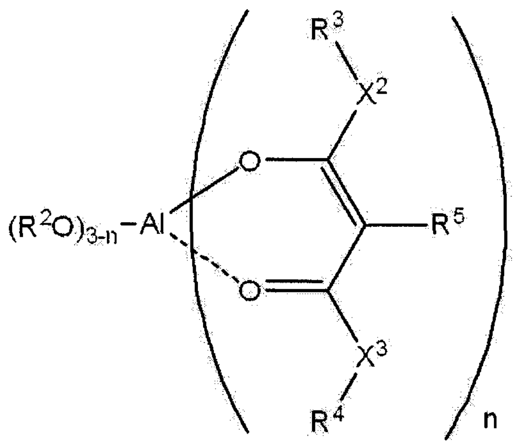

(II)

wherein, in Formula (II), each $R^2$ independently represents an alkyl group having from 1 to 8 carbon atoms, n represents an integer from 0 to 3, each of $X^2$ and $X^3$ independently represents an oxygen atom or a methylene group, and each of $R^3$, $R^4$ and $R^5$ independently represents a hydrogen atom or an alkyl group having from 1 to 8 carbon atoms.

2. The composition for forming a passivation layer according to claim 1, wherein at least one of the alkoxides represented by Formula (I) is an alkoxide in which M comprises Nb.

3. The composition for forming a passivation layer according to claim 1, wherein at least one of the alkoxides represented by Formula (I) is an alkoxide in which M comprises Ta, V, Y or Hf.

4. The composition for forming a passivation layer according to any one of claims 1 to 3, wherein the at least one compound selected from the group consisting of a titanium compound, a zirconium compound and a silicon alkoxide comprises at least the titanium compound, and the titanium compound is at least one selected from the group consisting of titanium methoxide, titanium ethoxide, titanium isopropoxide, titanium n-propoxide, titanium n-butoxide, titanium t-butoxide, titanium isobutoxide, titanium (diisopropoxide) bis(acetylacetonate) and titanium (tetrakis(2-ethyl-1-hexanolate)).

5. The composition for forming a passivation layer according to any one of claims 1 to 4, wherein the at least one compound selected from the group consisting of a titanium compound, a zirconium compound and a silicon alkoxide comprises at least the zirconium compound, and the zirconium compound is at least one selected from the group consisting of zirconium ethoxide, zirconium isopropoxide, zirconium n-propoxide, zirconium n-butoxide, zirconium t-butoxide, zirconium acetylacetone, zirconium trifluoroacetylacetonate and zirconium hexafluoroacetylacetonate.

6. The composition for forming a passivation layer according to any one of claims 1 to 5, wherein the at least one compound selected from the group consisting of a titanium compound, a zirconium compound and a silicon alkoxide comprises at least the silicon alkoxide, and the silicon alkoxide is a silicon alkoxide represented by the following Formula (III):

$$(R^6O)_{(4-m)}SiR^7_m \qquad (III)$$

wherein, in Formula (III), each of $R^6$ and $R^7$ independently represents an alkyl group having from 1 to 8 carbon atoms, and m represents an integer from 0 to 3.

**7.** The composition for forming a passivation layer according to any one of claims 1 to 6, wherein a content of the compound represented by Formula (I), the at least one compound selected from the group consisting of a titanium compound, a zirconium compound and a silicon alkoxide and the compound represented by Formula (II) is from 0.1 % by mass to 80% by mass of a total mass of the composition for forming a passivation layer.

**8.** The composition for forming a passivation layer according to any one of claims 1 to 7, wherein a total content of the solvent and the resin is from 5% by mass to 98% by mass of a total mass of the composition for forming a passivation layer.

**9.** Use of the composition according to any one of claims 1 to 8 for forming a passivation layer on an entire or partial surface of a semiconductor substrate.

**10.** A semiconductor substrate having a passivation layer, comprising:

a semiconductor substrate (1); and
a passivation layer (6) that is a thermally-treated product of the composition for forming a passivation layer according to any one of claims 1 to 8 and that is provided at an entire or partial surface of the semiconductor substrate.

**11.** A method of producing a semiconductor substrate having a passivation layer, the method comprising:

a process of forming a composition layer by applying the composition for forming a passivation layer according to any one of claims 1 to 8 onto an entire or partial surface of a semiconductor substrate; and
a process of forming a passivation layer by subjecting the composition layer to a thermal treatment.

**12.** A photovoltaic cell element, comprising:

a semiconductor substrate (1) having a pn junction of a p-type layer and an n-type layer;
a passivation layer (6) that is a thermally-treated product of the composition for forming a passivation layer according to any one of claims 1 to 8 and that is provided at an entire or partial surface of the semiconductor substrate; and
an electrode (5) provided at at least one of the p-type layer or the n-type layer.

**13.** A method of producing a photovoltaic cell element, the method comprising:

a process of forming a composition layer by applying the composition for forming a passivation layer according to any one of claims 1 to 8 onto an entire or partial surface of a semiconductor substrate having a pn junction of a p-type layer and an n-type layer;
a process of forming a passivation layer by subjecting the composition layer to a thermal treatment; and
a process of forming an electrode at at least one of the p-type layer or the n-type layer.

## Patentansprüche

**1.** Zusammensetzung zur Bildung einer Passivierungsschicht, umfassend ein Alkoxid der nachstehenden Formel (I); zumindest eine Verbindung, ausgewählt aus der Gruppe bestehend aus einer Titanverbindung, einer Zirkoniumverbindung und einem Siliciumalkoxid; ein Lösungsmittel und ein Harz:

$$\mathbf{M(OR^1)_m} \qquad \mathbf{(I)}$$

wobei in Formel (I) M zumindest ein Metallelement, ausgewählt aus der Gruppe bestehend aus Nb, Ta, V, Y und Hf, umfasst, jedes $R^1$ unabhängig eine Alkylgruppe mit 1 bis 8 Kohlenstoffatomen oder eine Arylgruppe mit 6 bis 14 Kohlenstoffatomen darstellt und m eine ganze Zahl von 1 bis 5 darstellt; **dadurch gekennzeichnet, dass** die

Zusammensetzung ferner eine Verbindung der nachstehenden Formel (II) umfasst

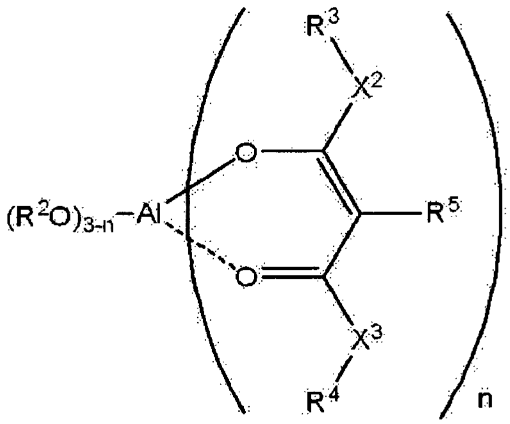

(II)

wobei in Formel (II) jedes $R^2$ unabhängig eine Alkylgruppe mit 1 bis 8 Kohlenstoffatomen darstellt, n eine ganze Zahl von 0 bis 3 darstellt, jedes $X^2$ und $X^3$ unabhängig ein Sauerstoffatom oder eine Methylengruppe darstellt und jedes $R^3$, $R^9$ und $R^5$ unabhängig ein Wasserstoffatom oder eine Alkylgruppe mit 1 bis 8 Kohlenstoffatomen darstellt.

2. Zusammensetzung zur Bildung einer Passivierungsschicht gemäss Anspruch 1, wobei zumindest eines der Alkoxide der Formel (I) ein Alkoxid ist, in dem M Nb umfasst.

3. Zusammensetzung zur Bildung einer Passivierungsschicht gemäss Anspruch 1, wobei zumindest eines der Alkoxide der Formel (I) ein Alkoxid ist, in dem M Ta, V, Y oder Hf umfasst.

4. Zusammensetzung zur Bildung einer Passivierungsschicht gemäss irgendeinem der Ansprüche 1 bis 3, wobei die zumindest eine Verbindung, ausgewählt aus der Gruppe bestehend aus einer Titanverbindung, einer Zirkoniumverbindung und einem Siliciumalkoxid, zumindest die Titanverbindung umfasst und die Titanverbindung zumindest eine, ausgewählt aus der Gruppe bestehend aus Titanmethoxid, Titanethoxid, Titanisopropoxid, Titan-n-propoxid, Titan-n-butoxid, Titan-t-butoxid, Titanisobutoxid, Titan(diisopropoxid)bis(acetylacetonat) und Titan(tetrakis(2-ethyl-1-hexanolat)), ist.

5. Zusammensetzung zur Bildung einer Passivierungsschicht gemäss irgendeinem der Ansprüche 1 bis 4, wobei die zumindest eine Verbindung, ausgewählt aus der Gruppe bestehend aus einer Titanverbindung, einer Zirkoniumverbindung und einem Siliciumalkoxid, zumindest die Zirkoniumverbindung umfasst und die Zirkoniumverbindung zumindest eine, ausgewählt aus der Gruppe bestehend aus Zirkoniumethoxid, Zirkoniumisopropoxid, Zirkonium-n-propoxid, Zirkonium-n-butoxid, Zirkonium-t-butoxid, Zirkoniumacetylaceton, Zirkoniumtrifluoracetylacetonat und Zirkoniumhexafluoracetylacetonat, ist.

6. Zusammensetzung zur Bildung einer Passivierungsschicht gemäss irgendeinem der Ansprüche 1 bis 5, wobei die zumindest eine Verbindung, ausgewählt aus der Gruppe bestehend aus einer Titanverbindung, einer Zirkoniumverbindung und einem Siliciumalkoxid, zumindest das Siliciumalkoxid umfasst und das Siliciumalkoxid ein Siliciumalkoxid der nachstehenden Formel (III) ist:

$$(R^6O)_{(4-m)}SiR^7_m \qquad \text{(III)}$$

wobei in Formel (III) jedes $R^6$ und $R^7$ unabhängig eine Alkylgruppe mit 1 bis 8 Kohlenstoffatomen darstellt und m eine ganze Zahl von 0 bis 3 darstellt.

7. Zusammensetzung zur Bildung einer Passivierungsschicht gemäss irgendeinem der Ansprüche 1 bis 6, wobei der Gehalt der durch die Formel (I) dargestellten Verbindung, der zumindest einen Verbindung, ausgewählt aus der Gruppe bestehend aus einer Titanverbindung, einer Zirkoniumverbindung und einem Siliciumalkoxid, und der durch die Formel (II) dargestellten Verbindung 0,1 bis 80 Masse-% der Gesamtmasse der Zusammensetzung zur Bildung einer Passivierungsschicht beträgt.

8. Zusammensetzung zur Bildung einer Passivierungsschicht gemäss irgendeinem der Ansprüche 1 bis 7, wobei der

Gesamtgehalt des Lösungsmittels und des Harzes 5 bis 98 Masse-% der Gesamtmasse der Zusammensetzung zur Bildung einer Passivierungsschicht beträgt.

**9.** Verwendung einer Zusammensetzung gemäss irgendeinem der Ansprüche 1 bis 8 zur Bildung einer Passivierungsschicht auf der gesamten oder einem Teil der Oberfläche eines Halbleitersubstrats.

**10.** Halbleitersubstrat, das eine Passivierungsschicht aufweist, umfassend:

ein Halbleitersubstrat (1); und
eine Passivierungsschicht (6), die ein thermisch behandeltes Produkt der Zusammensetzung zur Bildung einer Passivierungsschicht gemäss irgendeinem der Ansprüche 1 bis 8 ist und die auf der gesamten oder einem Teil der Oberfläche des Halbleitersubstrats vorgesehen ist.

**11.** Verfahren zur Herstellung eines Halbleitersubstrats, das eine Passivierungsschicht aufweist, wobei das Verfahren umfasst:

ein Verfahren zur Bildung einer Zusammensetzungsschicht durch Aufbringen einer Zusammensetzung zur Bildung einer Passivierungsschicht gemäss irgendeinem der Ansprüche 1 bis 8 auf die gesamte oder einen Teil der Oberfläche eines Halbleitersubstrats; und
ein Verfahren zur Bildung einer Passivierungsschicht, indem die Zusammensetzungsschicht einer thermischen Behandlung unterzogen wird.

**12.** Photovoltaik-Zellenelement, umfassend:

ein Halbleitersubstrat (1) mit einem pn-Übergang einer Schicht vom p-Typ und einer Schicht vom n-Typ;
eine Passivierungsschicht (6), die ein thermisch behandeltes Produkt einer Zusammensetzung zur Bildung einer Passivierungsschicht gemäss irgendeinem der Ansprüche 1 bis 8 ist und die auf einem Teil oder der gesamten Oberfläche des Halbleitersubstrats vorgesehen ist; und
eine Elektrode (5), die auf zumindest einer der Schicht vom p-Typ oder der Schicht vom n-Typ vorgesehen ist.

**13.** Verfahren zur Herstellung eines Photovoltaik-Zellenelements, wobei das Verfahren umfasst:

ein Verfahren zur Bildung einer Zusammensetzungsschicht durch Aufbringen einer Zusammensetzung zur Bildung einer Passivierungsschicht gemäss irgendeinem der Ansprüche 1 bis 8 auf die gesamte oder einen Teil der Oberfläche eines Halbleitersubstrats mit einem pn-Übergang einer Schicht vom p-Typ und einer Schicht vom n-Typ;
ein Verfahren zur Bildung einer Passivierungsschicht, indem die Zusammensetzungsschicht einer thermischen Behandlung unterzogen wird; und
ein Verfahren zur Bildung einer Elektrode auf zumindest einer der Schicht vom p-Typ oder der Schicht von n-Typ.

## Revendications

**1.** Composition permettant de former une couche de passivation, comprenant un alcoxyde représenté par la Formule (I) suivante; au moins un composé choisi dans le groupe constitué d'un composé de titane, d'un composé de zirconium et d'un alcoxyde de silicium ; un solvant; et une résine :

$$M(OR^1)_m \qquad (I)$$

dans laquelle, dans la Formule (1), M comprend au moins un élément métallique choisi dans le groupe constitué du Nb, du Ta, du V, de l'Y et de l'Hf, chaque $R^1$ représente indépendamment un groupe alkyle comportant de 1 à 8 atomes de carbone ou un groupe aryle comportant de 6 à 14 atomes de carbone, et m représente un nombre entier de 1 à 5 ; **caractérisée en ce que** la composition comprend en outre un composé représenté par la Formule (II) suivante :

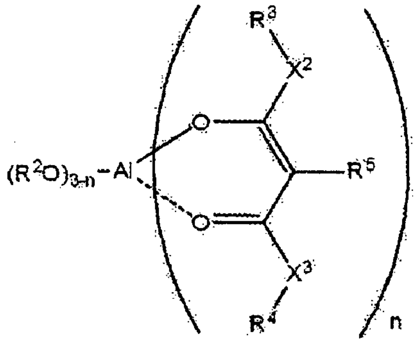

(II)

dans laquelle, dans la Formule (II), chaque $R^2$ représente indépendamment un groupe alkyle comportant de 1 à 8 atomes de carbone, n représente un nombre entier de 0 à 3, chacun parmi $X^2$ et $X^3$ représente indépendamment un atome d'oxygène ou un groupe méthylène, et chacun parmi $R^3$, $R^4$ et $R^5$ représente indépendamment un atome d'hydrogène ou un groupe alkyle comportant de 1 à 8 atomes de carbone.

**2.** Composition permettant de former une couche de passivation selon la revendication 1, dans laquelle au moins l'un des alcoxydes représentés par la Formule (I) est un alcoxyde dans lequel M comprend du Nb.

**3.** Composition permettant de former une couche de passivation selon la revendication 1, dans laquelle au moins l'un des alcoxydes représentés par la Formule (I) est un alcoxyde dans lequel M comprend du Ta, du V, de l'Y ou de l'Hf.

**4.** Composition permettant de former une couche de passivation selon l'une quelconque des revendications 1 à 3, dans laquelle le au moins un composé choisi dans le groupe constitué d'un composé de titane, d'un composé de zirconium et d'un alcoxyde de silicium comprend au moins le composé de titane, et le composé de titane est au moins un choisi dans le groupe constitué du méthoxyde de titane, de l'éthoxyde de titane, de l'isopropoxyde de titane, du n-propoxyde de titane, du n-butoxyde de titane, du t-butoxyde de titane, de l'isobutoxyde de titane, du bis(acétylacétonate) de (diisopropoxyde) de titane et du (tétrakis(2-éthyl-1-hexanolate)) de titane.

**5.** Composition permettant de former une couche de passivation selon l'une quelconque des revendications 1 à 4, dans laquelle le au moins un composé choisi dans le groupe constitué d'un composé de titane, d'un composé de zirconium et d'un alcoxyde de silicium comprend au moins le composé de zirconium, et le composé de zirconium est au moins un composé choisi dans le groupe constitué de l'éthoxyde de zirconium, de l'isopropoxyde de zirconium, du n-propoxyde de zirconium, du n-butoxyde de zirconium, du t-butoxyde de zirconium, de l'acétylacétone de zirconium, du trifluoroacétylacétonate de zirconium et de l'hexafluoroacétylacétonate de zirconium.

**6.** Composition permettant de former une couche de passivation selon l'une quelconque des revendications 1 à 5, dans laquelle le au moins un composé choisi dans le groupe constitué d'un composé de titane, d'un composé de zirconium et d'un alcoxyde de silicium comprend au moins l'alcoxyde de silicium, et l'alcoxyde de silicium est un alcoxyde de silicium représenté par la Formule (III) suivante :

$$(R^6O)_{(4-m)}SiR^7_m \qquad (III)$$

dans laquelle, dans la Formule (III), chacun parmi $R^6$ et $R^7$ représente indépendamment un groupe alkyle comportant de 1 à 8 atomes de carbone, et m représente un nombre entier de 0 à 3.

**7.** Composition permettant de former une couche de passivation selon l'une quelconque des revendications 1 à 6, dans laquelle une teneur du composé représenté par la Formule (I), du au moins un composé choisi dans le groupe constitué d'un composé de titane, d'un composé de zirconium et d'un alcoxyde de silicium et du composé représenté par la Formule (II) est de 0,1% en masse à 80 % en masse d'une masse totale de la composition permettant de former une couche de passivation.

**8.** Composition permettant de former une couche de passivation selon l'une quelconque des revendications 1 à 7, dans laquelle une teneur totale du solvant et de la résine est de 5 % en masse à 98 % en masse d'une masse totale de la composition permettant de former une couche de passivation.

**9.** Utilisation de la composition selon l'une quelconque des revendications 1 à 8 permettant de former une couche de

passivation sur une surface entière ou partielle d'un substrat semi-conducteur.

**10.** Substrat semi-conducteur comportant une couche de passivation, comprenant :

un substrat semi-conducteur (1) ; et
une couche de passivation (6) qui est un produit traité thermiquement de la composition permettant de former une couche de passivation selon l'une quelconque des revendications 1 à 8 et qui est prévue sur une surface entière ou partielle du substrat semi-conducteur.

**11.** Procédé de production d'un substrat semi-conducteur comportant une couche de passivation, le procédé comprenant :

un processus de formation d'une couche de composition par application de la composition permettant de former une couche de passivation selon l'une quelconque des revendications 1 à 8 sur une surface entière ou partielle d'un substrat semi-conducteur; et
un processus de formation d'une couche de passivation par exposition de la couche de composition à un traitement thermique.

**12.** Élément de cellule photovoltaïque, comprenant :

un substrat semi-conducteur (1) comportant une jonction pn d'une couche de type p et d'une couche de type n ;
une couche de passivation (6) qui est un produit traité thermiquement de la composition permettant de former une couche de passivation selon l'une quelconque des revendications 1 à 8 et qui est prévue sur une surface entière ou partielle du substrat semi-conducteur ; et
une électrode (5) prévue au niveau d'au moins une parmi la couche de type p ou la couche de type n.

**13.** Procédé de production d'un élément de cellule photovoltaïque, le procédé comprenant :

un processus de formation d'une couche de composition par application de la composition permettant de former une couche de passivation selon l'une quelconque des revendications 1 à 8 sur une surface entière ou partielle d'un substrat semi-conducteur comportant une jonction pn d'une couche de type p et d'une couche de type n ;
un processus de formation d'une couche de passivation en soumettant la couche de composition à un traitement thermique ; et
un processus de formation d'une électrode au niveau d'au moins une parmi la couche de type p ou la couche de type n.

FIG. 1

(a)

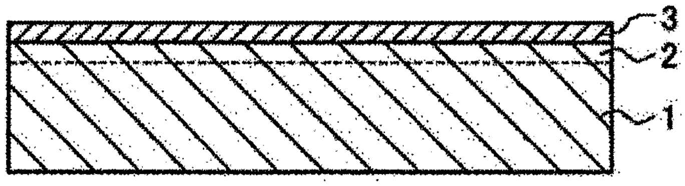


(b)

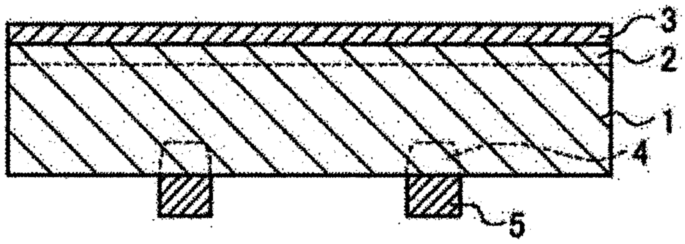


(c)

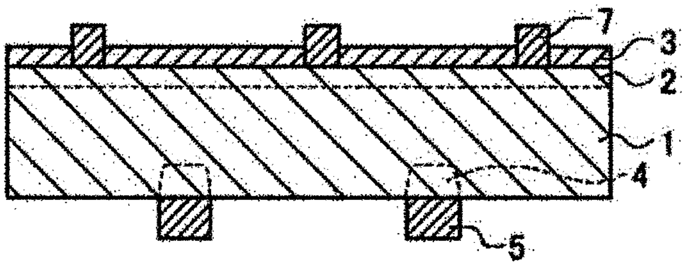


(d)

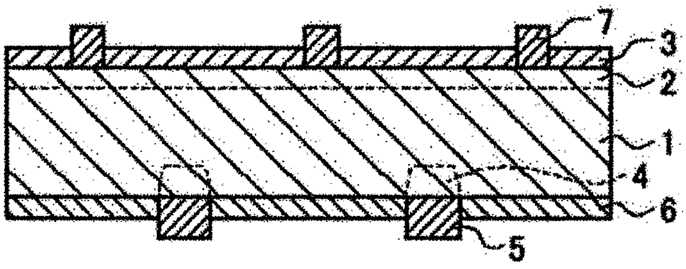

FIG. 2

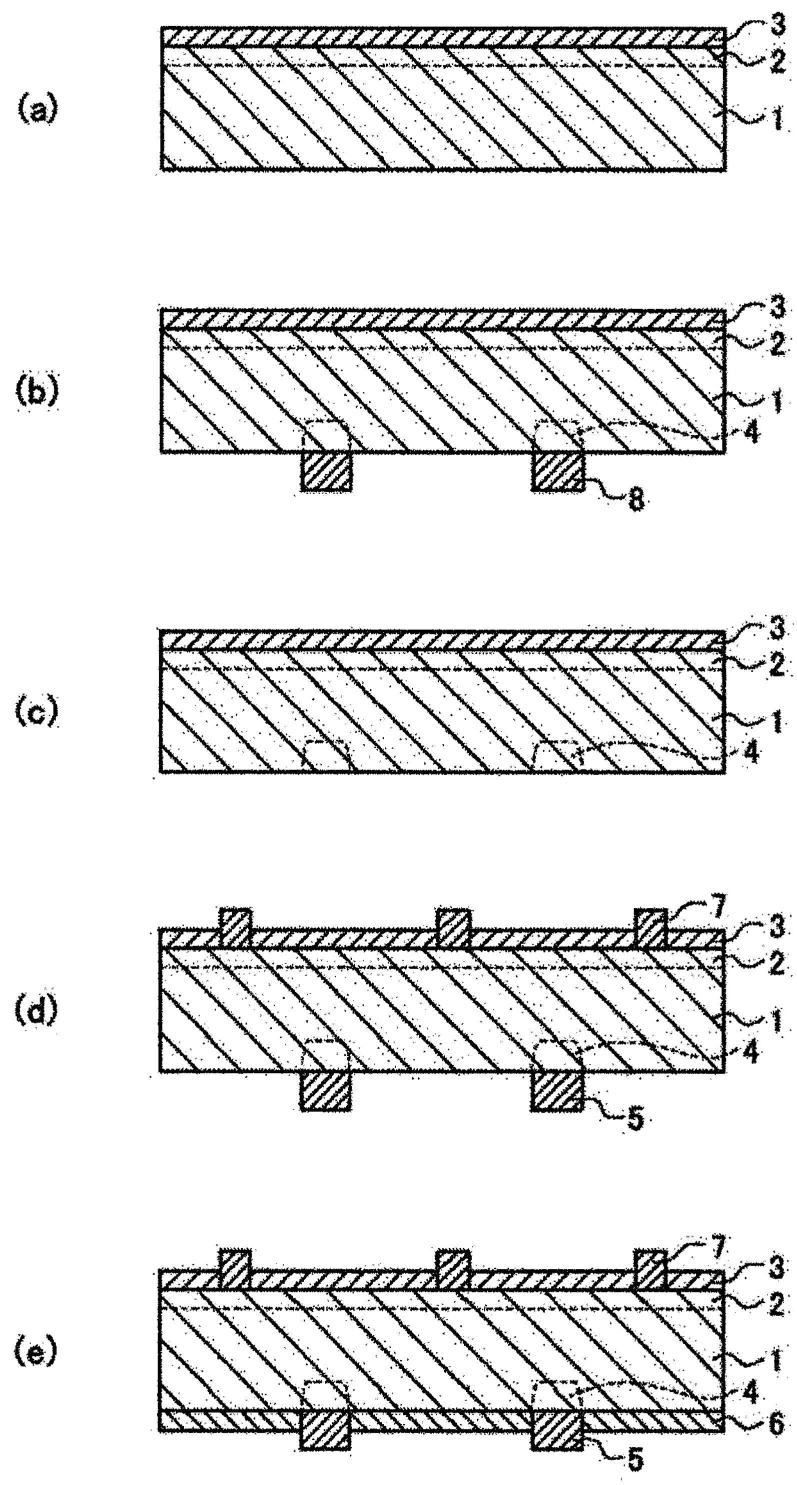

FIG. 3

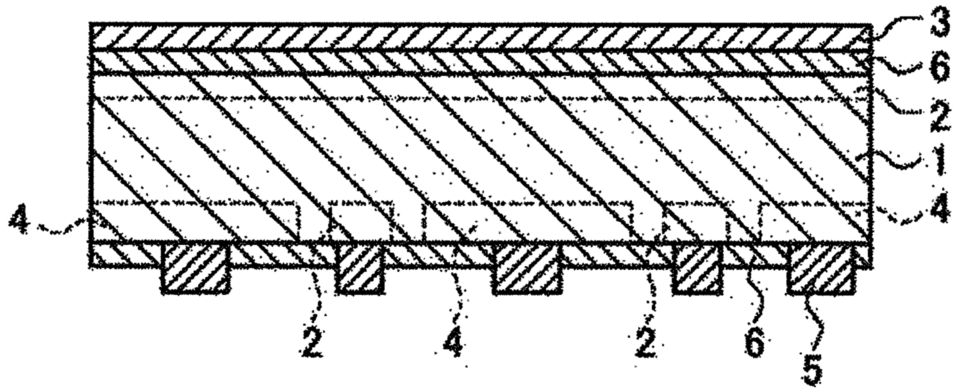


FIG. 4

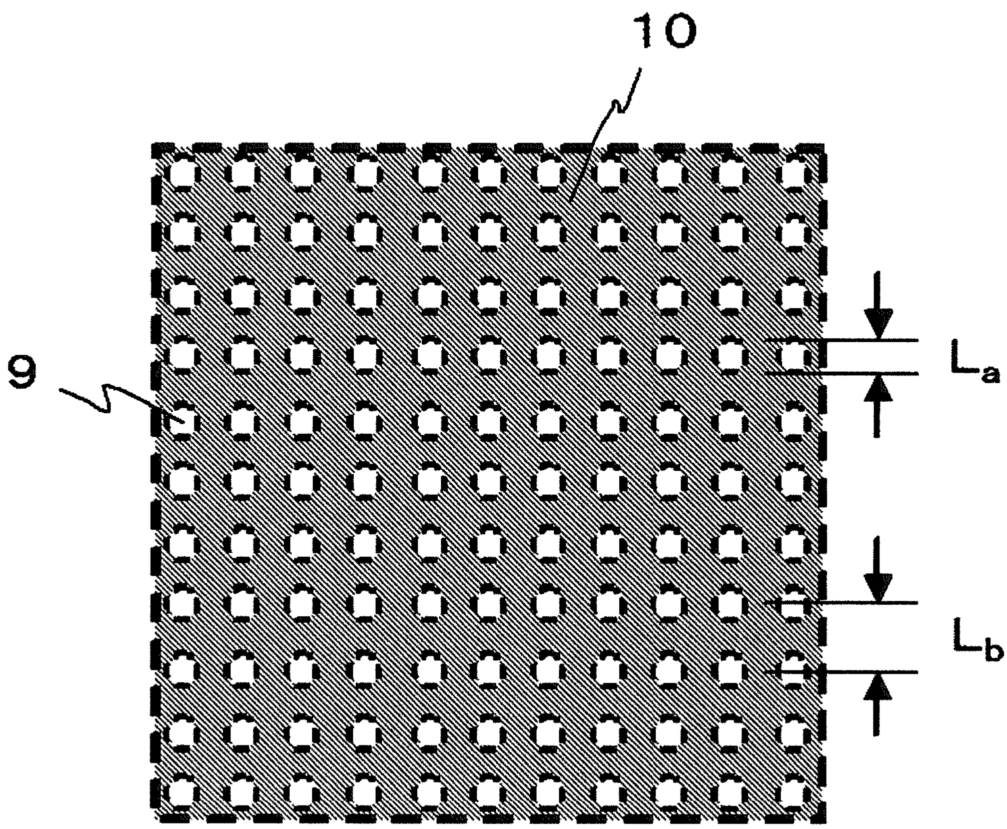

FIG. 5

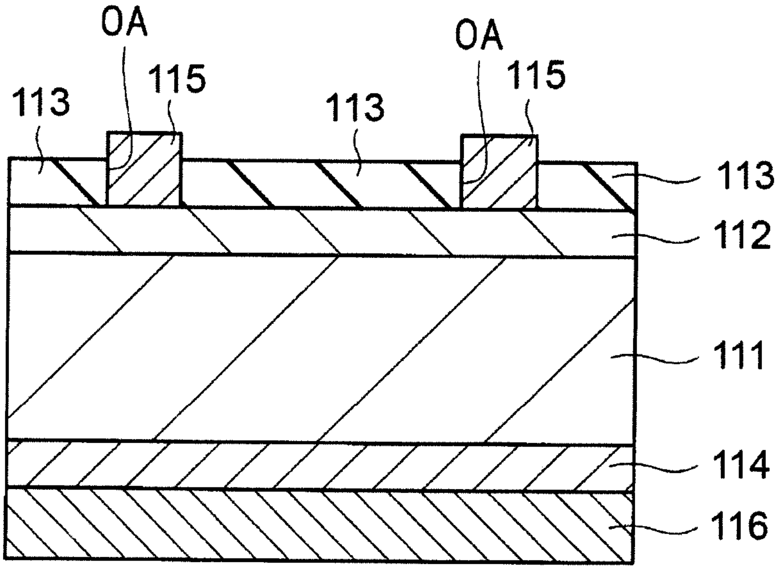
OA
115
113
113
OA
115
113
112
111
114
116

FIG. 6

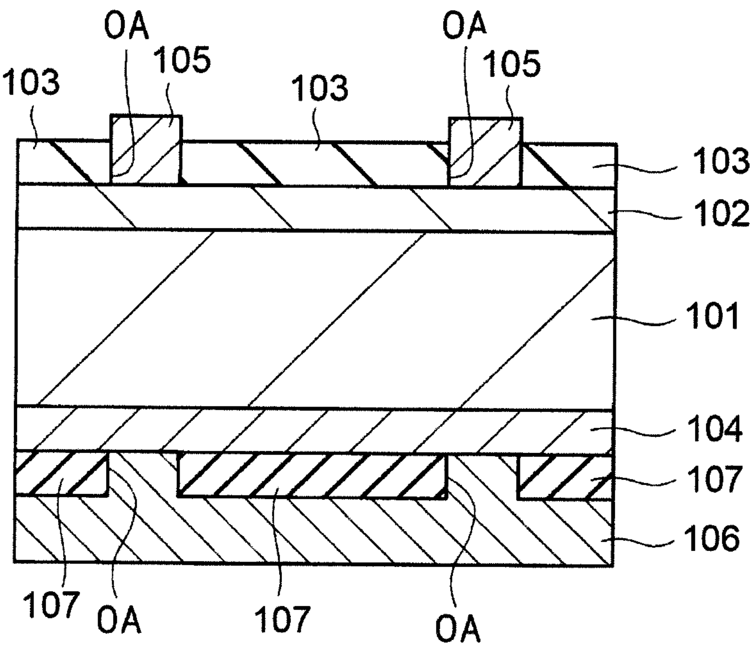
OA
105
103
103
OA
105
103
102
101
104
107
106
107
OA
107
OA

FIG. 7

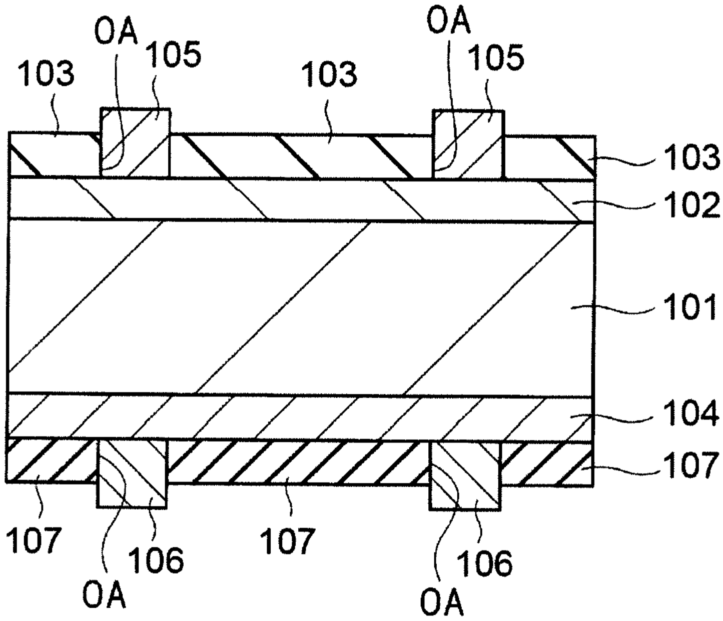
OA
105
103
103
OA
105
103
102
101
104
107
107
106
107
106
OA
OA

FIG. 8

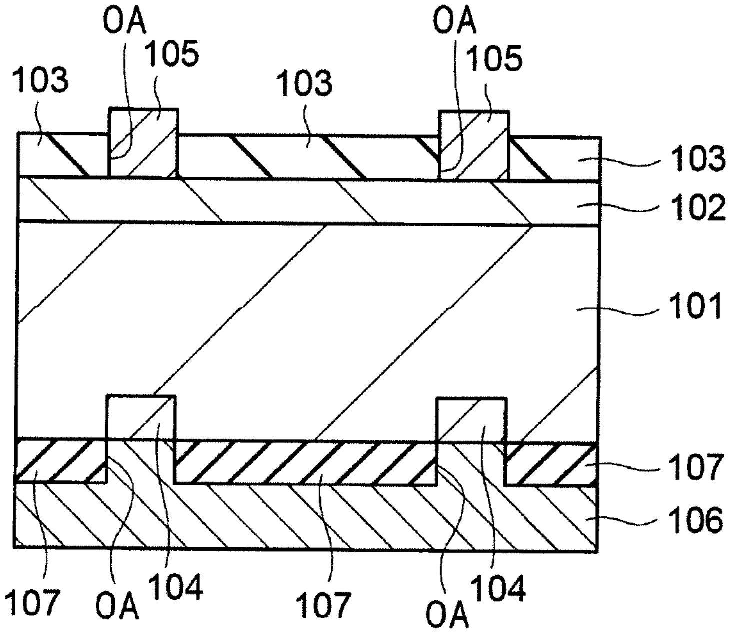
OA
105
103
103
OA
105
103
102
101
107
106
107
OA
104
107
OA
104

FIG. 9

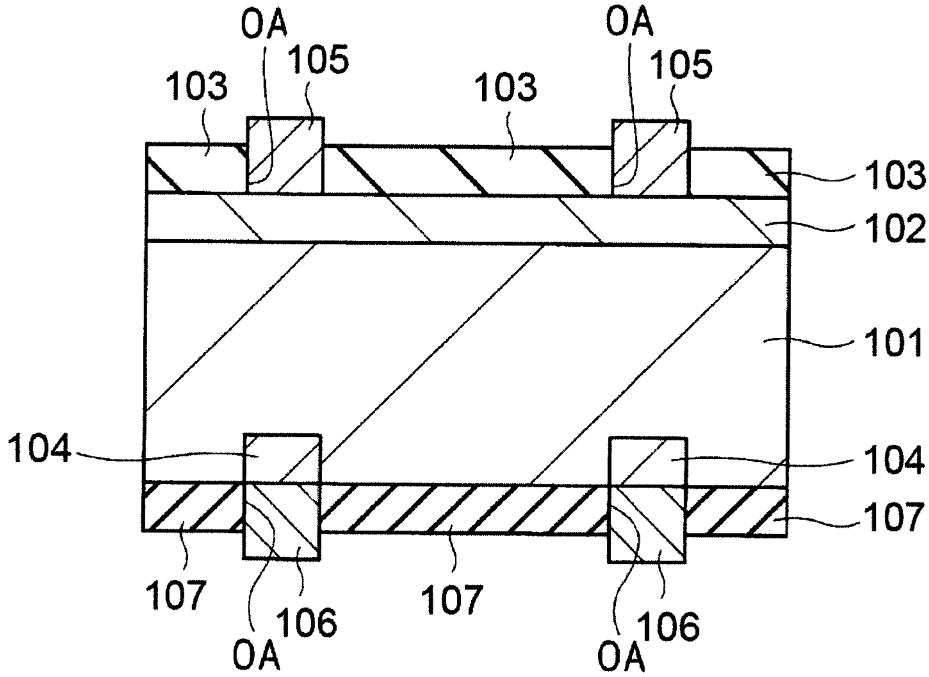
OA
105
103
103
OA
105
103
102
101
104
104
107
107
106
107
OA
106
OA

FIG. 10

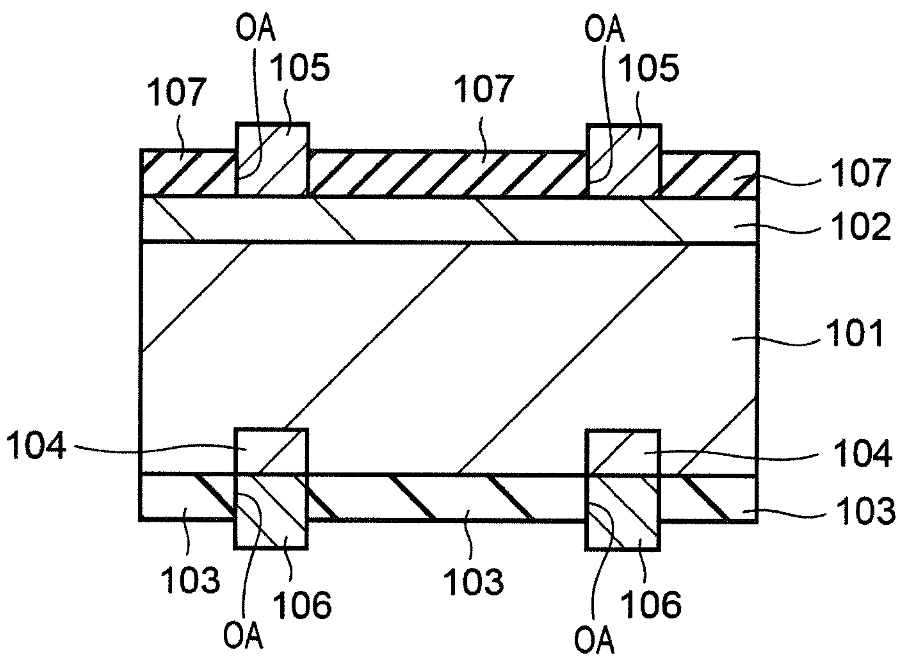
OA
105
107
107
OA
105
107
102
101
104
104
103
103
106
103
OA
106
OA

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3107287 B
- JP 2004006565 A
- JP 4767110 B
- WO 2010111311 A2
- WO 2011155635 A1
- US 2013101867 A1
- US 4496398 A


### Non-patent literature cited in the description


- *Journal of Applied Physics,* 2008, vol. 104, 113703-1-113703-7
- *Thin Solid Films,* 2009, vol. 517, 6327-6330
- *Chinese Physics Letters,* 2009, vol. 26, 088102-1-088102-4
- *Nippon Seramikkusu Kyokai Gakujitsu Ronbunshi,* 1989, vol. 97, 369-399
- *Japanese Journal of Applied Physics,* 2006, vol. 45, 5897-5901
- *Journal of Applied Physics,* 2008, vol. 104, 113703-1, 113703-7
- *Chinese Physics Letters,* 2009, vol. 26, 088102-1, 088102-4
- *Nippon Seramikkusu Kyokai Gakujitsu Ronbunshi,* 1989, vol. 97, 369-399